# EUROPEAN PATENT SPECIFICATION

(11) **EP 2 039 737 B1**
(45) Date of publication and mention of the grant of the patent: **24.11.2010**
(21) Application number: 08016372.8
(22) Date of filing: 17.09.2008
(51) Int. Cl.: H05B 33/14, H05B 33/20, H05B 33/18, H05B 33/22, C09K 11/06

(54) **Organic electroluminescence device**
Organische Elektrolumineszenzvorrichtung
Dispositif électroluminescent organique

(30) Priority: 18.09.2007 JP 2007240896
(43) Date of publication of application: 25.03.2009
(73) Proprietor: FUJIFILM Corporation, Minato-ku Tokyo (JP)
(72) Inventor: Takeda, Akira c/o Fujifilm Corporation,, Ashigarakami-gun, Kanagawa (JP)
(74) Representative: HOFFMANN EITLE

(56) References cited:
- WO-A-2006/033440
- A. SAMANTA, S. SAHA, R.W. FESSENDEN: "Nature of the Fluorescent State of N-Arylcarbazole Derivatives as Derived from Directly Measured Values of the Excited State Dipole Moment" J. PHYS. CHEM., vol. 105, 12 May 2001 (2001-05-12), pages 5438-5441, XP002524428
- YANG L ET AL: "Synthesis, characterization, photophysics and electroluminescence based on a series of pyran-containing emitters" THIN SOLID FILMS, ELSEVIER-SEQUOIA S.A. LAUSANNE, CH, vol. 500, no. 1-2, 3 April 2006 (2006-04-03), pages 224-230, XP025006394 ISSN: 0040-6090 [retrieved on 2006-04-03]
- ROBERT F. BRIDGER, DEREK A. LAW, DVID F. BOWMAN, B.S. MIDDLETON, KEITH U. INGOLD: "Permanganate oxidation of N-aryl-2-naphtylamines" J. ORG. CHEM., vol. 33, 1968, pages 4329-4332, XP002524429

## Description

### Background of the Invention

### 1. Field of the Invention

The present invention relates to an organic electroluminescence device (which may hereinafter be called "organic EL device", "luminescence device", or "device") capable of emitting light by converting electric energy to light, in particular, to an organic electroluminescence device excellent in driving voltage and EL external luminous efficiency.

### 2. Description of the Related Art

Today, research and development on various display devices (organic luminescence devices) using organic light-emitting materials are actively performed. Of these devices, organic EL devices can realize luminescence with high luminance at low voltage and therefore are drawing attention as promising display devices (Applied Physics Letters, volume 51, page 913 (1987)).

In recent years, devices have improved efficiency by using a phosphorescent material therefor. As the phosphorescent material, an iridium complex and a platinum complex are known (refer to, for example, US Patent No. 6303238, and International Patent Publication Nos. 00/57676 and 00/70655). Satisfactory durability cannot however be attained even by the technologies disclosed therein.

According to International Patent Publication No. 00/70655, the light emitting layer uses, in combination, Ir(ppy) (iridium tris(phenylpyridine)) as a dopant and CBP (4,4'-dicarbazolebiphenyl) as a host material.

According to International Patent Publication Nos. 04/016711 and 03/059015, and USSN 03/0175553, MCP (meta-discarbazo-q-ylbenzene) is used as a host material of the light emitting layer. There is however a demand for improvement of the host material from the viewpoint of driving voltage and external quantum efficiency.

A. Samanta, S. Saha, R.W. Fessenden: "Nature of the Fluorescent State of N-Arylcarboazole Derivatives as Derived from Directly Measured Values of the Excited State Dipole Moment" J. Phys. Chem A, vol. 105, 12 May 2001 (2001-05-12), pages 5438-5441 discloses the quantitative measurement of laser-induced changes in microwave dielectric loss of benzene solutions of two electron donor-acceptor system, N-(4-cyanophenyl)carbazole and N-(1-naphthyl)carbazole.

Yang L et al: "Synthesis, characterization, photophysics and electro luminescence based on a series of pyran-containing emitters" Thin Solid Films, Elsevier-Sequoia S.A. Lausanne, Ch, vol. 500, No. 1-2, 3 April 2006 (2006-04-03), pages 224-230 discloses N-(4-cyanophenyl)carbazole as an intermediate product for production of a dopant.

### Summary of the Invention

An object of the invention is to provide a luminescence device featuring low voltage operation and excellent EL external quantum efficiency.

When an organic compound is used as a charge (electron or hole) transportable material, it is generally said that its properties are dependent on the ionization potential (Ip), electron affinity (Ea), charge mobility and so on that the organic compound has. In an organic electroluminescence device in particular, it is desirable for injection of electrons from the interface on the cathode side that the electron affinity (Ea) of the organic compound is a relatively large value close to the work function of a cathode metal. Examples of a method for satisfying this physical property in organic compounds include (1) a method of using a metal ion-coordinated organometallic complex, (2) a method of using a material having an extended π electron-conjugated system, (3) a method of introducing an electron-withdrawing group in the position where the lowest unoccupied molecular orbital (LUMO) is present, and so on.

In the case of adopting the method (1), though an aluminum complex containing 8-hydroxyquinoline as its ligand is given as an example of the complex used therein, complexes stable under driving conditions of organic electroluminescence devices are generally limited in kind. In the case of adopting the method (2), an energy gap between HOMO (the highest occupied molecular orbital) and LUMO becomes small to result in lowering of the energy level in an excited state. With this being the situation, when an extended π electron-conjugated material is used expressly as a host material in combination with a light emitting material, it becomes impossible to ignore the deactivation process of excitation energy via the host material, and the material used can become a factor responsible for drop in luminous efficiency. In the case of adopting the method (3), it is important to select not only the introduction site of an electron-withdrawing group but also the kind of the electron-withdrawing group introduced.

According to the present invention, there is provided an organic electroluminescent device comprising: a pair of electrodes; and an organic layer between the pair of electrodes, which comprises a light-emitting layer and contains a compound represented by the following formula (1): 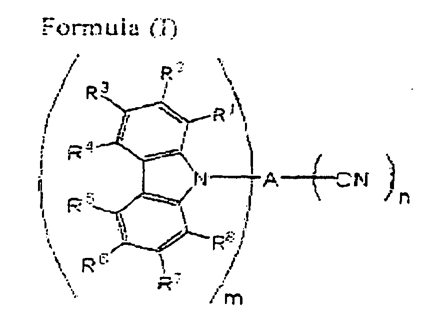 wherein each of R¹ to R⁸ independently represents a hydrogen atom or a substituent, A represents an aromatic ring which may have a substituent, m represents an integer of 2 or greater, and n represents an integer of 1 or greater.

Preferably each of R¹ to R⁸ independently represents a hydrogen atom, an alkyl group, an aryl group, a heteroaryl group, a silyl group, or a halogen atom.

Preferably A represents an aromatic ring, m represents an integer of 2 to 5, n represents an integer of 1 to 4, and each of R¹ to R⁸ independently represents a hydrogen atom, an alkyl group, an aryl group, a heteroaryl group, a silyl group, or a halogen atom.

Preferably, the compound of Formula (I) is represented by the following formula (Ia) 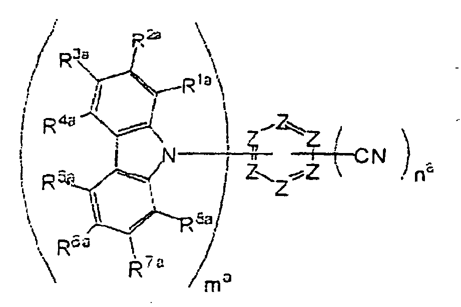 wherein each of R^{1a} to R^{8a} independently represents a hydrogen atom, an alkyl group, an aryl group, a heteroaryl group, a silyl group, or a halogen atom, m^{a} represents an integer of 2 to 5, n^{a} represents an integer of 1 to 4, and Z represents a carbon atom or a nitrogen atom, provided that when Z is unsubstituted, Z represents C-H or N.

Preferably A in Formula (I) represents a benzene ring, m represents an integer of 2 to 5, n represents an integer of 1 to 4, and m+n represents an integer of 3 to 6.

Preferably the compound represented by the Formula (I) is contained in the light emitting layer.

Alternatively, the compound represented by the formula (I) may be contained in a layer adjacent to the light emitting layer.

Preferably, the light emitting layer contains at least one of a platinum complex phosphorescent material and an iridium complex phosphorescent material.

Preferably, the light emitting layer contains a platinum complex phosphorescent material having a tetradentate ligand.

### Detailed Description of the Invention

The organic electroluminescence device of the invention (which may hereinafter be called "the device of the invention") has a pair of electrodes and, between these electrodes, one or more organic layers (which may be layers composed only of an organic compound or layers containing both an organic compound and an inorganic compound) including a light emitting layer and any of the one or more organic layers contain at least one of compounds represented by the formula (I).

The compounds of the invention represented by the formula (I) are excellent in chemical stability and cause less deterioration, such as decomposition, of materials during operation of the device so that decrease in efficiency or reduction in life of the organic electroluminescence device which will otherwise occur by the resulting decomposition product can be prevented.

The compounds represented by the formula (I) will next be described.

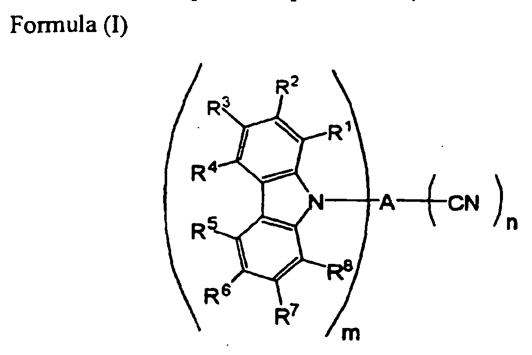

In the formula (I), each of R¹ to R⁸ represents a hydrogen atom or a substituent, A represents an aromatic ring which may have a substituent, m represents an integer of 2 or greater, and n represents an integer of 1 or greater.

Although the substituent represented by each of R¹ to R⁸ is not particularly limited, examples include alkyl groups, alkenyl groups, alkynyl groups, aryl groups, heteroaryl groups, amino groups, alkoxy groups, aryloxy groups, heterocyclic oxy groups, acyl groups, alkoxycarbonyl groups, aryloxycarbonyl groups, acyloxy groups, acylamino groups, alkoxycarbonylamino groups, aryloxycarbonylamino groups, sulfonylamino groups, sulfamoyl groups, carbamoyl groups, alkylthio groups, arylthio groups, heterocyclic thio groups, sulfonyl groups, sulfinyl groups, ureido groups, phosphoric acid amide groups, a hydroxy group, a mercapto group, halogen atoms, a cyano group, a sulfo group, a carboxyl group, a nitro group, a hydroxamic acid group, a sulfino group, a hydrazino group, an imino group, heterocyclic groups other than heteroaryl groups, silyl groups, silyloxy groups, and a deuterium atom. These substituents may be substituent further with another substituent, or may be coupled together to form a ring, or an oligomer compound or a polymer compound which will be described later.

The alkyl groups are preferably C₁₋₃₀, more preferably C₁₋₂₀, especially preferably C₁₋₁₀ alkyl groups such as methyl, ethyl, n-propyl, isopropyl, n-butyl, tert-butyl, n-octyl, n-nonyl, n-decyl, n-dodecyl, n-octadecyl, n-hexadecyl, cyclopropyl, cyclobutyl, cyclopentyl, cyclohexyl, cyclooctyl, 1-adamantyl, and trifluoromethyl. In the invention, the number of carbon atoms of the substituent such as alkyl group may include the number of carbon atoms of another substituent, if any, for the alkyl group or the like substituent.

The alkenyl groups are preferably C₂₋₃₀, more preferably C₂₋₂₀, especially preferably C₂₋₁₀ alkenyl groups and examples include vinyl, allyl, 1-propenyl, 1-isopropenyl, 1-butenyl, 2-butenyl, and 3-pentenyl.

The alkynyl groups are preferably C₂₋₃₀, more preferably C₂₋₂₀, especially preferably C₂₋₁₀ alkynyl groups and examples include ethynyl, propargyl, 1-propinyl, and 3-pentynyl.

The aryl groups are preferably C₆₋₃₀, more preferably C₆₋₂₀, especially preferably C₆₋₁₂ aryl groups and examples include phenyl, o-methylphenyl, m-methylphenyl, p-methylphenyl, 2,6-xylyl, p-cumenyl, mesityl, naphthyl, and anthranyl.

The heteroaryl groups are preferably C₁₋₃₀, more preferably C₁₋₁₂, heteroaryl groups and heteroatoms are, for example, nitrogen, oxygen and sulfur atoms. Specific examples include imidazolyl, pyrazolyl, pyridyl, pyrazyl, pyrimidyl, triazinyl, quinolyl, isoquinolinyl, pyrrolyl, indolyl, furyl, thienyl, benzoxazolyl, benzimidazolyl, benzothiazolyl, carbazolyl, and azepinyl.

The amino groups are preferably C₀₋₃₀, more preferably C₀₋₂₀, especially preferably C₀₋₁₀ amino groups and examples include amino, methylamino, dimethylamino, diethylamino, dibenzylamino, diphenylamino, and ditolylamino.

The alkoxy groups are preferably C₁₋₃₀, more preferably C₁₋₂₀, especially preferably C₁₋₁₀ alkoxy groups and examples include methoxy, ethoxy, butoxy, and 2-ethylhexyloxy.

The aryloxy groups are preferably C₆₋₃₀, more preferably C₆₋₂₀, especially preferably C₆₋₁₂ aryloxy groups and examples include phenyloxy, 1-naphthyloxy, and 2-naphthyloxy.

The heterocyclic oxy groups are preferably C₁₋₃₀, more preferably C₁₋₂₀, especially preferably C₁₋₁₂ heterocyclic oxy groups and examples include pyridyloxy, pyrazyloxy, pyrimidyloxy, and quinolyloxy.

The acyl groups are preferably C₂₋₃₀, more preferably C₂₋₂₀, especially preferably C₂₋₁₂ acyl groups and examples include acetyl, benzoyl, formyl, and pivaloyl.

The alkoxycarbonyl groups are preferably C₂₋₃₀, more preferably C₂₋₂₀, especially preferably C₂₋₁₂ alkoxycarbonyl groups and examples include methoxycarbonyl and ethoxycarbonyl.

The aryloxycarbonyl groups are preferably C₇₋₃₀, more preferably C₇₋₂₀, especially preferably C₇₋₁₂ aryloxycarbonyl groups and examples include phenyloxycarbonyl.

The acyloxy groups are preferably C₂₋₃₀, more preferably C₂₋₂₀, especially preferably C₂₋₁₀ acyloxy groups and examples include acetoxy and benzoyloxy.

The acylamino groups are preferably C₂₋₃₀, more preferably C₂₋₂₀, especially preferably C₂₋₁₀ acylamino groups and examples include acetylamino and benzoylamino.

The alkoxycarbonylamino groups are preferably C₂₋₃₀, more preferably C₂₋₂₀, especially preferably C₂₋₁₂ alkoxycarbonylamino groups and examples include methoxycarbonylamino.

The aryloxycarbonylamino groups are preferably C₇₋₃₀, more preferably C₇₋₂₀, especially preferably C₇₋₁₂ aryloxycarbonylamino groups and examples include phenyloxycarbonylamino.

The sulfonylamino groups are preferably C₁₋₃₀, more preferably C₁₋₂₀, especially preferably C₁₋₁₂ sulfonylamino groups and examples include methanesulfonylamino and benzenesulfonylamino.

The sulfamoyl groups are preferably C₀₋₃₀, more preferably C₀₋₂₀, especially preferably C₀₋₁₂ sulfamoyl groups and examples include sulfamoyl, methylsulfamoyl, dimethylsulfamoyl, and phenylsulfamoyl.

The carbamoyl groups are preferably C₁₋₃₀, more preferably C₁₋₂₀, especially preferably C₁₋₁₂ carbamoyl groups and examples include carbamoyl, methylcarbamoyl, diethylcarbamoyl, and phenylcarbamoyl.

The alkylthio groups are preferably C₁₋₃₀, more preferably C₁₋₂₀, especially preferably C₁₋₁₂ alkylthio groups and examples include methylthio and ethylthio.

The arylthio groups are preferably C₆₋₃₀, more preferably C₆₋₂₀, especially preferably C₆₋₁₂ arylthio groups and examples include phenylthio.

The heterocyclic thio groups are preferably C₁₋₃₀, more preferably C₁₋₂₀, especially preferably C₁₋₁₂ heterocyclic thio groups and examples include pyridylthio, 2-benzimidazolylthio, 2-benzoxazolylthio, and 2-benzthiazolylthio.

The sulfonyl groups are preferably C₁₋₃₀, more preferably C₁₋₂₀, especially preferably C₁₋₁₂ sulfonyl groups and examples include mesyl, tosyl, and trifluoromethanesulfonyl.

The sulfinyl groups are preferably C₁₋₃₀, more preferably C₁₋₂₀, especially preferably C₁₋₁₂ sulfinyl groups and examples include methanesulfinyl and benzenesulfinyl.

The ureido groups are preferably C₁₋₃₀, more preferably C₁₋₂₀, especially preferably C₁₋₁₂ ureido groups and examples include ureido, methylureido, and phenylureido.

The phosphoric acid amide groups are preferably C₁₋₃₀, more preferably C₁₋₂₀, especially preferably C₁₋₁₂ phosphoric acid amide groups and examples include diethylphosphoric acid amide and phenylphosphoric acid amide.

Examples of the halogen atoms include fluorine, chlorine, bromine, and iodine.

The heterocyclic groups other than heteroaryl groups are preferably C₁₋₃₀, more preferably C₁₋₁₂ heterocyclic groups and heteroatoms are, for example, nitrogen, oxygen, and sulfur atoms. Specific examples include piperidyl, morpholino, and pyrrolidyl.

The silyl groups are preferably C₃₋₄₀, more preferably C₃₋₃₀, especially preferably C₃₋₂₄ silyl groups and examples include trimethylsilyl, triethylsilyl, triisopropylsilyl, dimethyl-tert-butylsilyl, dimethylphenylsilyl, diphenyl-tert-butylsilyl, triphenylsilyl, tri-1-naphthylsilyl, and tri-2-naphthylsilyl.

The silyloxy groups are preferably C₃₋₄₀, more preferably C₃₋₃₀, especially preferably C₃₋₂₄ silyloxy groups and examples include trimethylsilyloxy and triphenylsilyloxy.

It is preferable that each of R¹ to R⁸ independently represents a hydrogen atom, an alkyl group, an aryl group, a heteroaryl group, a silyl group, or a halogen atom.

When each of R¹ to R⁸ represents the alkyl group, it can be bonded to a carbazole ring via the primary to quaternary carbon atom thereof, preferably the secondary to quaternary carbon atom, more preferably the tertiary or quaternary carbon atom, especially preferably the quaternary carbon atom. The substituent bonded to the ring via the primary carbon atom is, for example, a methyl group; the substituent bonded to the ring via the secondary carbon atom is, for example, an ethyl group or a benzyl group, the substituent bonded to the ring via the tertiary carbon atom is, for example, an isopropyl group or a diphenylmethyl group; and the substituent bonded to the ring via the quaternary carbon atom is, for example, a tert-butyl group, a 1-adamantyl group, or a trityl group.

Each of R¹, R², R⁴, R⁵, R⁷, and R⁸ represents preferably an alkyl group, an aryl group, or a hydrogen atom, more preferably an alkyl group or a hydrogen atom, especially preferably a hydrogen atom.

Each of R³ and R⁶ represents preferably an alkyl group, an aryl group, a silyl group, a cyano group, or a hydrogen atom, more preferably an alkyl group, a silyl group, or a hydrogen atom, especially preferably a hydrogen atom.

The aromatic ring A represents a hydrocarbon aromatic ring composed of carbon atoms and hydrogen atoms or a heteroaromatic ring containing, in addition to carbon atoms and hydrogen atoms, heteroatoms. The ring may have a substituent or fused with a plurality of aromatic rings. A preferably represents an aromatic ring.

The hydrocarbon aromatic ring has preferably from 6 to 30 carbon atoms, more preferably from 6 to 14 carbon atoms, especially preferably 6 carbon atoms. Examples of the hydrocarbon aromatic ring include benzene, naphthalene, anthracene, phenanthrene, tetracene (naphthacene), pentacene, pyrene, and coronene.

The heteroaromatic ring has preferably from 3 to 30 carbon atoms, more preferably from 4 to 16 carbon atoms, especially preferably from 5 to 12 carbon atoms. Examples of the heteroaromatic ring containing only a nitrogen atom as the heteroatom include pyridine, pyrazine, pyrimidine, pyrrole, pyrazole, and imidazole and examples of fused heteroaromatic rings containing only a nitrogen atom include benzimidazole, indole, and carbazole. Examples of the heteroaromatic ring containing an oxygen atom as the heteroatom include furan, oxazole, and isoxazole. Examples of the heteroaromatic ring containing a sulfur atom as the hetero atom include thiophene, thiazole, and isothiazole and examples of fused heteroaromatic rings containing a sulfur atom include benzofuran, dibenzofuran, benzothiophene, and dibenzothiophene.

The aromatic ring A contains preferably benzene, azines, pyrrole, furan, or thiophene, more preferably benzene, pyridine, pyrazine, naphthalene, anthracene, indole, carbazole, dibenzofuran, or dibenzothiophene, still more preferably benzene or pyridine, especially preferably benzene.

In the formula (I), m represents an integer of 2 or greater, preferably from 2 to 10, more preferably from 2 to 6, still more preferably from 2 to 5, especially preferably 2 or 3.

In the formula (I), n represents an integer of 1 or greater, preferably from 1 to 10, more preferably from 1 to 4, still more preferably from 1 to 3, especially preferably 1.

Further, in the formula (I) representing the compound contained in the organic layer, it is preferable that A represents an aromatic ring, m represents an integer of 2 to 5, n represents an integer of 1 to 4, and each of R¹ to R⁸ independently represents a hydrogen atom, an alkyl group, an aryl group, a heteroaryl group, a silyl group, or a halogen atom.

Alternatively, it is preferable that, in the formula (I) representing the compound contained in the organic layer, A represents a benzene ring, m represents an integer of 2 to 5, n represents an integer of 1 to 4, and m+n represents an integer of 3 to 6.

The compound of the invention represented by the formula (I) may be a low molecular compound, an oligomer compound, or a polymer compound (having a mass average molecular weight (in terms of polystyrene) of preferably from 1000 to 5000000, more preferably from 2000 to 1000000, still more preferably from 3000 to 100000) having, in the main chain or a side chain thereof, the structure represented by the formula (I). The compound of the invention represented by the formula (I) is preferably a low molecular compound.

When the compound of the invention represented by the formula (I) is an oligomer compound or a polymer compound having, in the main chain or side chain thereof, the structure represented by the formula (I), the structure contained in the main chain has two or more of R¹ to R⁸ or a group substituted for the aromatic ring A, more preferably two or more of R¹ to R⁸ and containing either one of R³ or R⁵ or a group substituted for the aromatic ring A, especially preferably R⁵ or a group substituted for the aromatic ring A. When the structure is contained in the side chain, the side chain has any of R¹ to R⁸ or a group substituted for the aromatic ring A, more preferably either one of R³ or R⁵ or a group substituted for the aromatic ring A, especially preferably a group substituted for the aromatic ring A.

In the invention, using purpose of the compound of the invention represented by the formula (I) is not limited and it may be contained in any of the organic layers. The compound of the invention represented by the formula (I) is introduced preferably in any one or more of a light emitting layer, a hole injection layer, a hole transport layer, an electron transport layer, an electron injection layer, an exciton blocking layer and a charge blocking layer.

In the invention, the compound represented by the formula (I) is preferably contained in any one of the light emitting layer or layers adjacent to the light emitting layer. The compound represented by the formula (I) may be contained in each of the light emitting layer and the layers adjacent thereto.

The light emitting layer contains the compound of the invention represented by the formula (I) in an amount of from 1 to 99.9 mass%, more preferably from 50 to 99.9 mass%, still more preferably from 80 to 99.9 mass%.

When the compound of the invention represented by the formula (I) is contained in a layer other than the light emitting layer, it is contained preferably in an amount of from 1 to 100 mass%, more preferably from 50 to 100 mass%, still more preferably from 80 to 100 mass%.

The compound represented by the formula (I) can be synthesized, for example, from an aromatic halide having a cyano group. When a chloride, a bromide, or an iodide is used, the compound of the formula (I) can be synthesized by a coupling reaction with carbazole or a substituted carbazole in the presence of a catalyst containing a palladium compound or a copper compound. When a fluoride is used, on the other hand, the compound can be synthesized by a substitution reaction with carbazole or an alkali metal salt of a substituted carbazole.

The compound represented by the formula (Ia) is exemplified as one of the preferable embodiments of the compound represented by the formula (I). The compound represented by the formula (I) will next be described.

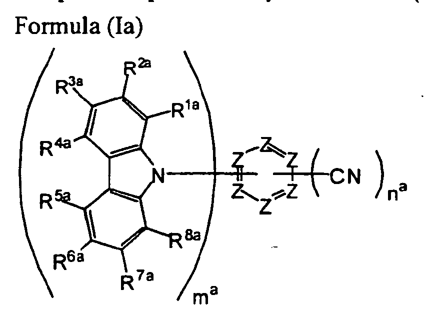

In the formula (Ia), each of R^{1a} to R^{8a} independently represents a hydrogen atom, an alkyl group, an aryl group, a heteroaryl group, a silyl group, or a halogen atom. m^{a} represents an integer of 2 to 5, n^{a} represents an integer of 1 to 4, and Z represents a carbon atom or a nitrogen atom, provided that when Z is unsubstituted, Z represents C-H or N.

Preferred ranges of R^{1a} to R^{8a} are same as those of R¹ to R⁸ of the compound represented by the formula (I), respectively.

Z represents a carbon atom or a nitrogen atom, provided that when Z is unsubstituted, Z represents C-H or N. The number of Zs representing a nitrogen out of six Zs is preferably form 0 to 3, more preferably 0 to 2, still more preferably 0 to 1, especially preferably 0.

m^{a} represents an integer of 2 to 5, n^{a} represents an integer of 1 to 4, and m^{a}+n^{a} represents an integer of 3 to 6. m^{a} is preferably from 2 to 4, more preferably 2 to 3, especially preferably 2. n^{a} is preferably from 1 to 3, more preferably 1 to 2, especially preferably 1.

m in the formula (I) and m^{a} in the formula (Ia) represent the number of carbazole skeletons which bear a main part of charge transporting property of the compound of the invention, and they are selected in consideration of the productive adequacy of organic thin film by vacuum deposition, the stability in solid state to heating and the charge transporting property of the compound as a whole. For example, it is considered that if the molecular weight is too small, it is difficult to prepare a organic film having a suitable thickness by vacuum deposition, whereas, if the molecular weight is too large, excessive heating is required at the vacuum deposition, resulting in deterioration of the materials.

The following are specific examples of the compound represented by the formula (I), but the present invention is not limited to or by these compounds. In the following specific examples, Cz represents an N-carbazolyl group.

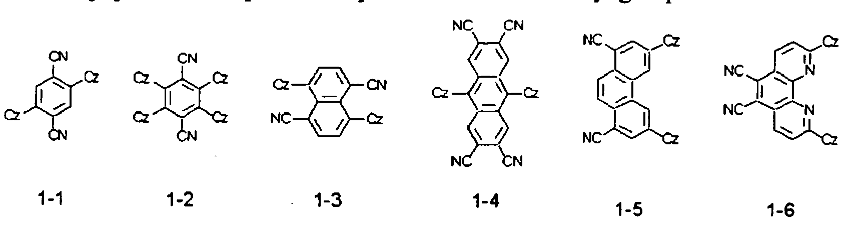

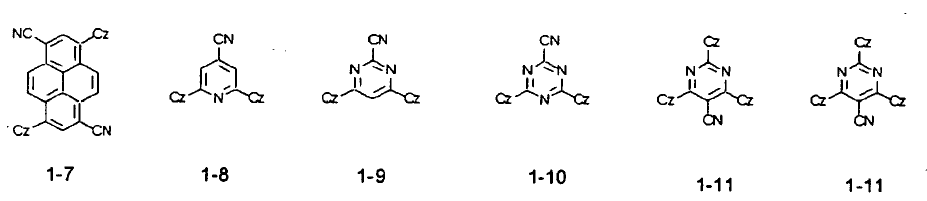

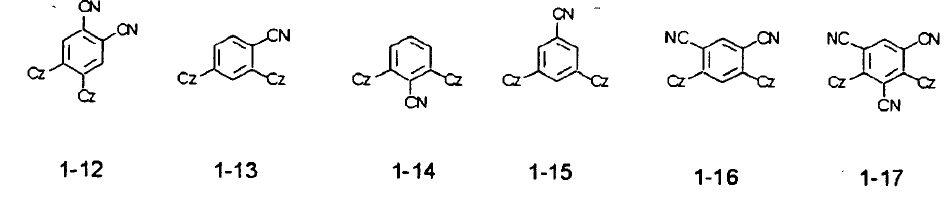

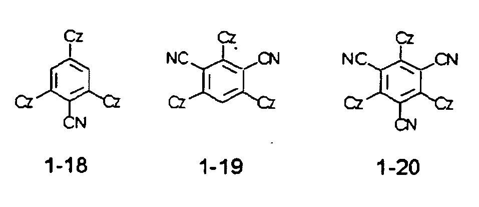

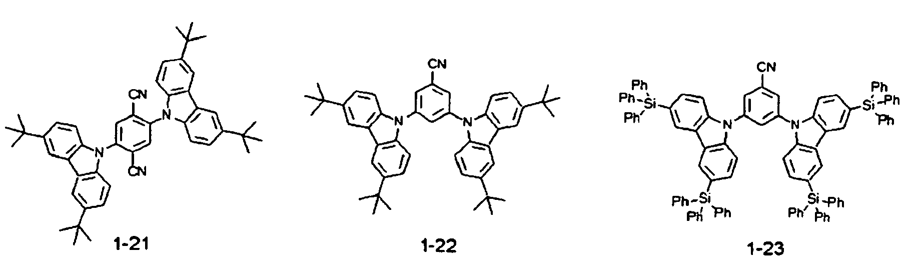

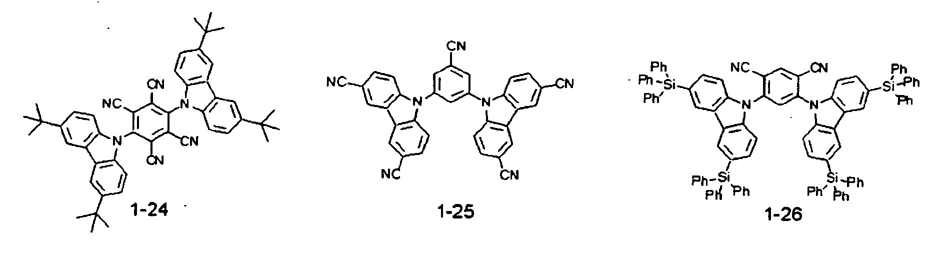

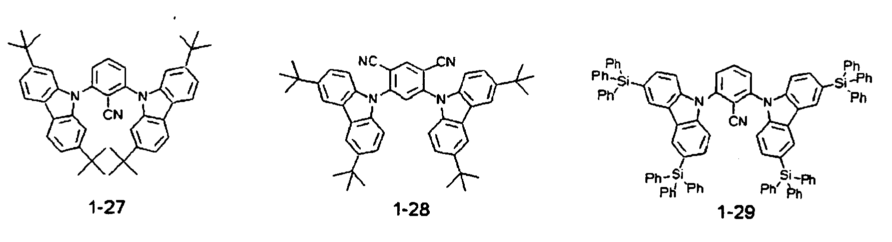

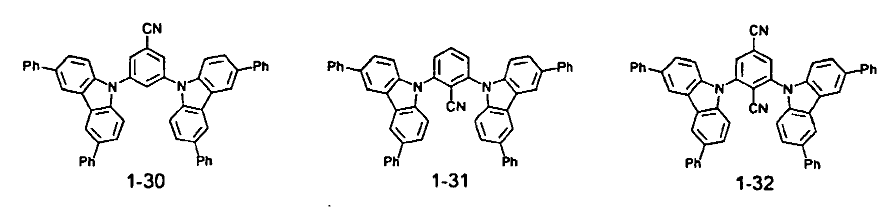

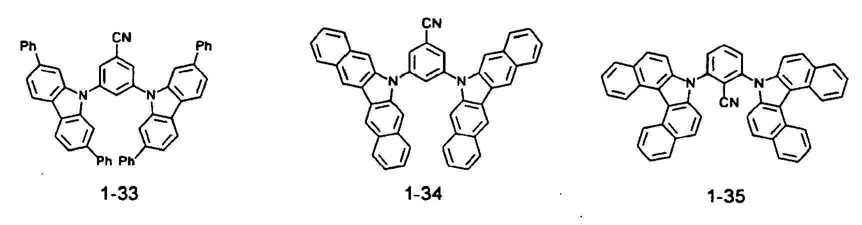

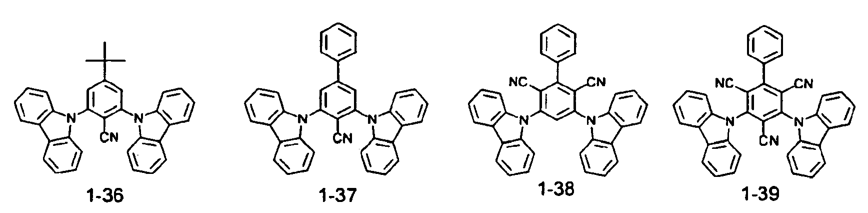

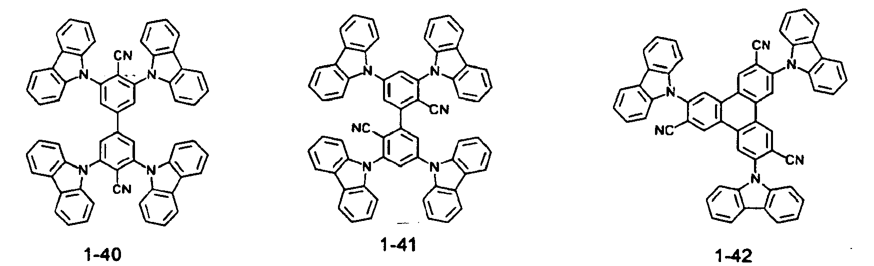

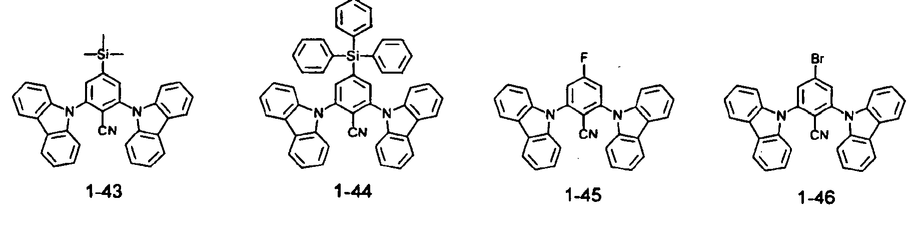

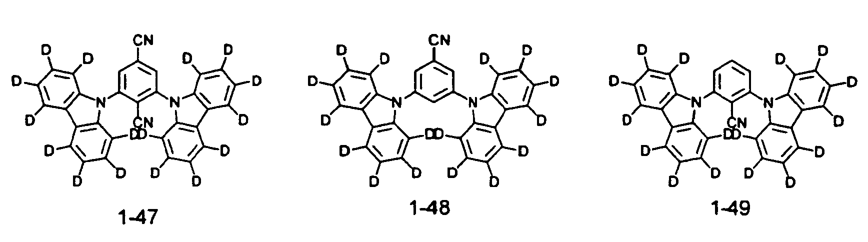

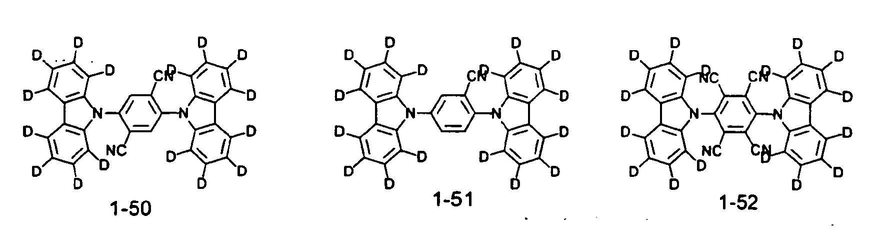

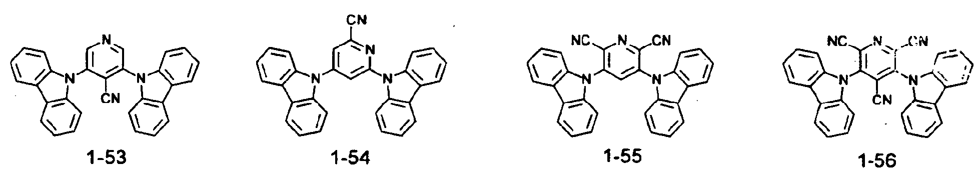

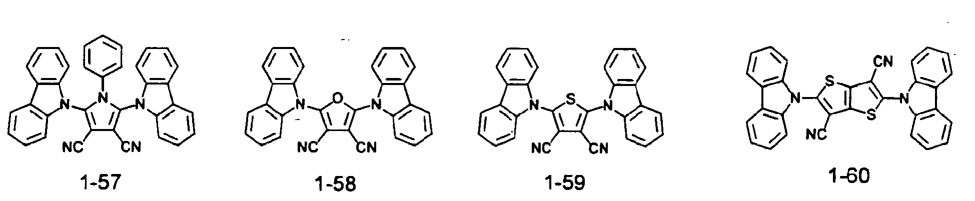

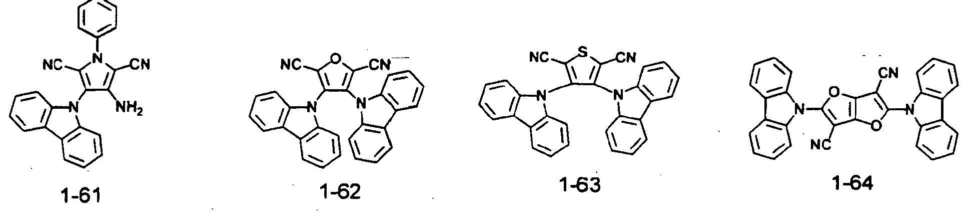

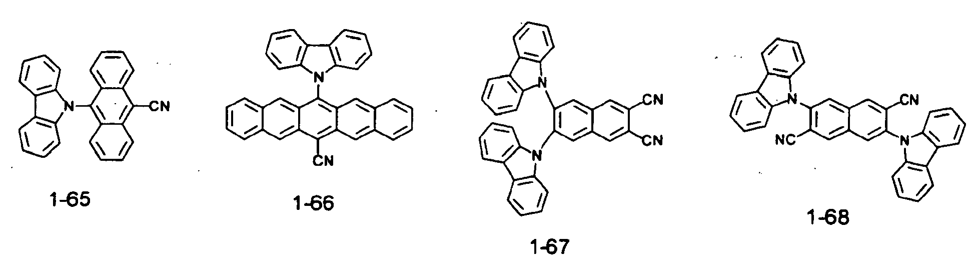

The following are specific examples of the polymer compound or the oligomer compound as the compound represented by the formula (I), but the present invention is not limited to or by them. If the compound of the formula (I) is the polymer compound, the polymer compound may be a homopolymer compound or a copolymer. The copolymer may be any of a random copolymer, an alternating copolymer, or a block copolymer. In the following formulas, m:n represents a molar ratio of monomers contained in the polymer, m represents a number from 1 to 100, n represents a number from 0 to 99, with the proviso that m+n=100. The polymerization degree of m is preferably from 20 to 500, more preferably from 20 to 100.

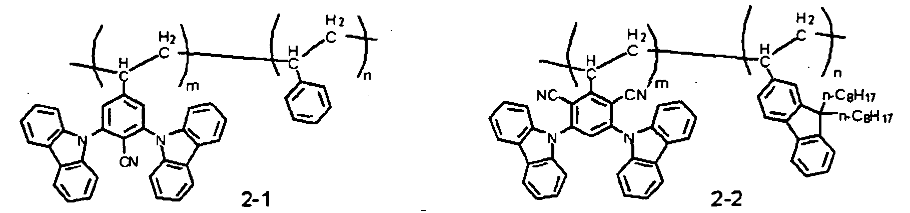

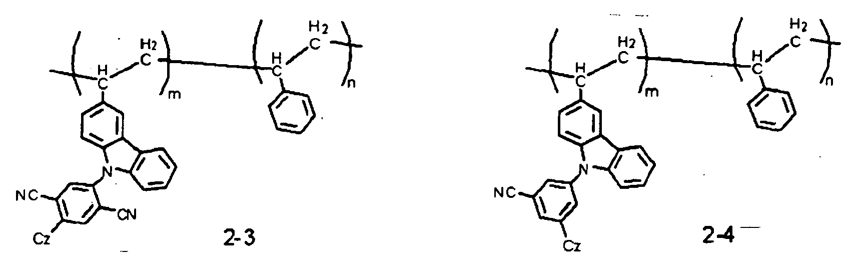

### [Organic electroluminescence device]

The luminescence device of the invention will hereinafter be described specifically.

The device of the invention has a cathode and an anode on a substrate and has, between these electrodes, organic layers including a light emitting layer.

At least one of the anode and the cathode is preferably transparent judging from the nature of a luminescence device.

As a preferable stack mode of the organic layers in the invention, a hole transport layer, a light emitting layer, and an electron transport layer are stacked successively from the side of the anode. Further, the device has a hole injection layer between the hole transport layer and the anode and/or an electron transport intermediate layer between the light emitting layer and the electron transport layer. The device may have a hole transport intermediate layer between the light emitting layer and the hole transport layer. Similarly, it may have an electron injection layer between the cathode and the electron transport layer.

Each layer may be divided into a plurality of secondary layers.

Each of the organic layers can be formed desirably by any one of dry film-forming processes such as vapor deposition or sputtering, transfer process, printing process, coating process, inkjet process and spray process.

Elements constituting the device of the invention will next be described specifically.

### (Substrate)

The substrate to be used in the invention preferably does not scatter or attenuate light emitted from the organic layers. Specific examples include inorganic materials such as yttria-stabilized zirconia (YSZ) and glass; and organic materials, e.g., polyesters such as polyethylene terephthalate, polybutylene terephthalate, and polyethylene naphthalate, polystyrenes, polycarbonates, polyethersulfones, polyarylates, polyimides, polycycloolefins, norbornene resins, and poly(chlorotrifluoroethylene).

When glass is used as the substrate, use of an alkali-free glass is preferred in order to minimize elution of ions from the glass. When soda lime glass is used, a barrier coated one with, for example, silica is preferred. Substrates made of the organic materials are preferred because they are excellent in heat resistance, dimensional stability, solvent resistance, electrical insulating properties, and processability.

The shape, structure, and size of the substrate are not particularly limited and can be selected as needed according to the intended use or purpose of the luminescence device. In general, the substrate is preferably in the form of a plate and may have either a single layer structure or a stacked structure. It may be made of a single member or two or more members.

Although the substrate may be either colorless and transparent or colored and transparent, a colorless and transparent substrate is preferred because such a substrate causes neither scattering nor attenuation of light emitted from the light emitting layer.

The substrate can have, on the surface or backside surface thereof, a moisture penetration preventing layer (gas barrier layer). As materials for the moisture penetration preventing layer (gas barrier layer), inorganic substances such as silicon nitride and silicon oxide are suited. The moisture penetration preventing layer (gas barrier layer) can be formed, for example, by RF sputtering.

When a thermoplastic substrate is used, it may have a hard coat layer or an undercoat layer further if necessary.

### (Anode)

The anode is usually not particularly limited in shape, structure, or size insofar as it has a function as an electrode supplying holes to the organic layers. Materials of the anode can be selected as needed from known electrode materials, depending on the intended use or purpose of the luminescence device. As described above, the anode is usually formed as a transparent anode.

Examples of the materials of the anode include metals, alloys, metal oxides, and electroconductive compounds, and mixtures thereof. Specific examples of the anode material include electroconductive metal oxides such as tin oxides doped with antimony and fluorine (e.g., ATO and FTO), tin oxide, zinc oxide, indium oxide, indium tin oxide (ITO) and indium zinc oxide (IZO), metals such as gold, silver, chromium, and nickel, mixtures or stacks of these metals and electroconductive metal oxides; inorganic electroconductive substances such as copper iodide and copper sulfide, organic electroconductive materials such as polyaniline, polythiophene, and polypyrrole; and stacks of these materials with ITO. Among these materials, electroconductive metal oxides are preferred, with ITO being especially preferred from the viewpoint of productivity, and high conductivity, transparency.

The anode can be formed over the substrate by a process selected as needed from the wet processes such as printing and coating, physical processes such as vacuum deposition, sputtering and ion plating, and chemical processes such as CVD and plasma CVD in consideration of its suitability to the material constituting the anode. When ITO is selected as the anode material, the anode can be formed by DC sputtering, RF sputtering, vacuum deposition, or ion plating.

In the organic electroluminescence device of the invention, the formation position of the anode is not particularly limited and it can be selected as needed depending on the intended use or purpose of the luminescence device. It is however preferably formed on the substrate. In this case, the anode may be formed all over the one surface of the substrate or may be formed in a part thereof.

When the anode is formed, patterning may be performed by chemical etching using photolithography or physical etching with laser exposure. The anode may also be formed by vacuum deposition or sputtering through stacked masks, a lift-off process, or a printing process.

Although the thickness of the anode can be selected as needed, depending on the material constituting the anode and it cannot be specified in a wholesale manner, the thickness is usually from approximately 10 nm to 50 µm, preferably from 50 nm to 20 µm.

The resistivity of the anode is preferably 10³ Ω/sq or less, more preferably 10² Ω/sq. The anode may be either colorless or colored insofar as it is transparent. The transmittance of the anode is preferably 60% or greater, more preferably 70% or greater in order to obtain luminescence from the side of the transparent anode.

Detailed description on transparent anodes is given in *Development of Transparent Conductive Films,* supervised by Yutaka Sawada, published by CMC (1999) and it can be applied to the invention. When a plastic base material having low heat resistance is used, a transparent anode formed using ITO or IZO at a temperature as low as 150°C or less is preferred.

### (Cathode)

The shape, structure or size of the cathode is usually not particularly limited insofar as it has a function as an electrode charging electrons into the organic layers. The material of it can be selected as needed from known electrode materials, depending on the intended use or purpose of the luminescence device.

Materials making up the cathode are, for example, metals, alloys, metal oxides, and electroconductive compounds, and mixtures thereof. Specific examples include alkali metals (such as Li, Na, K, and Cs), alkaline earth metals (such as Mg and Ca), gold, silver, lead, aluminum, sodium-potassium alloy, lithium-aluminum alloy, magnesium-silver alloy, and rare earth metals such as indium and ytterbium. These materials may be used alone. From the viewpoint of satisfying both stability and electron injection property, however, two or more of them can be used preferably in combination.

Of these, alkali metals and alkaline earth metals are preferred as the material constituting the cathode from the viewpoint of electron injection property, while materials composed mainly of aluminum are preferred because of their excellent storage stability.

The term "materials composed mainly of aluminum" means a single substance of aluminum and mixtures or alloys composed of aluminum and from 0.01 to 10 mass% of an alkali metal or an alkaline earth metal (such as a lithium-aluminum alloy and a magnesium-aluminum alloy).

The materials of the cathode are described in detail in JP-A-2-15595 and JP-A-5-121172 and the materials described therein can also be employed in the invention.

The process of forming the cathode is not particularly limited and it can be formed in a known manner. It can be formed in accordance with a process selected as needed from wet processes such as printing and coating, physical processes such as vacuum deposition, sputtering and ion plating, and chemical processes such as CVD and plasma CVD in consideration of the suitability to the above-described material making up the cathode. When a metal is selected as the material for the cathode, the cathode may be formed by simultaneously or successively sputtering one or more of the metals.

When the cathode is formed, patterning may be performed by chemical etching using photolithography or physical etching with laser exposure. The cathode may also be formed by vacuum deposition or sputtering through stacked masks, or by a lift-off process or a printing process.

In the invention, the forming position of the cathode is not particularly limited and it may be formed all over the organic layer or may be formed over a part thereof.

A dielectric layer made of, for example, a fluoride or oxide of an alkali metal or an alkaline earth metal and having a thickness of from 0.1 nm to 5 nm may be inserted between the cathode and the organic layer. This dielectric layer can also be regarded as a kind of an electron injection layer. It may be formed, for example, by vacuum deposition, sputtering or ion plating.

The thickness of the cathode can be selected as needed, depending on the material constituting the cathode and it cannot be determined in a wholesale manner. The thickness is usually from 10 nm to 5 µm, preferably from 50 nm to 1 µm.

The cathode may be either transparent or opaque. A transparent cathode can be obtained by forming the material of the cathode into a thin film with a thickness of from 1 to 10 nm and then stacking thereover a transparent conductive material such as ITO or IZO.

### (Organic layer)

The organic layer in the invention will next be described.

The organic EL device of the invention has at least one organic layer including a light emitting layer. An organic layer other than the light emitting layer is, for example, a hole transport layer, an electron transport layer, a charge blocking layer, a hole injection layer, and an electron injection layer as described above.

In the organic EL device of the invention, these layers constituting the organic layers can be formed preferably by any of dry film forming processes such as vapor deposition and sputtering, wet coating process, transfer process, printing process, and inkjet process.

### (Light emitting layer)

The light emitting layer is a layer having a function of, when voltage is applied, receiving holes from the anode, the hole injection layer, or the hole transport layer, receiving electrons from the cathode, the electron injection layer, or the electron transport layer, and providing a recombination site of the holes and electrons to cause light emission.

The light emitting layer in the invention may be composed only of a. light emitting material. Alternatively, it may be composed of a mixed layer of a host material and a light emitting dopant. The host material is preferably the compound of the invention represented by the formula (I), but compounds other than it may be used either singly or in combination. It will be described later in detail in the section of <Host material>. The light emitting dopant may be either a fluorescent material or phosphorescent material. Two or more materials may be used in combination. The host material is preferably a charge transport material. The host materials may be used either singly or in combination. For example, an electron transmitting host material may be mixed with a hole transporting host material. The light emitting layer may contain a material which has no charge transporting property and does not emit light.

The light emitting layer may be either a single layer or a combination of two or more layers. In the latter case, these layers may emit lights of different colors.

As the light emitting dopant in the invention, either a phosphorescent material or a fluorescent material is usable.

The light emitting layer in the invention can contain two or more light emitting dopants in order to improve color purity or widen the emission wavelength region.

### <Phosphorescent dopant>

Examples of the phosphorescent dopant typically include complexes containing a transition metal atom and a lanthanoid atom.

Preferred examples of the transition metal atom include, but not limited particularly to, ruthenium, rhodium, palladium, tungsten, rhenium, osmium, iridium, gold, silver, copper, and platinum. Of these, rhenium, iridium, and platinum are more preferred, with iridium and platinum being still more preferred.

Examples of the lanthanoid atom include lanthanum, cerium, praseodymium, neodymium, samarium, europium, gadolinium, terbium, dysprosium, holmium, erbium, thulium, ytterbium, and lutecium. Of these, neodium, europium, and gadolinium are preferred.

As the ligand of the; complex, ligands described in, for example, G Wilkinson et al., Comprehensive Coordination Chemistry, published by Pergamon Press in 1987; H. Yersin, Photochemistry and Photophysics of Coordination Compounds, published by Springer-Verlag in 1987; and Yamamoto Akio, Organometallic Chemistry - Principles and Applications, published by Shokabo Publishing in 1982, can be used.

Specific examples of the ligands include preferably halogen ligands (preferably chlorine ligand), aromatic carbocyclic ligands (e.g., preferably C₅₋₃₀, more preferably C₆₋₃₀, still more preferably C₆₋₂₀, especially preferably C₆₋₁₂ ligands such as cyclopentadienyl anions, benzene anions, and naphthyl anions), nitrogen-containing heterocyclic ligands (e.g., preferably C₅₋₃₀, more preferably C₆₋₃₀, still more preferably C₆₋₂₀, especially preferably C₆₋₁₂ ligands such as phenylpyridine, benzoquinoline, quinolinol, bipyridyl, and phenanthroline), diketone ligands (such as acetylacetone), carboxylic acid ligands (e.g., preferably C₂₋₃₀, more preferably C₂₋₂₀, still more preferably C₂₋₁₆ ligands such as acetic acid ligand), alcoholate ligands (e.g., preferably C₁₋₃₀, more preferably C₁₋₂₀, still more preferably C₆₋₂₀ ligands such as phenolate ligand), silyloxy ligands (e.g., preferably C₃₋₄₀, more preferably C₃₋₃₀, still more preferably C₃₋₂₀ ligands such as trimethylsilyloxy ligand, dimethyl-tert-butylsilyloxy ligand and triphenylsilyloxy ligand), carbon monoxide ligand, isonitrile ligand, cyano ligand, phosphorus ligands (e.g., preferably C₃₋₄₀, more preferably C₃₋₃₀, still more preferably C₃₋₂₀, especially preferably C₆₋₂₀ ligands such as triphenylphosphine ligand), thiolato ligands (e.g., preferably C₁₋₃₀, more preferably C₁₋₂₀, still more preferably C₆₋₂₀ such as phenylthiolato ligand), and phosphine oxide ligands (e.g., preferably C₃₋₃₀, more preferably C₈₋₃₀, still more preferably C₁₈₋₃₀ ligands such as triphenylphosphine oxide ligand). Of these, the nitrogen-containing heterocyclic ligands are more preferred.

The above-described complexes may be either a complex containing one transition metal atom in the compound, or a so-called polynuclear complex containing two or more transition metal atoms. They may contain different metal atoms at the same time.

Of these, specific examples of the luminescent dopants include phosphorescent compounds described in patent documents such as U.S. Pat. Nos. 6,303,238B1 and 6,097,147, WO 00/57676, 00/70655, 01/08230, 01/39234A2, 01/41512A1, 02/02714A2, 02/15645A1, 02/44189A1, and 05/19373A2, and JP-A-2001-247859, JP-A-2002-302671, JP-A-2002-117978, JP-A-2003-133074, JP-A-2002-235076, JP-A-2003-123982, and JP-A-2002-170684, EP1211257, JP-A-2002-226495, JP-A-2002-234894, JP-A-2001-247859, JP-A-2001-298470, JP-A-2002-173674, JP-A-2002-203678, JP-A-2002-203679, JP-A-2004-357791, JP-A-2006-256999, JP-A-2007-19462, JP-A-2007-84635, and JP-A-2007-96259. Of these, more preferred examples of the luminescent dopants include Ir complexes, Pt complexes, Cu complexes, Re complexes, W complexes, Rh complexes, Ru complexes, Pd complexes, Os complexes, Eu complexes, Tb complexes, Gd complexes, Dy complexes, and Ce complexes, of which Ir complexes, Pt complexes, and Re complexes are especially preferred. Of these, Ir complexes, Pt complexes, and Re complexes each containing at least one coordination mode of metal-carbon bonds, metal-nitrogen bonds, metal-oxygen bonds, and metal-sulfur bonds are preferred. Furthermore, from the standpoint of luminous efficiency, running durability, and chromaticity, Ir complexes, Pt complexes and Re complexes each containing a tridentate or higher-dentate ligand are especially preferred, with the Ir complexes and Pt complexes being most preferred. Among them, platinum complex having a tetradentate ligand is especially preferred.

### <Fluorescent dopant>

Examples of the fluorescent dopants generally include benzoxazole, benzimidazole, benzothiazole, styrylbenzene, polyphenyl, diphenylbutadiene, tetraphenylbutadiene, naphthalimide, coumarin, pyran, perinone, oxadiazole, aldazine, pyralidine, cyclopentadiene, bis-styrylanthracene, quinacridone, pyrrolopyridine, thiadiazolopyridine, cyclopentadiene, styrylamine, aromatic dimethylidine compounds, condensed polycyclic aromatic compounds (anthracene, phenanthroline, pyrene, perylene, rubrene, and pentacene), various metal complexes as typified by metal complexes of 8-quinolynol, pyromethene complexes, and rare-earth complexes, polymer compounds such as polythiophene, polyphenylene, and polyphenylene vinylene, and organic silanes, and derivatives thereof.

Of these, the following compounds are specific examples of the luminescent dopants, but the present invention is not limited thereto.

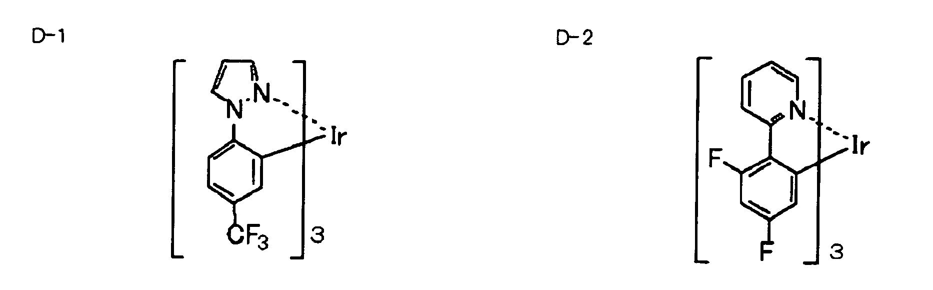

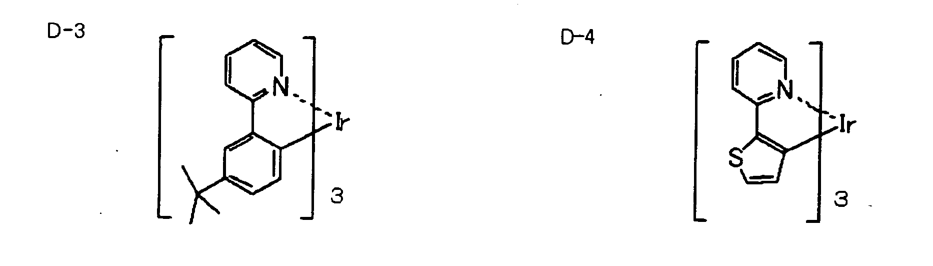

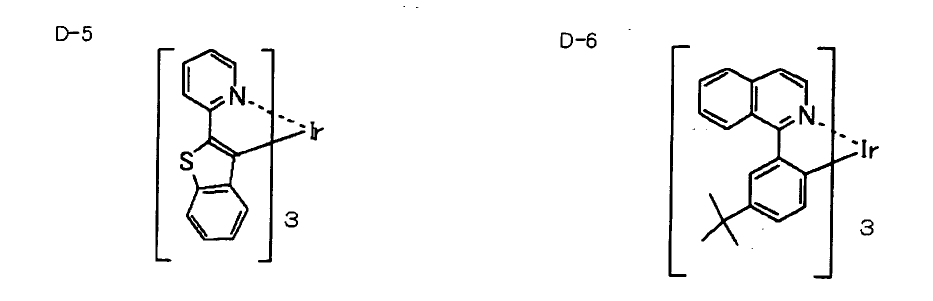

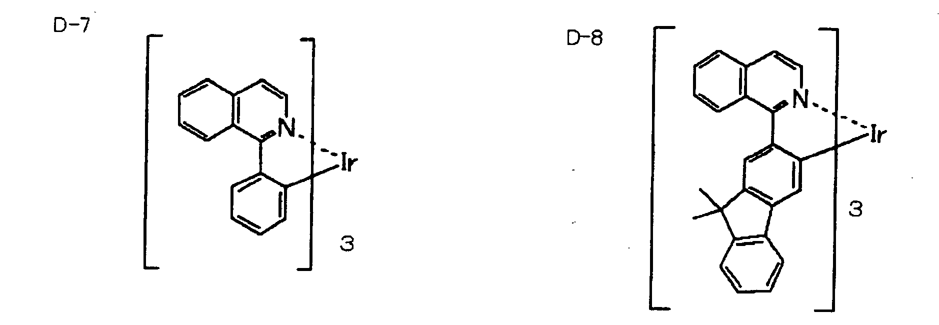

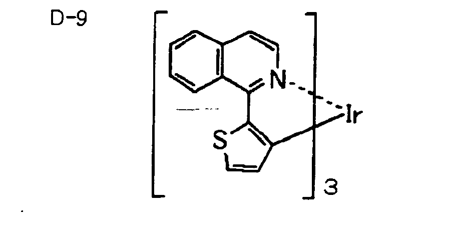

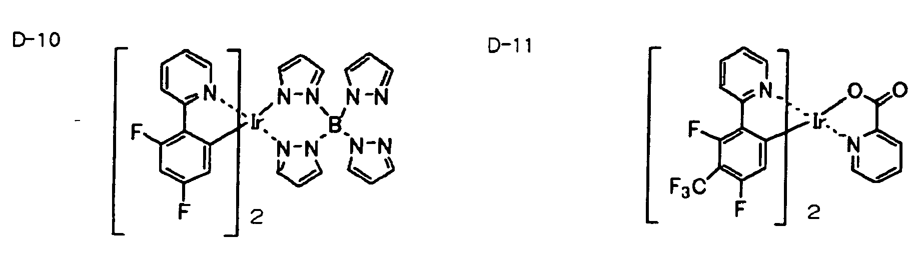

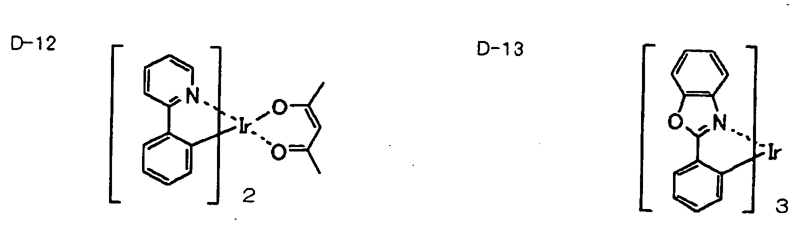

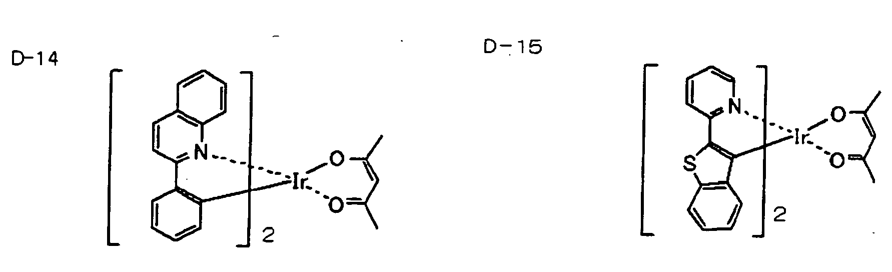

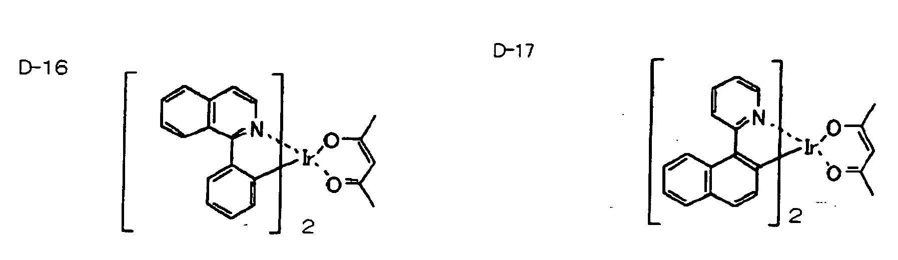

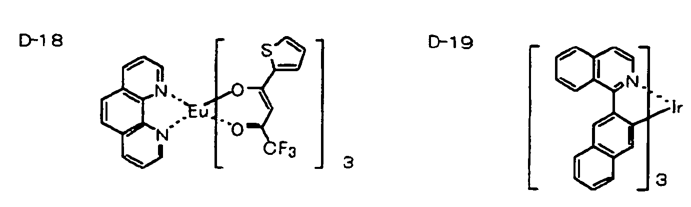

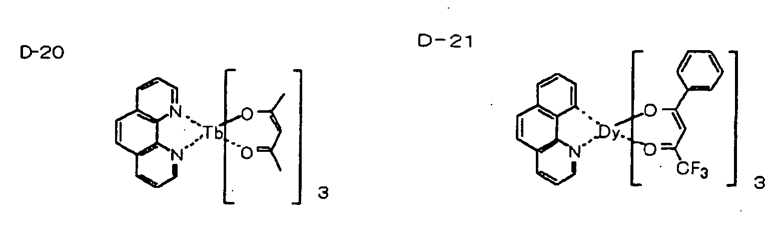

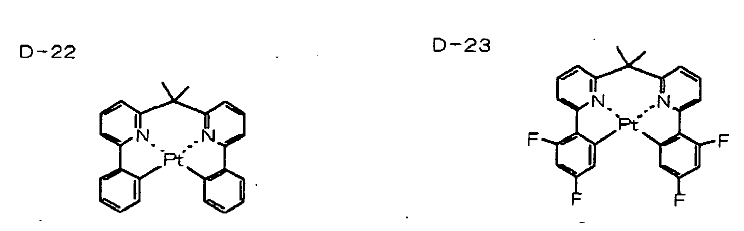

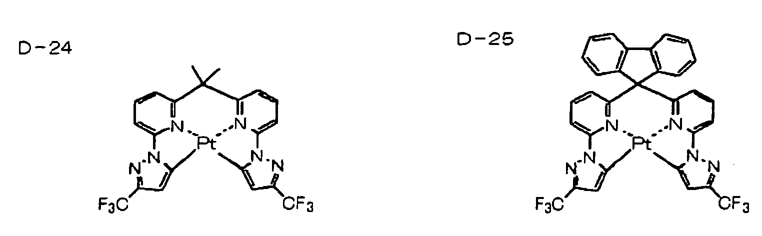

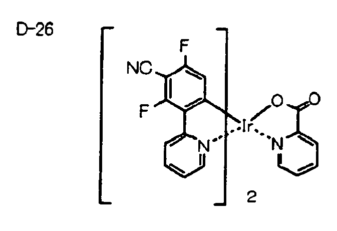

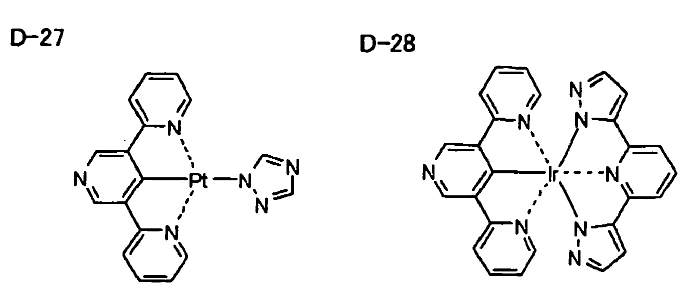

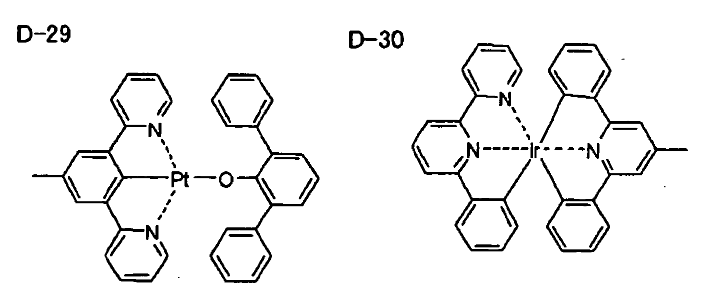

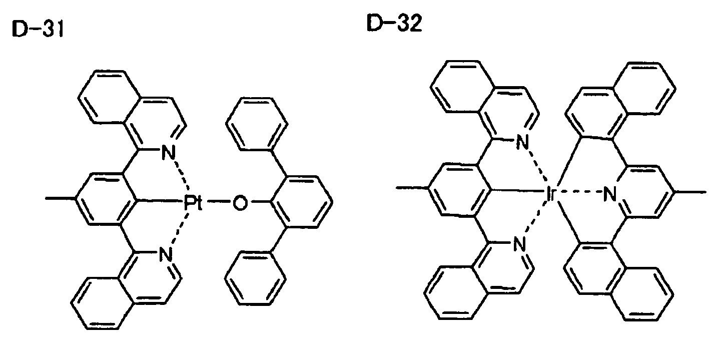

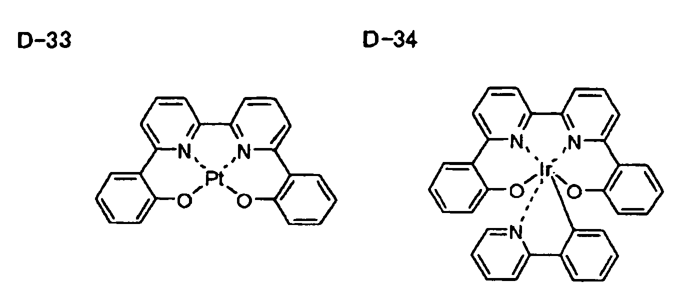

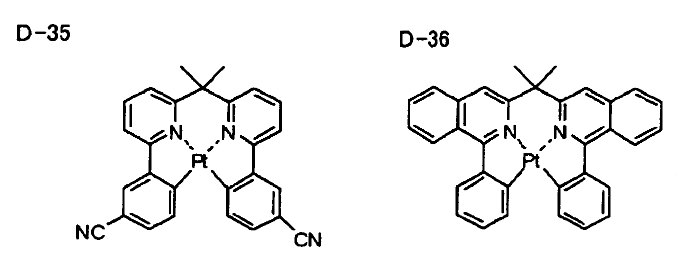

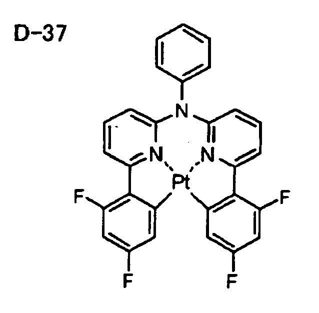

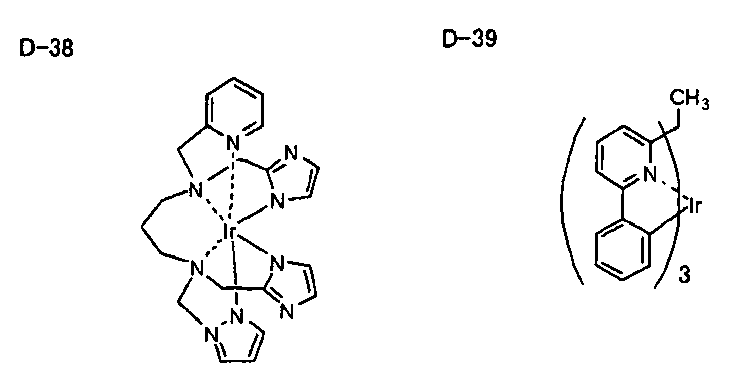

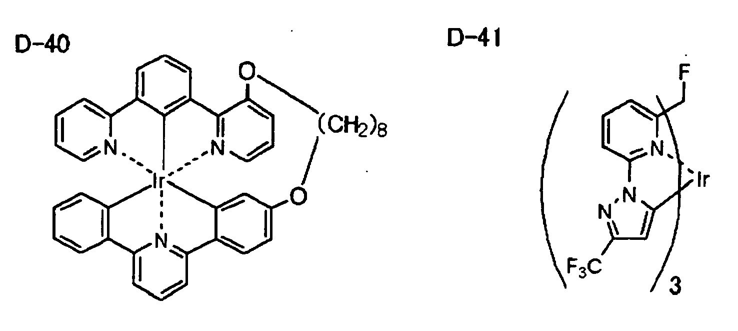

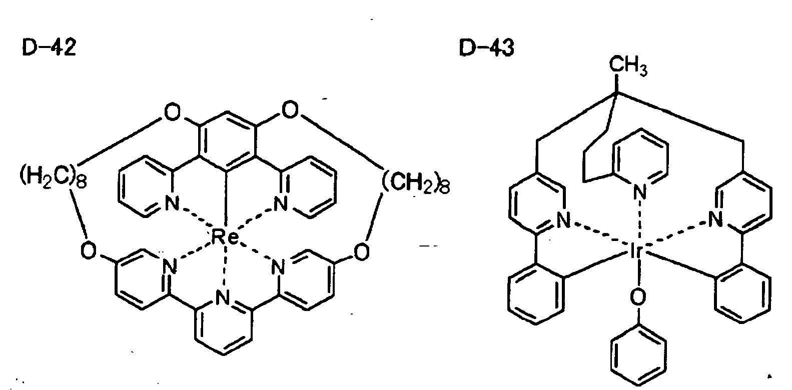

Although the light emitting material is not particularly limited, it is used in combination with preferably a phosphorescent material, more preferably an iridium complex phosphorescent material or a platinum complex phosphorescent material, especially preferably a platinum complex phosphorescent material having a tetradentate ligand. Another phosphorescent material may however be used in combination.

The present organic electroluminescence device preferably contains at least one of platinum complex phosphorescent materials or iridium complex phosphorescent materials in the light emitting layer.

As the complex phosphorescent material, compounds described in Coordination Chemistry Reviews, 250, 2093-2126(2006) may be used.

As the platinum complex phosphorescent material, compounds described in International Patent Publication No. 00-57676 may be used.

Specific examples of the platinum complex phosphorescent material having a tetradentate ligand include compounds described in U.S. Pat. No. 6,653,654, International Patent Publication Nos. 04-108857 and 05-042444, JP-A-2006-232784, International Patent Publication No. 05-042550, JP-A-2005-310733 and JP-A-2005-317516, Japanese Patent Application No. 2005-041939, and International Patent Publication No. 06-098505.

Examples of the iridium complex phosphorescent material include compounds described in International Patent Publication Nos. 00-70655, 01-41512, and 02-5645, JP-A-2002-117978, and International Patent Publication Nos. 04-085450, 06-121811, 05-019373, and 05-113704.

It is far preferred that the present organic electroluminescence device contains at least one platinum complex phosphorescent material having a tetradentate ligand.

Examples of the platinum complex phosphorescent material having a tetradentate ligand include the compounds disclosed in International Patent Publication No. 04/108857.

More specifically, the compounds disclosed in U.S. Pat. No. 6,653,654, International Patent Publication Nos. 04/099339 and 04/108857, JP-A-2005-310733, JP-A-2005-317516, JP-A-2006-261623, JP-A-2006-93542 and JP-A-2006-256999, International Patent Publication No. 06/098505, JP-A-2007-19462, JP-A-2007-96255 and JP-A-2007-96259, International Patent Publication No. 05/042444, JP-A-2006-232784, U.S. Pat. No. 0134461 and International Patent Publication No. 05/042550 are preferred as the platinum complex phosphorescent materials having tetradentate ligands.

The platinum complex phosphorescent materials having tetradentate ligands are preferably those containing 2-arylpyridine derivatives, 2-(1-pyrazolyl)pyridine derivatives or 1-arylpyrazole derivatives as partial structures of their respective ligands, more preferably those containing 2-arylpyridine derivatives or 2-(1-pyrazolyl)pyridine derivatives as partial structures of their respective ligands, especially preferably those containing 2-arylpyridine derivatives as partial structures of their respective ligands.

The partial structures of ligands (e.g., 2-arylpyridine derivatives, 2-(1-pyrazolyl)pyridine derivatives, 1-arylpyrazole derivatives) are linked together at their appropriate sites and form a tetradentate ligand.

In the case of containing 2-arylpyridine derivatives as partial structures of a tetradentate ligand, it is preferable that the linking site of each derivative is the 6-position of the pyridine ring or the aryl carbon in the position meta to the pyridine ring, it is more preferable that their pyridine rings are interlinked at each other's 6-positions or their aryl carbons in the positions meta to the pyridine rings are interlinked, and it is especially preferable that their pyridine rings are interlinked at each other's 6-positions.

In the case of containing 2-(1-pyrazolyl)pyridine derivatives as partial structures of a tetradentate ligand, it is preferable that the linking site of each derivative is the 6-position of the pyridine or the 4-position of the 1-pyrazolyl group, it is more preferable that their pyridine rings are interlinked at each other's 6-positions or their 1-pyrazolyl groups are interlinked at each other's 4-positions, and it is especially preferable that their pyridine rings are interlinked at each other's 6-positions.

In the case of containing 1-arylpyrazole derivatives as partial structures of a tetradentate ligand, it is preferable that the linking site of each derivative is the 3-position of the pyrazole ring or the aryl carbon in the position meta to the pyrazole ring, it is more preferable that their pyrazole rings are interlinked at each other's 3-positions or their aryl carbons in the positions meta to the pyrazole rings are interlinked, and it is especially preferable that their pyrazole rings are interlinked at each other's 3-positions.

A structural unit for interlinking one partial structure of the ligand with another may be either a single bond or a divalent linking group, but it is preferably a divalent linking group. Examples of a divalent linking group preferably used herein include a methylene linkage, an ethylene linkage, a phenylene linkage, a nitrogen linkage, an oxygen linkage, a sulfur linkage and a silicon linkage. Of these linkages, a methylene linkage, a nitrogen linkage and a silicon linkage are preferable to the others, and a methylene linkage is especially preferred. Examples of a methylene linkage include a methylene group (-CH₂-), a methylmethylene group (-CHMe-), a fluoromethylmethylene group (-CFMe-), a dimethylmethylene group (-CMe₂-), a methylphenylmethylene group (-CMePh-), a diphenylmethylene group (-CPh₂-), a 9,9-fluorenediyl group, a 1,1-cyclopentadiyl group and a 1,1-cyclohexanediyl group. Of these groups, a dimethylmethylene group, a diphenylmethylene group, a 9,9-fluorenediyl group, a 1,1-cyclopentanediyl group and a 1,1-cyclohexanediyl group are preferable to the others, a dimethylmethylene group, a diphenylmethylene group and a 1,1-cyclohexanediyl group are more preferred, and a dimethylmethylene group is especially preferred.

A group of compounds preferred as the platinum complex phosphorescent materials having tetradentate ligands are Pt complexes represented by the following formula (A).

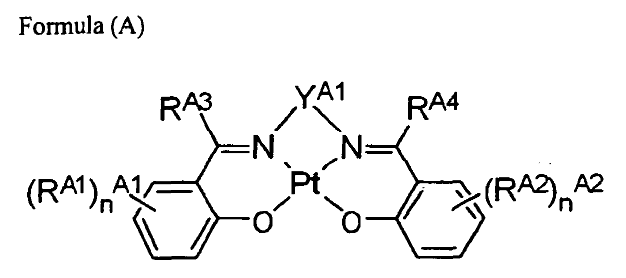

In the formula (A), each of R^{A3} and R^{A4} independently represents a hydrogen atom or a substituent, and each of R^{A1} and R^{A2} independently represents a substituent. When there are two or more R^{A1}s or two or more R^{A2}s in the formula (A), the R^{A1}s or the R^{A2}s may be the same or different, and may combine with each other to form a ring. Each of n^{A1} and n^{A2} independently represents an integer of 0 to 4. Y^{A1} represents a linking group.

The substituents represented by R^{A1}, R^{A2}, R^{A3} and R^{A4} respectively can be selected arbitrarily from the following Group A substituents.

### Group A Substituents:

Alkyl groups (preferably C₁₋₃₀, more preferably C₁₋₂₀, especially preferably C₁₋₁₀, alkyl groups, with examples including a methyl group, an ethyl group, an isopropyl group, a tert-butyl group, an n-octyl group, an n-decyl group, an n-hexadecyl group, a cyclopropyl group, a cyclopentyl group and a cyclohexyl group), alkenyl groups (preferably C₂₋₃₀, more preferably C₂₋₂₀, especially preferably C₂₋₁₀, alkenyl groups, with examples including a vinyl group, an allyl group, a 2-butenyl group and a 3-pentenyl group), alkynyl groups (preferably C₂₋₃₀, more preferably C₂₋₂₀, especially preferably C₂₋₁₀, alkynyl groups, with examples including a propargyl group and a 3-pentynyl group), aryl groups (preferably C₆₋₃₀, more preferably C₆₋₂₀, especially preferably C₆₋₁₂, aryl groups, with examples including a phenyl group, a p-methylphenyl group, a naphthyl group and an anthranyl group), amino groups (preferably C₀₋₃₀, more preferably C₀₋₂0, especially preferably C₀₋₁₀, amino groups, with examples including an amino group, a methylamino group, a dimethylamino group, a diethylamino group, a dibenzylamino group, diphenylamino group and ditolylamino group), alkoxy groups (preferably C₁₋₃₀, more preferably C₁₋₂₀, especially preferably C₁₋₁₀, alkoxy groups, with examples including a methoxy group, an ethoxy group, a butoxy group and a 2-ethylhexyloxy group), aryloxy groups (preferably C₆₋₃₀, more preferably C₆₋₂₀, especially preferably C₆₋₁₂, aryloxy groups, with examples including a phenyloxy group, a 1-napthyloxy group and a 2-naphthyloxy group), heterocyclic oxy groups (preferably C₁₋₃₀, more preferably C₁₋₂₀, especially preferably C₁₋₁₂, heterocyclic oxy groups, with examples including a pyridyloxy group, a pyrazyloxy group, a pyrimidyloxy group and a quinolyloxy group), acyl groups (preferably C₁₋₃₀, more preferably C₁₋₂₀, especially preferably C₁₋₁₂, acyl groups, with examples including an acetyl group, a benzoyl group, a formyl group and a pivaroyl group), alkoxycarbonyl groups (preferably C₂₋₃₀, more preferably C₂₋₂₀, especially preferably C₂₋₁₂, alkoxycarbonyl groups, with examples including a methoxycarbonyl group and an ethoxycarbonyl group), aryloxycarbonyl groups (preferably C₇₋₃₀, more preferably C₇₋₂₀, especially preferably C₇₋₁₂, aryloxycarbonyl groups, with examples including a phenyloxycarbonyl group), acyloxy groups (preferably C₂₋₃₀, more preferably C₂₋₂₀, especially preferably C₁₋₁₀, acyloxy groups, with examples including an acetoxy group and a benzoyloxy group),
acylamino groups (preferably C₂₋₃₀, more preferably C₂₋₂₀, especially preferably C₂₋₁₀, acylamino groups, with examples including an acetylamino group and a benzoylamino group), alkoxycarbonylamino groups (preferably C₂₋₃₀, more preferably C₂₋₂₀, especially preferably C₂₋₁₂, alkoxycarbonylamino groups, with examples including a methoxycarbonylamino group), aryloxycarbonylamino groups (preferably C₇₋₃₀, more preferably C₇₋₂₀, especially preferably C₇₋₁₂, aryloxycarbonylamino groups, with examples including a phenyloxycarbonylamino group), sulfonylamino groups (preferably C₁₋₃₀, more preferably C₁₋₂₀, especially preferably C₁₋₁₂, sulfonylamino groups, with examples including a methanesulfonylamino group and a benzenesulfonylamino group), sulfamoyl groups (preferably C₀₋₃₀, more preferably C₀₋₂₀, especially preferably C₀₋₁₂, sulfamoyl groups, with examples including a sulfamoyl group, a methylsulfamoyl group, a dimethylsulfamoyl group and a phenylsulfamoyl group), carbamoyl groups (preferably C₁₋₃₀, more preferably C₁₋₂₀, especially preferably C₁₋₁₂, carbamoyl groups, with examples including a carbamoyl group, a methylcarbamoyl group, a dimethylcarbamoyl group and a phenylcarbamoyl group), alkylthio groups (preferably C₁₋₃₀, more preferably C₁₋₂₀, especially preferably C₁₋₁₂, alkylthio groups, with examples including a methylthio group and an ethylthio group), arylthio groups (preferably C6-30, more preferably C6-20, especially preferably C6-12, arylthio groups, with examples including a phenylthio group), heterocyclic thio groups (preferably C1-30, more preferably C1-20, especially preferably C1-12, heterocyclic thio groups, with examples including a pyridylthio group, a 2-benzimidazolylthio group, a 2-benzoxazolylthio group and a 2-benzothiazolylthio group),
sulfonyl groups (preferably C₁₋₃₀, more preferably C₁₋₂₀, especially preferably C₁₋₁₂, sulfonyl groups, with examples including a mesyl group and a tosyl group), sulfinyl groups (preferably C₁₋₃₀, more preferably C₁₋₂₀, especially preferably C₁₋₁₂, sulfinyl groups, with examples including a methanesulfinyl group and a benzenesulfinyl group), ureido groups (preferably C₁₋₃₀, more preferably C₁₋₂₀, especially preferably C₁₋₁₂, ureido groups, with examples including a ureido group, a methylureido group and a phenylureido group), phosphoric acid amide groups (preferably C₁₋₃₀, more preferably C₁₋₂₀, especially preferably C₁₋₁₂, phosphoric acid amide groups, with examples including a diethylphosphoric acid amide group and a phenylphosphoric acid amide group), a hydroxyl group, a mercapto group, halogen atoms (e.g., a fluorine atom, a chlorine atom, a bromine atom, an iodine atom), a cyano group, a sulfo group, a carboxyl group, a nitro group, a hydroxamic acid group, a sulfino group, a hydrazino group, an imino group, heterocyclic groups (preferably C₁₋₃₀, more preferably C₁₋₁₂, heterocyclic groups each containing a nitrogen, oxygen or sulfur atom as a hetero atom, with examples including an imidazolyl group, a pyridyl group, a quinolyl group, a furyl group, a thienyl group, a piperidyl group, a morpholino group, a benzoxazolyl group, a benzimidazolyl group, a benzothiazolyl group, a carbazolyl group and an azepinyl group), silyl groups (preferably C₃₋₄₀, more preferably C₃₋₃₀, especially preferably C₃₋₂₄, silyl groups, with examples including a trimethylsilyl group and a triphenylsilyl group), silyloxy groups (preferably C₃₋₄₀, more preferably C₃₋₃₀, especially preferably C₃₋₂₄, silyloxy groups, with examples including a trimethylsilyloxy group and a triphenylsilyloxy group), and phosphoryl groups (with examples including diphenylphosphoryl group and a dimethylphosphoryl group).

The linking group represented by Y^{A1} can be selected arbitrarily from the following Group A linking groups.

### Group A Linking Groups:

Alkylene groups (e.g., methylene, ethylene, propylene), arylene groups (e.g., phenylene, naphthalenediyl), heteroarylene groups (e.g., pyridinediyl, thiophenediyl), imino groups (-NR-) (e.g., phenylimino), an oxy group (-O-), a thio group (-S-), phosphinidene groups (-PR-) (e.g., phenylphosphonidene), silylene groups (-SiRR'-) (e.g., dimethylsilylene, diphenylsilylene) and combinations of two or more of the groups recited above. These linking groups each may further have a substituent.

The substituent represented by each of R^{A1}, R^{A2}, R^{A3} and R^{A4} is preferably an alkyl group, an aryl group or a heterocyclic group, more preferably an aryl group or a heterocyclic group, especially preferably an aryl group.

The linking group represented by Y^{A1} is preferably a vinylene group substituted at the 1- and 2-positions, a phenylene group, a pyridinediyl group, a pyrazinediyl group, a pyrimidinediyl group or a C₁₋₈ alkylene group, more preferably a vinylene group substituted at the 1- and 2-positions, a phenylene group or a C₁₋₆ alkylene group, especially preferably a phenylene group.

The substituent represented by each of R^{A3} and R^{A4} may combine with the linking group represented by Y^{A1} to form a ring. For example, when Y^{A1} is 1,2-phenylene, R^{A3} and R^{A4} may be linked to the 3-position and the 6-position of the phenylene, respectively, to form a 1,10-phenanthroline ring, which may further have substituents.

Another group of compounds preferred as the platinum complex phosphorescent materials having tetradentate ligands are Pt complexes represented by the following formula (B).

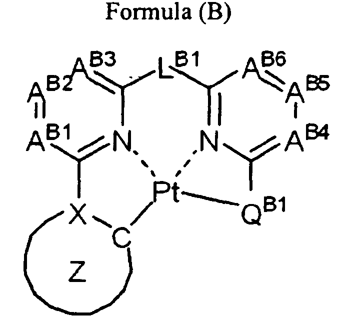

In the formula (B), each of A^{B1} to A^{B6} independently represents C-R or N. R represents a hydrogen atom or a substituent. L^{B1} represents a single bond or a divalent linking group. X represents C or N. Z represents a 5- or 6-membered aromatic ring or heteroaromatic ring formed in cooperation with X-C. Q^{B1} represents an anionic group bonding to Pt.

The formula (B) is illustrated below.

Each of A^{B1} to A^{B6} independently represents C-R or N. R represents a hydrogen atom or a substituent. Examples of the substituent represented by R are the same ones as the Group A substituents include, and the preferred range of each example and that of the corresponding Group A substituent are the same.

Each of A^{B1} to A^{B6} is preferably C-R, and adjacent Rs may combine with each other to form a ring. When each of A^{B1} to A^{B6} is C-R, R in each of A^{B2} and A^{B5} is preferably a hydrogen atom, an alkyl group, an aryl group, an amino group, an alkoxy group, an aryloxy group, a fluoro group or a cyano group, more preferably a hydrogen atom, an amino group, an alkoxy group, an aryloxy group or a fluoro group, especially preferably a hydrogen atom or a fluoro group, and R in each of A^{B1}, A^{B3}, A^{B4} and A^{B6} is preferably a hydrogen atom, an alkyl group, an aryl group, an amino group, an alkoxy group, an aryloxy group, a fluoro group or a cyano group, more preferably a hydrogen atom, an amino group, an alkoxy group, an aryloxy group or a fluoro group, especially preferably a hydrogen atom..

L^{B1} represents a single bond or a divalent linking group. Examples of the divalent linking group represented by L^{B1} include alkylene groups (e.g., methylene, ethylene, propylene), arylene groups (e.g., phenylene, naphthalenediyl), heteroarylene groups (e.g., pyridinediyl, thiophenediyl), imino groups (-NR-) (e.g., phenylimino), an oxy group (-O-), a thio group (-S-), phosphinidene groups (-PR-) (e.g., phenylphosphonidene), silylene groups (-SiRR'-) (e.g., dimethylsilylene, diphenylsilylene) and combinations of two or more of the groups recited above. These linking groups each may further have a substituent.

Of those which are recited above as L^{B1}, a single bond, alkylene groups, arylene groups, heteroarylene groups, imino groups, an oxy group, a thio group and silylene groups are preferable to the others, a single bond, alkylene groups, arylene groups and imino groups are more preferable to the others, and alkylene groups are still more preferable to the others. Among alkylene groups, methylene groups are preferable to the others. Among methylene groups, disubstituted methylene groups are preferable, and dimethylmethylene, diethylmethylene, diisobutylmethylene, dibenzylmethylene, ethylmethylmethylene, methylpropylmethylene, isobutylmethylmethylene, diphenylmethylene, methylphenylmethylene, cyclohexanediyl, cyclopentanediyl, fluorenediyl and fluoromethylmethylene groups are more preferable. Of these groups, dimethylmethylene, diphenylmethylene and cyclohexanediyl groups are especially preferred over the others.

X represents C or N. Z represents a 5- or 6-membered aromatic hydrocarbon ring or aromatic heterocyclic ring formed in cooperation with X-C in the formula. Examples of an aromatic hydrocarbon ring or aromatic heterocyclic ring represented by Z include a benzene ring, a naphthalene ring, an anthracene ring, a pyrene ring, a phenanthrene ring, a perylene ring, a pyridine ring, a quinoline ring, an isoquinoline ring, a phenanthridine ring, a pyrimidine ring, a pyrazine ring, a pyridazine ring, a triazine ring, a cinnoline ring, an acridine ring, a phthalazine ring, a quinazoline ring, a quinoxaline ring, a naphthyridine ring, a pteridine ring, a pyrrole ring, a pyrazole ring, a triazole ring, an indole ring, a carbazole ring, an indazole ring, a benzimidazole ring, an oxazole ring, a thiazole ring, an oxadiazole ring, a thiadiazole ring, a benzoxazole ring, a benzothiazole ring, an imidazopyridine ring, a thiophene ring, a benzothiophene ring, a furan ring, a benzofuran ring, a phosphole ring, a phosphinine ring and a silole ring. Z may have a substituent. To the substituent, any one of the Group A substituents can be applied. In addition, Z may form a fused ring together with another ring.

Examples of a ring preferred as Z include a benzene ring, a naphthalene ring, a pyrazole ring, an imidazole ring, a triazole ring, a pyridine ring, an indole ring and a thiophene ring. Of these rings, a benzene ring, a pyrazole ring and a pyridine ring are preferred over the others.

Q^{B1} represents an anionic group bound to Pt. Examples of the anionic group represented by Q^{B1} include a vinyl ligand, aromatic hydrocarbon ring ligands (e.g., a benzene ligand, a naphthalene ligand, an anthracene ligand, a phenathracene ligand), heterocylic ring ligands (e.g., a furan ligand, a thiophene ligand, a pyridine ligand, a pyrazine ligand, a pyrimidine ligand, a pyridazine ligand, a triazine ligand, a thiazole ligand, a thiazole ligand, an oxazole ligand, a pyrrole ligand, an imidazole ligand, a pyrazole ligand, a triazole ligand), and fused ring ligands containing the rings as recited above (e.g., a quinoline ligand, a benzothiazole ligand). Herein, the bond between Q^{B1} and Pt may be either a covalent bond, or an ionic bond, or a coordinate bond. In the Q^{B1}, the atom bound to Pt is preferably a carbon atom, a nitrogen atom, an oxygen atom, a sulfur atom or a phosphorus atom, more preferably a carbon atom, an oxygen atom or a nitrogen atom, still more preferably a carbon atom.

The group represented by Q^{B1} is preferably an aromatic hydrocarbon ring ligand which is bound to Pt via its carbon atom, an aromatic heterocyclic ring ligand which is bound to Pt via its carbon atom, a nitrogen-containing aromatic heterocyclic ring ligand which is bound to Pt via its nitrogen atom, or an acyloxy ligand, more preferably an aromatic hydrocarbon ring ligand which is bound to Pt via its carbon atom, or an aromatic heterocyclic ring ligand which is bound to Pt via its carbon atom. And it is especially preferred that the group represented by Q^{B1} be the same group as derived from the ring Z formed in cooperation with C-X in the formula (B).

The Pt complexes represented by the formula (B) are preferably Pt complexes represented by the following formula (C).

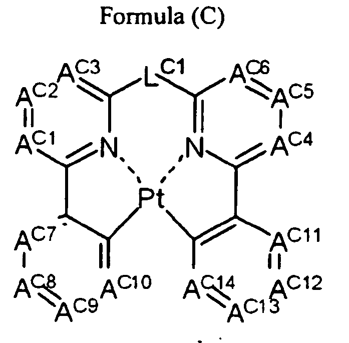

In the formula (C), each of A^{C1} to A^{C14} independently represents C-R or N. R represents a hydrogen atom or a substituent. L^{C1} represents a single bond or a divalent linking group.

The formula (C) is illustrated.

Each of A^{C1} to A^{C14} independently represents C-R or N. R represents a hydrogen atom or a substituent. A^{C1} to A^{C14} have the same meanings as A^{B1} to A^{B6} in the formula (B) have respectively, and preferred ranges thereof and those of A^{B1} to A^{B6} are the same respectively.

As to A^{C1} to A^{C14}, the suitable number of Ns (nitrogen atoms) among the ring constituents A^{C7} to A^{C10} and that among A^{C11} to A^{C14} are each from 0 to 2, preferably from 0 or 1. The ring constituent N is chosen preferably from A^{C8}, A^{C9} or A^{C10} and from A^{C12}, A^{C13} or A^{C14}, respectively, more preferably from A^{C8}, A^{C9}, A^{C12} or A^{C13}, especially preferably from A^{C8} or A^{C12}.

When each of A^{C7} to A^{C14} represents C-R, the R of A^{C8} and A^{C12} each is preferably a hydrogen atom, an alkyl group, a polyfluoroalkyl group, an aryl group, an amino group, an alkoxy group, an aryloxy group, a fluoro group or a cyano group, more preferably a hydrogen atom, a polyfluoroalkyl group, an alkyl group, an aryl group, a fluoro group or a cyano group, especially preferably a hydrogen atom, a polyfluoroalkyl group or a cyano group. The R of A^{C7}, A^{C9}, A^{C11} and A^{C13} each is preferably a hydrogen atom, an alkyl group, a polyfluoroalkyl group, an aryl group, an amino group, an alkoxy group, an aryloxy group, a fluoro group or a cyano group, more preferably a hydrogen atom, a polyfluoroalkyl group, a fluoro group or a cyano group, especially preferably a hydrogen atom or a fluoro group. The R of A^{C10} and A^{C14} each is preferably a hydrogen atom or a fluoro group, more preferably a hydrogen atom. When two of A^{C7} to A^{C9} or two of A^{C11} to A^{C13} are groups represented by C-R, the two Rs may combine with each other to form a ring.

The linking group represented by L^{C1} has the same meaning as the linking group represented by L^{B1} in the formula (B) has, and preferred ranges of these linking groups are also the same.

The Pt complexes represented by the formula (B) are preferably Pt complexes represented by the following formula (D) too.

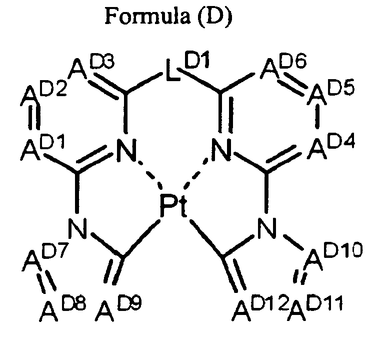

In the formula (D), each of A^{D1} to A^{D12} independently represents C-R or N. R represents a hydrogen atom or a substituent. L^{D1} represents a single bond or a divalent linking group.

The formula (D) is illustrated.

Each of A^{D1} to A^{D12} independently represents C-R or N. R represents a hydrogen atom or a substituent.

A^{D1} to A^{D6} have the same meanings as A^{B1} to A^{B6} in the formula (B) have respectively, and preferred ranges thereof and those of A^{B1} to A^{B6} are the same respectively.

As to A^{D7} to A^{D12}, the suitable number of Ns (nitrogen atoms) among the ring constituents A^{D7} to A^{D9} and that among A^{D10} to A^{D12} are each from 0 to 2, preferably from 1 or 2, especially preferably 1. The ring constituent N is chosen preferably from A^{D7}, A^{D8} or A^{D9} and from A^{D10}, A^{D11} or A^{D12}, respectively, more preferably from A^{D7}, A^{D9}, A^{D10} or A^{D12}, especially preferably from A^{D7} or A^{D10}.

When each of A^{D7} to A^{D12} represents C-R, the R of A^{D8} and A^{D11} each is preferably a hydrogen atom, an alkyl group, a polyfluoroalkyl group, an aryl group, an amino group, an alkoxy group, an aryloxy group, a fluoro group or a cyano group, more preferably a hydrogen atom, a polyfluoroalkyl group, an alkyl group, an aryl group, a fluoro group or a cyano group, especially preferably a polyfluoroalkyl group (e.g., a trifluoromethyl group, a perfluoroethyl group) or a cyano group. The R of A^{D7}, A^{D9}, A^{D10} and A^{D12} each is preferably a hydrogen atom, an alkyl group, a polyfluoroalkyl group, an aryl group, an amino group, an alkoxy group, an aryloxy group, a fluoro group or a cyano group, more preferably a hydrogen atom or a fluoro group, especially preferably a hydrogen atom. When any adjacent two of A^{D7} to A^{D12} are groups represented by C-R, the two Rs may combine with each other to form a ring.

The linking group represented by L^{D1} has the same meaning as the linking group represented by L^{B1} in the formula (B) has, and preferred ranges of these linking groups are also the same.

Still another group of compounds preferred as the platinum complex phosphorescent materials having tetradentate ligands are Pt complexes represented by the following formula (E).

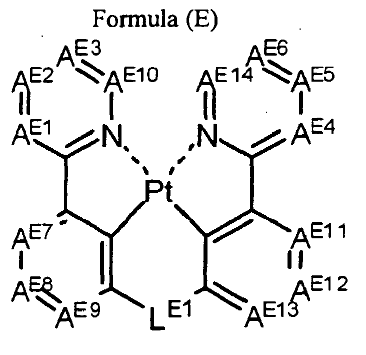

In the formula (E), each of A^{E1} to A^{E14} independently represents C-R or N. R represents a hydrogen atom or a substituent. L^{E1} represents a single bond or a divalent linking group.

The formula (E) is illustrated. Each of A^{E1} to A^{E14} independently represents C-R or N. R represents a hydrogen atom or a substituent. A^{E1} to A^{E6} have the same meanings as A^{B1} to A^{B6} in the formula (B) have respectively, and preferred ranges thereof and those of A^{B1} to A^{B6} are the same respectively. A^{E7} to A^{E14} have the same meanings as A^{C7} to A^{C14} in the formula (C) have respectively, and preferred ranges thereof and those of A^{C7} to A^{C14} are the same respectively.

The linking group represented by L^{E1} has the same meaning as the linking group L^{B1} in the formula (B) has.

L^{E1} is preferably a single bond, an alkylene group, an arylene group, a heteroarylene group, an imino group, an oxy group, a thio group or a silylene group, more preferably an alkylene group, an imino group, an oxy group, a thio group or a silylene group. Of these groups, an alkylene group is preferred over the others. The alkylene group is preferably a methylene group, more preferably a substituted methylene group, especially preferably a disubstituted methylene group. Suitable examples of the disubstituted methylene group include a dimethylmethylene group, a diethylmethylene group, a diisobutylmethylene group, a dibenzylmethylene group, an ethylmethylmethylene group, a methylpropylmethylene group, an isobutylmethylmethylene group, a diphenylmethylene group, a methylphenylmethylene group, a cyclohezanediyl group, a cyclopentanediyl group, a fluorenediyl group and a fluoromethylmethylene group. Of these disubstituted methylene group, a dimethylmethylene group, a diphenylmethylene group and a cyclohexanediyl group are preferred over the others.

A further group of compounds preferred as the platinum complex phosphorescent materials having tetradentate ligands are Pt complexes represented by the following formula (F).

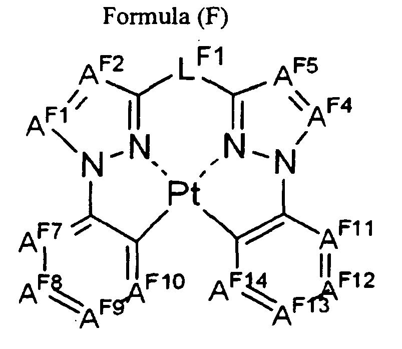

In the formula (F), each of A^{F1} to A^{F14} independently represents C-R or N. R represents a hydrogen atom or a substituent. L^{F1} represents a single bond or a divalent linking group.

The formula (F) is illustrated.

Each of A^{F1} to A^{F14} independently represents C-R or N. R represents a hydrogen atom or a substituent. A^{F1} to A^{F5} have the same meanings as A^{B1} to A^{B5} in the formula (B) have respectively. Each of A^{F1} to A^{F5} is preferably C-R, and two Rs may combine with each other to form a ring. When each of A^{F1} to A^{F5} is C-R, the R is preferably a hydrogen atom, an alkyl group, an aryl group, an amino group, an alkoxy group, an aryloxy group, a fluoro group or a cyano group, more preferably a hydrogen atom, an aryl group, a fluoro group or a cyano group, especially preferably a hydrogen atom.

A^{F7} to A^{F14} have the same meanings as A^{C7} to A^{C14} in the formula (C) have respectively, and the preferred ranges thereof and those of A^{C7} to A^{C14} are the same respectively. When two of A^{F7} to A^{F9} or two or A^{F11} to A^{F13} are groups represented by C-R, the two Rs may combine with each other to form a ring. The ring formed is preferably a furan ring, a benzofuran ring, a pyrrole ring, a benzopyrrole ring, a benzothiophene ring or a fluorene ring, which each may further has a substituent.

The linking group represented by L^{F1} has the same meaning as the linking group represented by L^{B1} in the formula (B) has, and preferred ranges of these linking groups are also the same.

Examples of the platinum complex phosphorescent materials having tetradentate ligands include the following, but they are not limited to these complexes.

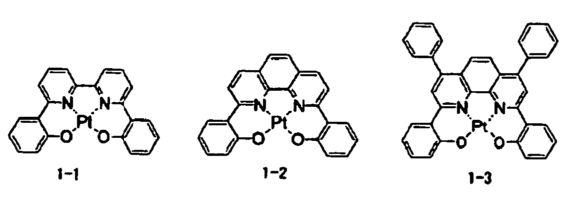

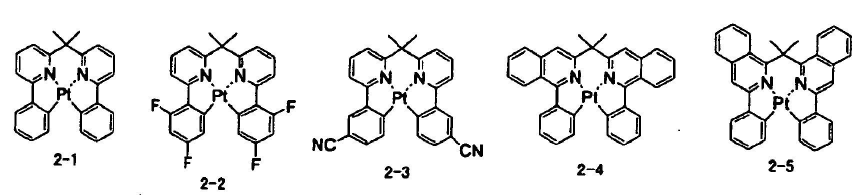

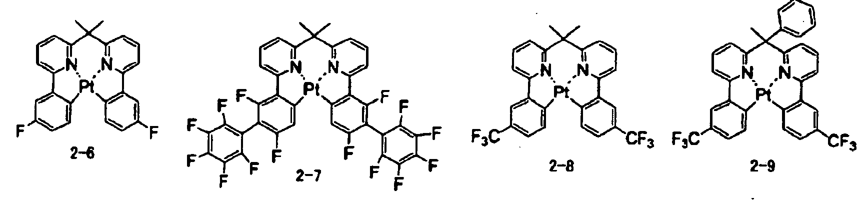

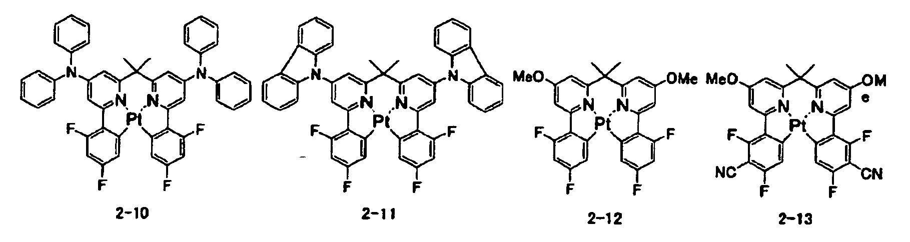

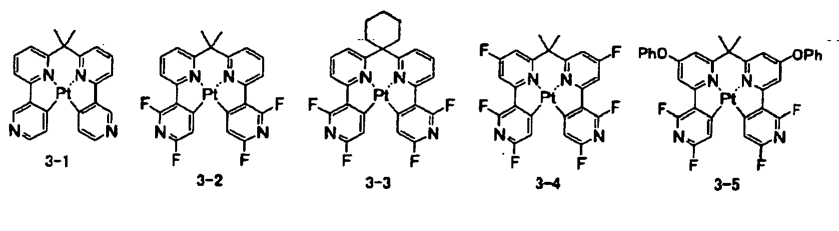

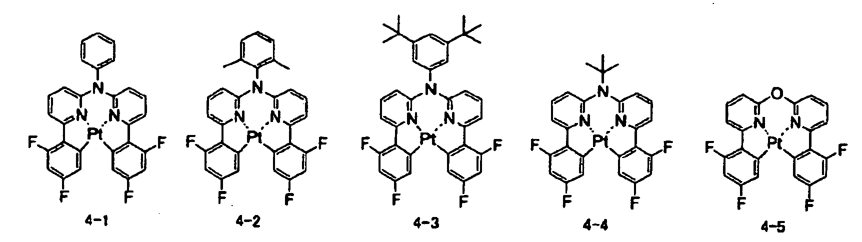

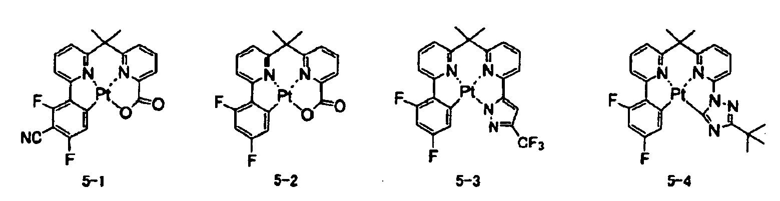

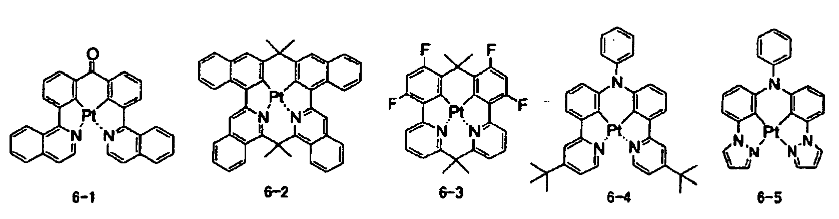

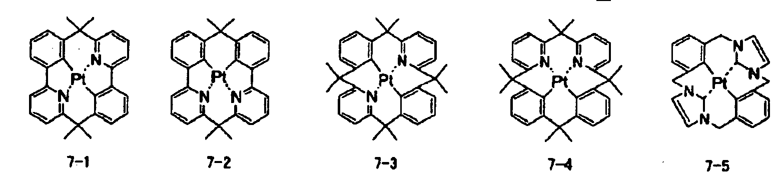

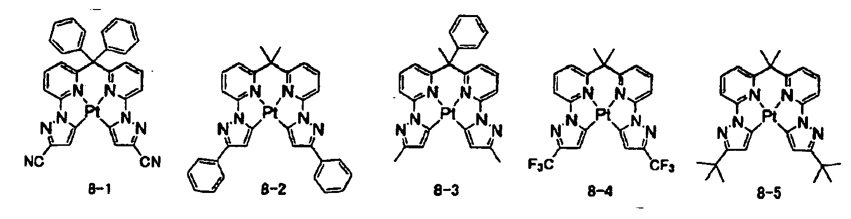

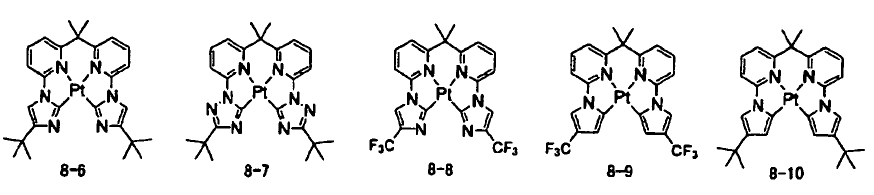

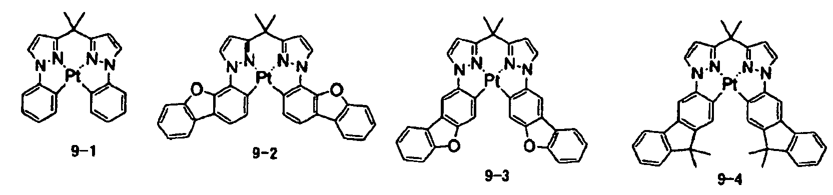

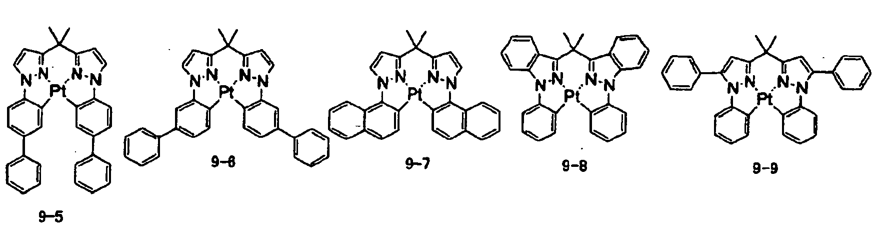

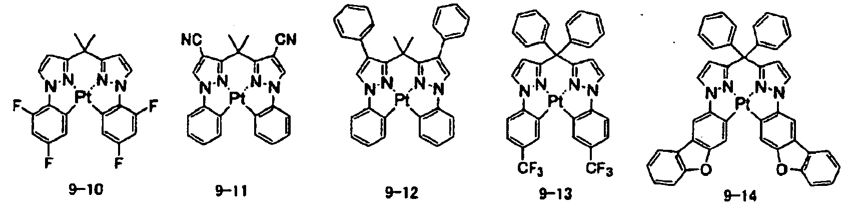

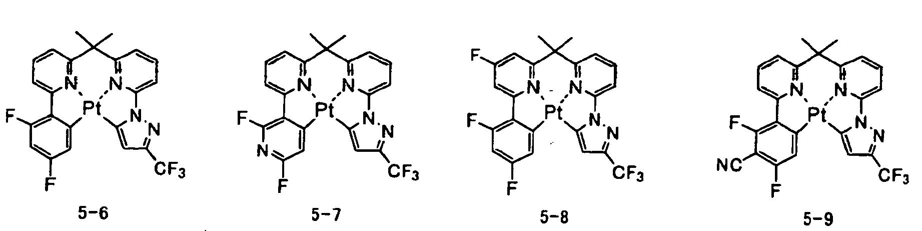

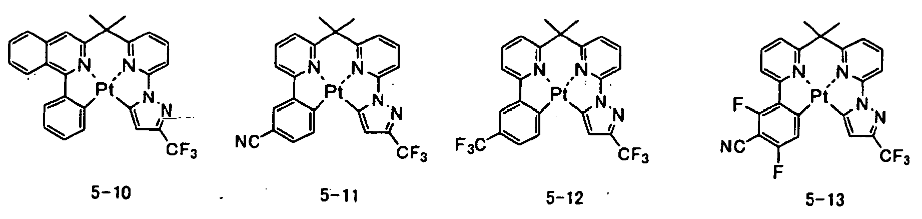

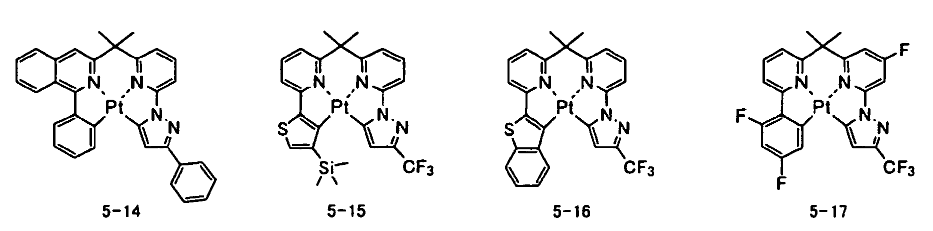

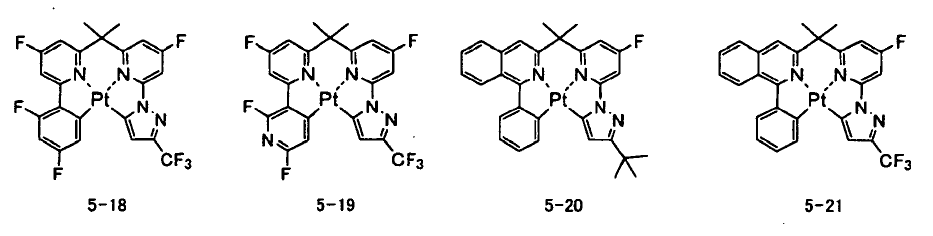

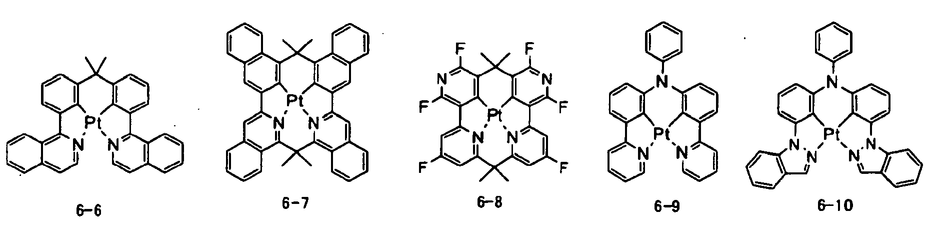

The metal complex compounds illustrated above can be synthesized according to various methods, such as the methods described in Journal of Organic Chemistry, 53, 786 (1988), and more specifically, G.R. Newkome et al., page 789, left column, line 53, to right column, line 7, page 790, left column, lines 18 to 38, and page 790, right column, lines 19 to 30, combinations of these methods, and the method described in Chemische Berichte, 113, 2749 (1980), and more specifically, H, Lexy et al., page 2752, lines 26 to 35.

For example, those compounds can be synthesized from metal compounds and ligands or dissociated ligands in the presence or absence of a solvent (e.g., a halogen-containing solvent, an alcohol solvent, an ether solvent, an ester solvent, a ketone solvent, a nitrile solvent, an amide solvent, a sulfone solvent, a sulfoxide solvent, water), in the presence or absence of a base (including inorganic and organic bases, such as sodium methoxide, potassium t-butoxide, triethylamine and potassium carbonate) under room temperature or application of heat (in the usual way or by means of a microwave device).

The platinum complexes having tetradentate ligands, though favorably used as light-emitting materials, may be used as materials other than light-emitting ones.

Each of the platinum complexes having tetradentate ligands is generally incorporated into a light-emitting layer in an amount of 0.1 to 50 mass% based on all the compounds forming the light-emitting layer. From the viewpoints of durability and external quantum efficiency, the platinum complex content in the light-emitting layer is preferably from 1 to 50 mass%, more preferably from 2 to 40 mass%.

Examples of an iridium complex phosphorescent material include the compounds disclosed in International Patent Publication Nos. 00/70655, 01/41512, and 02/5645, JP-A-2002-117978, and International Patent Publication Nos. 04/085450, 06/121811, 05/019373 and 05/113704.

Iridium complexes especially suitable as iridium complex phosphorescent materials are an iridium complex whose ligand is bound to an iridium atom via its carbene, an iridium complex whose ligand is bound to an iridium atom via the nitrogen atom of its pyrazole skeleton and an iridium complex whose ligand is bound to an iridium atom via the nitrogen atom of its pyridine skeleton. Of these iridium complexes, the iridium complex whose ligand is bound to an iridium atom via its carbene and the iridium complex whose ligand is bound to an iridium atom via the nitrogen atom of its pyrazole skeleton are preferable to the other. And the iridium complex whose ligand is bound to an iridium atom via the nitrogen atom of its pyrazole skeleton is especially preferred.

The expression of "ligand is bound to an iridium atom" signifies that the bond between a ligand and an iridium atom may be either a covalent bond, or a coordinate bond, or an ionic bond.

Examples of the carbene forming a coordinate bond together with an iridium atom include carbon monoxide, an isonitrile group and a carbon carbene stabilized with a hetero atom.

Suitable examples of an iridium complex phosphorescent material containing a ligand bound to an iridium atom via its carbene include iridium complexes represented by the following formula (II).

The formula (II) is illustrated.

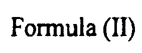

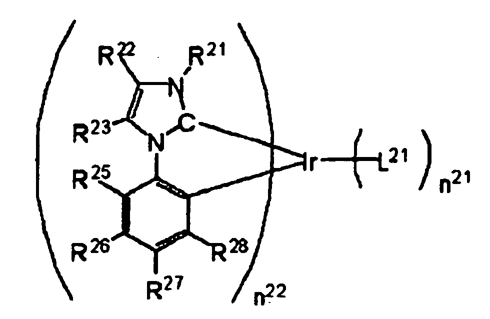

In the formula (II), each of R²¹ to R²³ and R²⁵ to R²⁸ independently represents a hydrogen atom or a substituent, L²¹ represents a ligand, n²² represents an integer of 1 to 3, and n²¹ represents an integer of 0 to 4. C represents the carbene carbon and forms a coordinate bond together with the iridium atom.

Each of R²¹ to R²³ and R²⁵ to R²⁸ independently represents a hydrogen atom or a substituent.

Examples of the substituent include alkyl groups (preferably C₁₋₃₀, more preferably C₁₋₂₀, especially preferably C₁₋₁₀, alkyl groups, such as methyl, ethyl, isopropyl, tert-butyl, n-octyl, n-decyl, n-hexadecyl, cyclopropyl, cyclopentyl and cyclohexyl), alkenyl groups (preferably C₂₋₃₀, more preferably C₂₋₂₀, especially preferably C₂₋₁₀, alkenyl groups, such as vinyl, allyl, 2-butenyl and 3-pentenyl), alkynyl groups (preferably C₂₋₃₀, more preferably C₂₋₂₀, especially preferably C₂₋₁₀, alkynyl groups, such as propargyl and 3-pentynyl), aryl groups (preferably C₆₋₃₀, more preferably C₆₋₂₀, especially preferably C₆₋₁₂, aryl groups, such as phenyl, p-methylphenyl, naphthyl and anthranyl), amino groups (preferably C₀₋₃₀, more preferably C₀₋₂₀, especially preferably C₀₋₁₀, amino groups, such as amino, methylamino, dimethylamino, diethylamino, dibenzylamino, diphenylamino and ditolylamino), alkoxy groups (preferably C₁₋₃₀, more preferably C₁₋₂₀, especially preferably C₁₋₁₀, alkoxy groups, such as methoxy, ethoxy, butoxy and 2-ethylhexyloxy), aryloxy groups (preferably C₆₋₃₀, more preferably C₆₋₂₀, especially preferably C₆₋₁₂, aryloxy groups, such as phenyloxy, 1-naphthyloxy and 2-naphthyloxy), heterocyclic oxy groups (preferably C₁₋₃₀, more preferably C₁₋₂₀, especially preferably C₁₋₁₂, heterocyclic oxy groups, such as pyridyloxy, pyrazyloxy, pirimidyloxy and quinolyloxy), acyl groups (preferably C₂₋₃₀, more preferably C₂₋₂₀, especially preferably C₂₋₁₂, acyl groups, such as acetyl, benzoyl, formyl and pivaroyl), alkoxycarbonyl groups (preferably C₂₋₃₀, more preferably C₂₋₂₀, especially preferably C₂₋₁₂, alkoxycarbonyl groups, such as methoxycarbonyl and ethoxycarbonyl), aryloxycarbonyl groups (preferably C₇₋₃₀, more preferably C₇₋₂₀, especially preferably C₇₋₁₂, aryloxycarbonyl groups, such as phenyloxycarbonyl), acyloxy groups (preferably C₂₋₃₀, more preferably C₂₋₂₀, especially preferably C₂₋₁₀, acyloxy groups, such as acetoxy and benzoyloxy), acylamino groups (preferably C₂₋₃₀, more preferably C₂₋₂₀, especially preferably C₂₋₁₀, acylamino groups, such as acetylamino and benzoylamino), alkoxycarbonylamino groups (preferably C₂₋₃₀, more preferably C₂₋₂₀, especially preferably C₂₋₁₂, alkoxycarbonylamino groups, such as methoxycarbonylamino), aryloxycarbonylamino groups (preferably C₇₋₃₀, more preferably C₇₋₂₀, especially preferably C₇₋₁₂, aryloxycarbonylamino groups, such as phenyloxycarbonylamino), sulfonylamino groups (preferably C₁₋₃₀, more preferably C₁₋₂₀, especially preferably C₁₋₁₀, sulfonylamino groups, such as methanesulfonylamino and benzenesulfonylamino), sulfamoyl groups (preferably C₀₋₃₀, more preferably C₀₋₂₀, especially preferably C₀₋₁₂, sulfamoyl groups, such as sulfamoyl, methylsulfamoyl, dimethylsulfamoyl and phenylsulfamoyl), carbamoyl groups (preferably C₁₋₃₀, more preferably C₁₋₂₀, especially preferably C₁₋₁₂, carbamoyl groups, such as carbamoyl, methylcarbamoyl, diethylcarbamoyl and phenylcarbamoyl), alkylthio groups (preferably C₁₋₃₀, more preferably C₁₋₂₀, especially preferably C₁₋₁₂, alkylthio groups, such as methylthio and ethylthio), arylthio groups (preferably C₆₋₃₀, more preferably C₆₋₂₀, especially preferably C₆₋₁₂, arylthio groups, such as phenylthio), heterocyclic thio groups (preferably C₁₋₃₀, more preferably C₁₋₂₀, especially preferably C₁₋₁₂, heterocyclic thio groups, such as pyridylthio, 2-benzimidazolylthio, 2-benzoxazolylthio and 2-benzthiazolylthio), sulfonyl groups (preferably C₁₋₃₀, more preferably C₁₋₂₀, especially preferably C₁₋₁₂, sulfonyl groups, such as mesyl and tosyl), sulfinyl groups (preferably C₁₋₃₀, more preferably C₁₋₂₀, especially preferably C₁₋₁₂, sulfinyl groups, such as methanesulfinyl and benzenesulfinyl), ureido groups (preferably C₁₋₃₀, more preferably C₁₋₂₀, especially preferably C₁₋₁₂, ureido groups, such as ureido, methylureido and phenylureido), phosphoric acid amide groups (preferably C₁₋₃₀, more preferably C₁₋₂₀, especially preferably C₁₋₁₂, phosphoric acid amide groups, such as diethylphosphoric acid amido and phenylphosphoric acid amido), a hydroxy group, a mercapto group, halogen atoms (e.g., a fluorine atom, a chlorine atom, a bromine atom, an iodine atom), a cyano group, a sulfo group, a carboxyl group, a nitro group, a hydroxamic acid group, a sulfino group, a hydrazino group, an imino group, heterocyclic groups (preferably C₁₋₃₀, more preferably C₁₋₁₂, heterocyclic groups each containing a nitrogen, oxygen or sulfur atom as a hetero atom, with examples including imidazolyl, pyridyl, quinolyl, furyl, thienyl, piperidyl, morpholino, benzoxazolyl, benzimidazolyl, benzothiazolyl, carbazolyl and azepinyl), silyl groups (preferably C₃₋₄₀, more preferably C₃₋₃₀, especially preferably C₃₋₂₄, silyl groups, such as trimethylsilyl and triphenylsilyl), and silyloxy groups (preferably C₃₋₄₀, more preferably C₃₋₃₀, especially preferably C₃₋₂₄, silyloxy groups, such as trimethylsilyloxy and triphenylsilyloxy). These substituents each may further be substituted.

R²¹ and R²², or R²² and R²³, may combine with each other to form a ring structure.

The substituent as R²¹ is preferably an alkyl group, an aryl group or a heteroaryl group, more preferably an alkyl group or an aryl group, especially preferably a methyl group, a tert-butyl group, a phenyl group, a mesityl group or a 2-o-xylyl group.

The substituent as R²² and R²³ each is preferably an alkyl group, an aryl group or a heteroaryl group, more preferably an alkyl group or an aryl group, especially preferably a methyl group, a tert-butyl group or a phenyl group.

The substituent as R²⁵ to R²⁷ each is preferably an alkyl group, an aryl group, a heteroaryl group, a halogen atom or a cyano group, more preferably an alkyl group, an aryl group, a halogen atom or a cyano group, especially preferably a methyl group, a tert-butyl group, a phenyl group, a fluorine atom or a cyano group.

L²¹ represents a ligand. Examples of the ligand include the ligands described in, for example, H. Yersin, Photochemistry and Photophysics of Coordination Compounds, published by Springer-Verlag in 1987; and Yamamoto Akio, Yuki Kinzoku Kagaku Kiso to Oyo (which might be translated "Organometallic Chemistry - Principles and Applications"), published by Shokabo Publishing in 1982. And more specifically, the ligand is preferably a halogen ligand (preferably a chlorine ligand or a bromine ligand), a nitrogen-containing heterocyclic ring ligand (such as bipyridyl, phenanthroline, phenylpyridine, pyrazolylpyridine, benzimidazolylpyridine, phenylpyrazole, picolinic acid or a dipicolinic acid), a diketone ligand (such as acetylacetone, 1,1,1,5,5,5-hexafluoropentane-2,3-dione or 2,2,6,6-tetramethylheptane-3,5-dione), a nitrile ligand, a CO ligand, an isonitrile ligand, a phosphorus-containing ligand (such as a phosphine derivative, a phosphorous ester derivative or a phosphinine derivative) or a carboxylic acid ligand (such as acetic acid ligand), more preferably a nitrogen-containing heterocyclic ring ligand or a diketone ligand, especially preferably a diketone ligand.

The nitrogen-containing heterocyclic ring in a nitrogen-containing heterocyclic ring ligand is preferably a pyridine ring, a pyrazine ring, a pyrimidine ring, a pyridazine ring, a pyrrole ring, a pyrazole ring, an imidazole ring, a triazole ring, a thiazole ring, an oxazole ring, an oxadiazole ring, a thiadiazole ring or an azaphosphinine ring, more preferably a pyridine ring, a pyrrole ring, a pyrazole ring or an imidazole ring, still more preferably a pyridine ring, a pyrazole ring or an imidazole ring.

Each of these nitrogen-containing heterocyclic ligands may have a substituent. Examples of the substituent include the groups recited as examples of the substituent represented by R¹¹. Of such groups, an alkyl group, an aryl group, an alkoxy group, a fluorine atom, a cyano group, a substituted amino group and the like are preferred over the others.

n²² is preferably 2 or 3, especially preferably 3. When n²¹ is 2 or 3, a plurality of L²¹s may be the same or different. When n²² is 2 or 3, the ligands the number of which is determined by the n²² may be the same or different.

Of the iridium complex phosphorescent materials which each contain a ligand bound to an iridium atom via its carbene and are represented by the formula (II), iridium complex phosphorescent materials represented by the following formula (III) are preferred.

The formula (III) are illustrated.

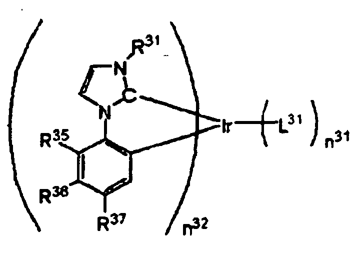

In the formula (III), R³¹ represents an alkyl group or an aryl group, each of R³⁵ to R³⁷ independently represents a hydrogen atom, a fluorine atom, an alkyl group or a cyano group. Alternatively, R³⁵ and R³⁶, or R³⁶ and R³⁷, may combine with each other to form a fused ring structure. L³¹ represents a ligand, n³² represents an integer of 1 to 3, and n³¹ represents an integer of 0 to 4. C represents a carbene carbon and forms a coordinate bond together with an iridium atom.

R³¹ represents an alkyl group or an aryl group, preferably an alkyl group.

The alkyl group of R³¹ is preferably a methyl group, an ethyl group, a tert-butyl group or a cyclohexyl group, more preferably a methyl group or a tert-butyl group, especially preferably a methyl group.

The aryl group of R³¹ is preferably a phenyl group, a p-methylphenyl group, a 2-xylyl group, a 5-xylyl group, a mesityl group, a 1-naphthyl group, a 2-naphthyl group. or an anthranyl group, more preferably a phenyl group, a p-methylphenyl group, a 2-xylyl group, a 5-xylyl group or a mesityl group, especially preferably a phenyl group.

R³⁵, R³⁶ and R³⁷ have the same meanings as the substituents R²⁵, R²⁶ and R²⁷ in the formula (II) have respectively.

R³⁵ is preferably a hydrogen atom, a fluorine atom, an alkyl group or a cyano group, more preferably a hydrogen atom, a fluorine atom or a cyano group, especially preferably a fluorine atom.

R³⁶ is preferably a hydrogen atom, a fluorine atom, an alkyl group or a cyano group, more preferably a hydrogen atom, a fluorine atom or a cyano group, especially preferably a cyano group.

R³⁷ is preferably a hydrogen atom, a fluorine atom, an alkyl group or a cyano group, more preferably a fluorine atom or a cyano group, especially preferably a cyano group.

The alkyl group of R³⁵, R³⁶ and R³⁷ each is preferably a methyl group, an ethyl group, a tert-butyl group, a cyclohexyl group, a trifluoromethyl group or a perfluorobutyl group, more preferably a methyl group, a tert-butyl group, a trifluoromethyl group or a perfluorobutyl group, especially preferably a trifluoromethyl group.

The benzene-fused ring structure formed by combining R³⁵ and R³⁶ or by combining R³⁶ and R³⁷ is preferably dibenzofuranyl, dibenzothiophenyl, N-phenylcarbazolyl, N-methylcarbazolyl, 9,9-dimethylfluorenyl, N-phenylindolyl, benzothienyl or 1,1-dimethylindenyl, more preferably dibenzofuryl, dibenzothiophenyl, N-phenylcarbazolyl, N-methylcarbazolyl or 9,9-dimethylfluorenyl, especially preferably a dibenzofranyl.

Each of the bonding positions of oxygen and sulfur atoms in the dibenzofuranyl and dibenzothiophenyl structures, respectively, which are each formed by combining R³⁵ and R³⁶ or by combining R³⁶ and R³⁷, is preferably in the position of R³⁵ or R³⁷, especially preferably in the position of R³⁵.

L³¹ has the same meaning as the ligand L²¹ in the formula (II) has, and preferred ranges of these ligands are also the same.

n³¹and n³² have the same meanings as n²¹ and n²² in the formula (II) have respectively, and preferred ranges thereof and those of n²¹ and n²² are also the same respectively.

The iridium complex phosphorescent materials which each contain a ligand bound to the iridium atom via the nitrogen atom of its pyrazole skeleton are preferably iridium complexes represented by the following formula (IV).

The formula (IV) is illustrated.

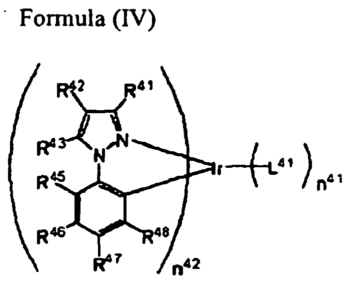

In the formula (IV), each of R⁴¹ to R⁴³ and R⁴⁵ to R⁴⁸ independently represents a hydrogen atom or a substituent, L⁴¹ represents a ligand, n⁴² represents an integer of 1 to 3, and n⁴¹ represents an integer of 0 to 4.

R⁴¹ to R⁴³ and R⁴⁵ to R⁴⁸ have the same meanings as R²¹ to R²³ and R²⁵ to R²⁸ in the formula (II) have respectively.

The substituent as R⁴¹ to R⁴³ each is preferably an alkyl group, an aryl group or a heteroaryl group, more preferably an alkyl group or an aryl group, especially preferably a methyl group, a tert-butyl group or a phenyl group.

The substituent as R⁴⁵ to R⁴⁷ each is preferably an alkyl group, an aryl group, a heteroaryl group, a halo group or a cyano group, more preferably an alkyl group, an aryl group, a halo group or a cyano group, especially preferably a methyl group, a tert-butyl group, a phenyl group, a fluorine atom or a cyano group.

R⁴⁵ and R⁴⁶, or R⁴⁶ and R⁴⁷, may combine with each other to form a ring structure.

L⁴¹ has the same meaning as the ligand L²¹ in the formula (II) has, and preferred ranges of these ligands are also the same.

n⁴¹ and n⁴² have the same meanings as n²¹ and n²² in the formula (II) have respectively, and preferred ranges thereof and those of n²¹ and n²² are also the same respectively.

The iridium complex phosphorescent materials represented by the formula (IV), which each contain a ligand bound to the iridium atom via the nitrogen atom of its pyrazole skeleton, are more preferably iridium complex phosphorescent materials represented by the following formula (V).

The formula (V) is illustrated.

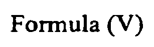

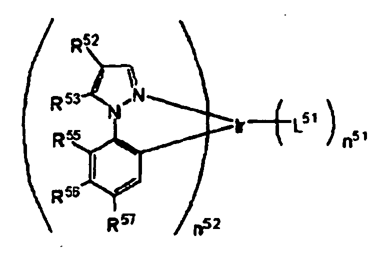

In the formula (V), each of R⁵² and R⁵³ independently represents a hydrogen atom, an alkyl group or an aryl group, and each of R⁵⁵ to R⁵⁷ independently represents a hydrogen atom, a fluorine atom, an alkyl group or a cyano group. Alternatively, R⁵⁵ and R⁵⁶ or R⁵⁶ and R⁵⁷, may be groups forming a fused ring structure by combining with each other. L⁵¹ represents a ligand, n⁵² represents an integer of 1 to 3, and n⁵¹ represents an integer of 0 to 4.

Each of R⁵² and R⁵³ is preferably a hydrogen atom, an alkyl group or an aryl group, more preferably a hydrogen atom, a methyl group, a tert-butyl group or a phenyl group, especially preferably a hydrogen atom.

R⁵⁵, R⁵⁶ and R⁵⁷ have the same meanings as R³⁵, R³⁶ and R³⁷ in the formula (III) have respectively, and preferred ranges thereof and those of R³⁵, R³⁶ and R³⁷ are the same respectively.

L⁵¹ has the same meaning as L²¹ in the formula (II) has, and preferred ranges of these ligands are the same.

n⁵¹ and n⁵² have the same meanings as n²¹ and n²² in the formula (II) have respectively, and preferred ranges thereof and those of n²¹ and n²² are the same respectively.

The iridium complex phosphorescent materials which each contain a ligand bound to the iridium atom via the nitrogen atom of its pyridine skeleton are preferably iridium complexes represented by the following formula (VI).

The formula (VI) is illustrated.

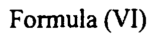

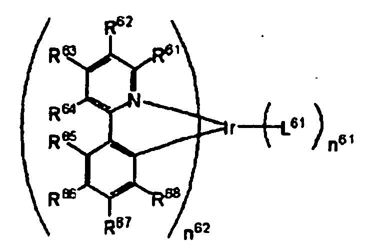

In the formula (VI), each of R⁶¹ to R⁶⁸ independently represents a hydrogen atom or a substituent, L⁶¹ represents a ligand, n⁶² represents an integer of 1 to 3, and n⁶¹ represents an integer of 0 to 4.

R⁶¹ to R⁶³ and R⁶⁵ to R⁶⁸ have the same meanings as R²¹ to R²³ and R²⁵ to R²⁸ in the formula (II) have respectively, and R⁶⁴ has the same meaning as R²³ in the formula (II) has.

The substituent as R⁶¹ to R⁶⁴ each is preferably a fluorine atom, an alkyl group, an alkoxy group, an aryloxy group, a heteroaryloxy group or a substituted amino group, more preferably a fluorine atom, an alkyl group, an alkoxy group, an aryloxy group or a substituted amino group, still more preferably a fluorine atom, a methyl group, a tert-butyl group, a methoxy group, a phenoxy group, a dimethylamino group or a diphenylamino group, especially preferably a fluorine atom.

R⁶¹ and R⁶², or R⁶² and R⁶³, or R⁶³ and R⁶⁴, may combine with each other to form a ring structure.

The substituent as R⁶⁵ to R⁶⁸ each is preferably an alkyl group, an aryl group, a heteroaryl group, a halo group or a cyano group, more preferably an alkyl group, an aryl group, a halo group or a cyano group, especially preferably a methyl group, a tert-butyl group, a phenyl group, a fluorine atom or a cyano group.

R⁶⁵ and R⁶⁶, or R⁶⁶ and R⁶⁷, or R⁶⁷ and R⁶⁸, may combine with each other to form a ring structure.

L⁶¹ has the same meaning as L²¹ in the formula (II) has, and preferred ranges of these ligands are also the same.

n⁶¹ and n⁶² have the same meanings as n²¹ and n²² in the formula (II) have respectively, and preferred ranges thereof and those of n²¹ and n²² are the same respectively.

The iridium complex phosphorescent materials represented by the formula (VI), which each contain a ligand bound to the iridium atom via the nitrogen atom of its pyridine skeleton, are more preferably iridium complex phosphorescent materials represented by the following formula (VII).

The formula (VII) is illustrated.

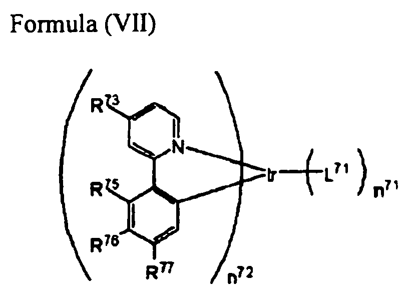

In the formula (VII), R⁷³ represents a hydrogen atom, an alkyl group, an amino group or an alkoxy group, each of R⁷⁵ to R⁷⁷ independently represents a hydrogen atom, a fluorine atom, a cyano group or an alkyl group, L⁷¹ represents a ligand, n⁷² represents an integer of 1 to 3, and n⁷¹ represents an integer of 0 to 4.

R⁷³ is preferably a fluorine atom, an alkyl group, an amino group or an alkoxy group, more preferably a fluorine atom, a methyl group, a tert-butyl group, a dimethylamino group, a diphenylamino group, a methoxy group, a tert-butoxy group or a phenoxy group, still more preferably a fluorine atom or a methoxy group, especially preferably a fluorine atom.

R⁷⁵ is preferably a hydrogen atom, a fluorine atom, an alkyl group or a cyano group, more preferably a hydrogen atom, a fluorine atom or a cyano group, especially preferably a fluorine atom.

R⁷⁶ is preferably a hydrogen atom, a fluorine atom, an alkyl group or a cyano group, more preferably a hydrogen atom, a fluorine atom or a cyano group, especially preferably a cyano group.

R⁷⁷ is preferably a hydrogen atom, a fluorine atom, an alkyl group or a cyano group, more preferably a fluorine atom or a cyano group, especially preferably a fluorine atom.

The alkyl group of R⁷⁵, R⁷⁶ and R⁷⁷ each is preferably a methyl group, an ethyl group, a tert-butyl group, a cyclohexyl group, a trifluoromethyl group or a perfluorobutyl group, more preferably a methyl group, a tert-butyl group, a trifluoromethyl group or a perfluorobutyl group, especially preferably a trifluoromethyl group.

L⁷¹ has the same meaning as L²¹ in the formula (II) has, and preferred ranges of these ligands are also the same.

n⁷¹ and n⁷² have the same meanings as n²¹ and n²² in the formula (II) have respectively, and preferred ranges thereof and those of n²¹ and n²² are also the same respectively.

The term "maximum emission wavelength of an iridium complex phosphorescent material" refers to the wavelength at which the emission intensity is maximum of all maximal values in the emission spectrum of an iridium complex phosphorescent material. The maximum emission wavelength is preferably from 450 nm to 470 nm, more preferably from 450 nm to 465 nm, especially preferably from 450 nm to 460 nm.

Examples of the iridium complex phosphorescent materials include the compounds disclosed in International Patent Publication Nos. 00/70655, 01/41512 and 02/5645, JP-A-2002-117978, International Patent Publication Nos. 04/085450, 06/121811, 05/019373, 05/113704 and 04/016711, and Coordination Chemistry Reviews, 250, 2093-2126 (2006).

Examples of the iridium complex phosphorescent materials are illustrated below, but these examples should not be construed as limiting the scope of the invention.

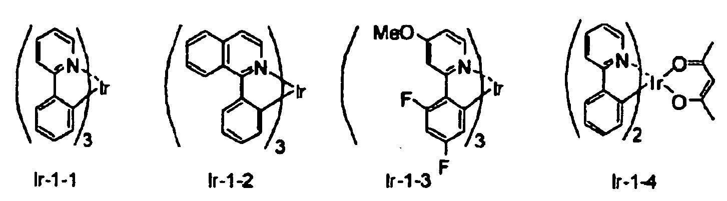

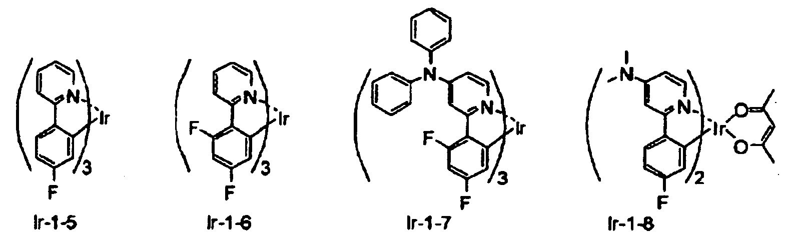

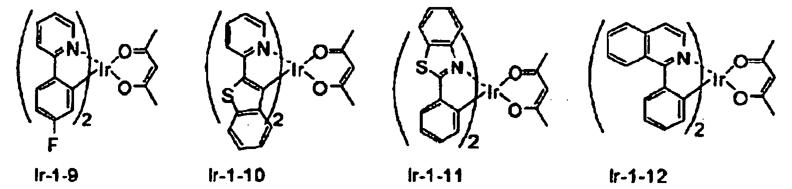

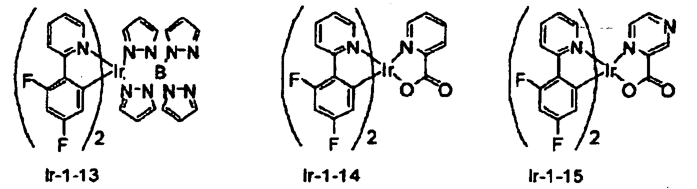

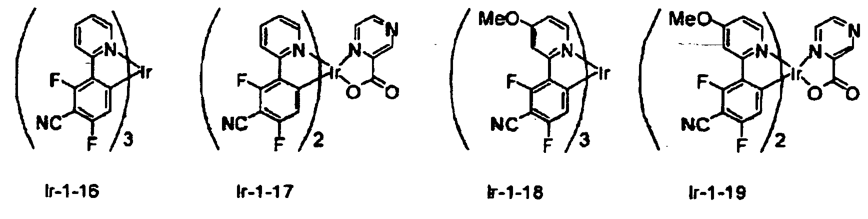

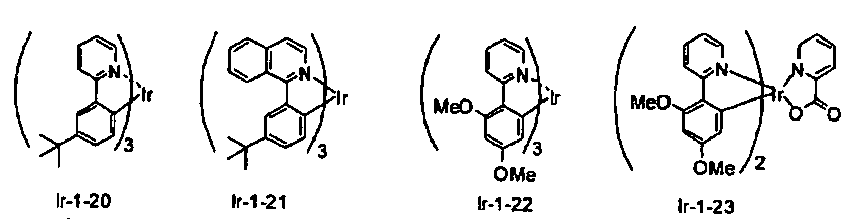

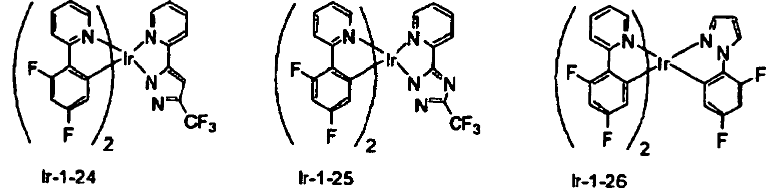

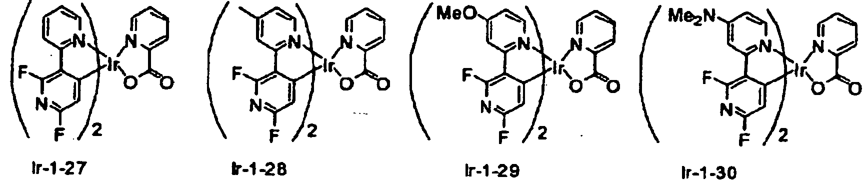

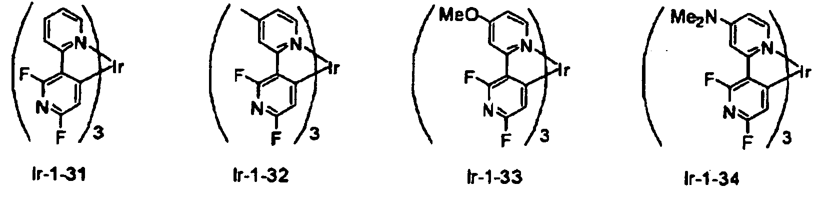

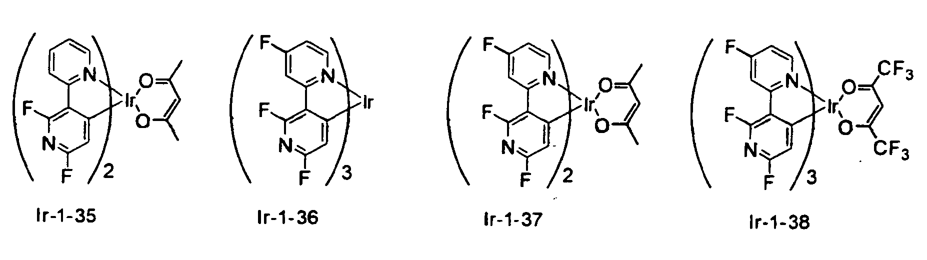

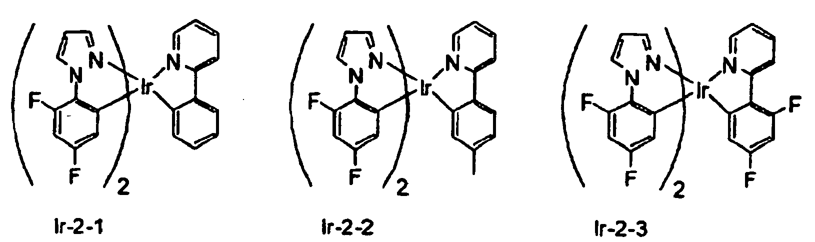

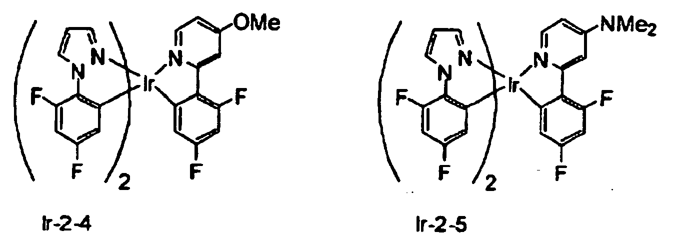

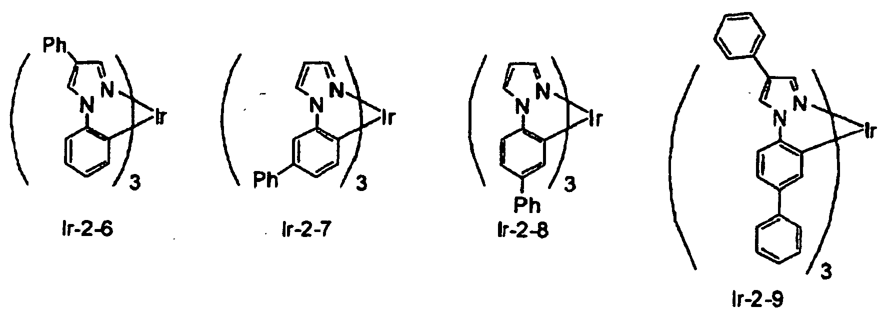

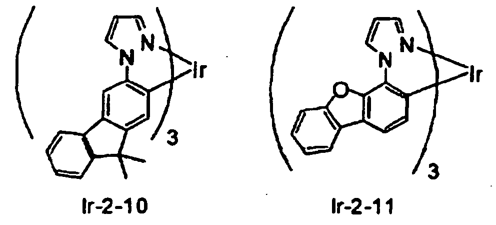

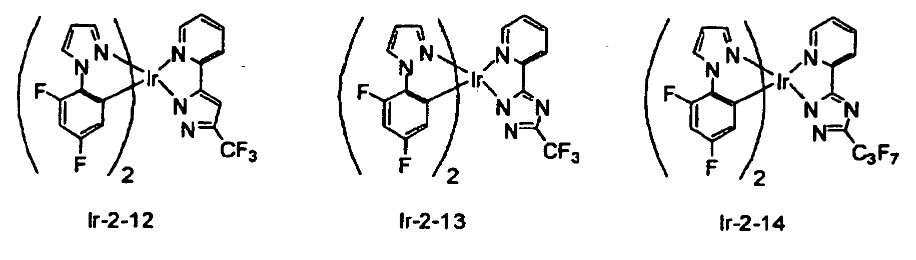

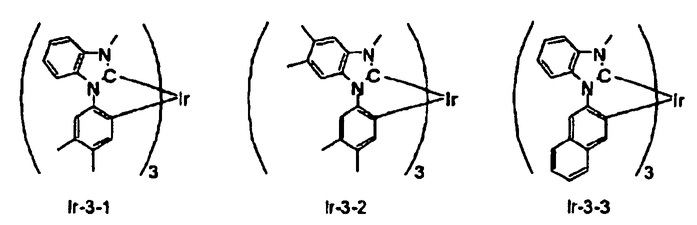

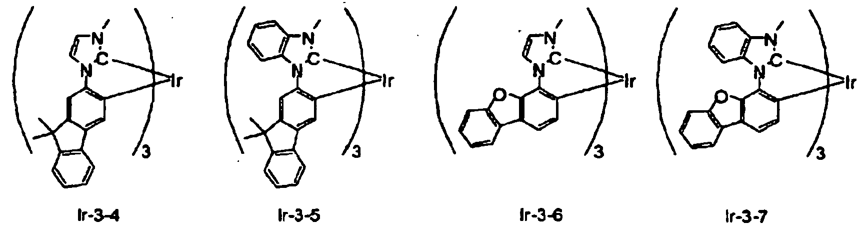

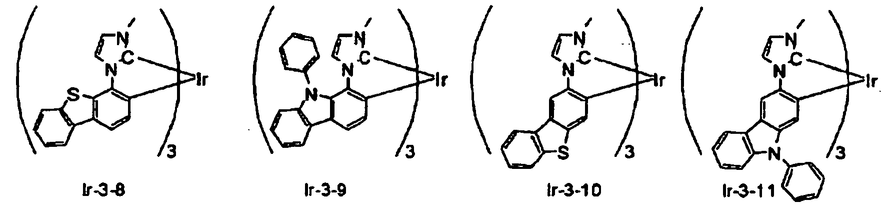

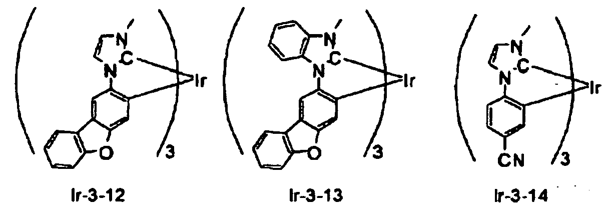

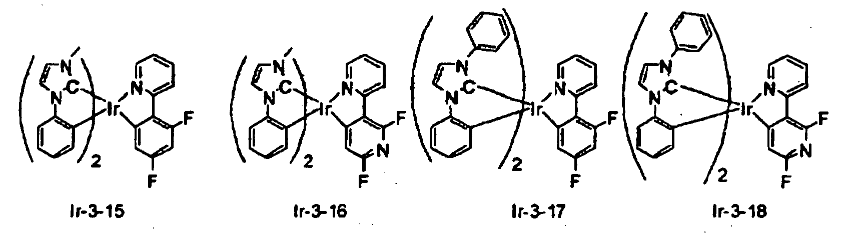

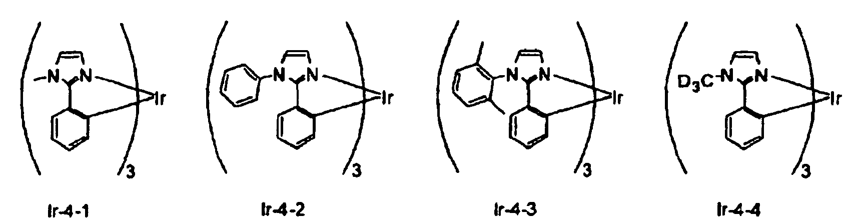

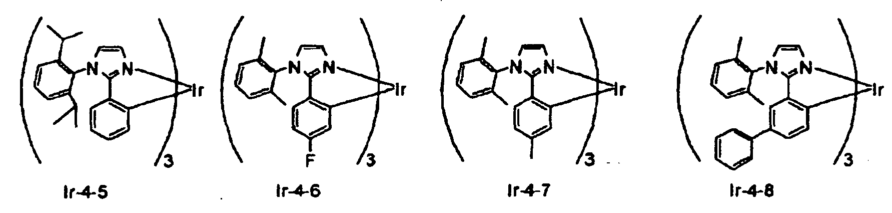

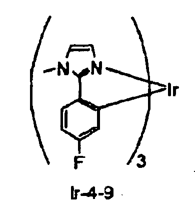

The compounds exemplified above as the complex compounds can be produced, e.g., in the processes described below.

The metal complex compounds can be synthesized using various techniques, including the methods described in Journal of Organic Chemistry, 53, 786 (1988), and more specifically, G.R. Newkome et al., page 789, left column, line 53, to right column, line 7, page 790, left column, lines 18 to 38, and page 790, right column, lines 19 to 30, combinations of these methods, and the methods described in Chemische Berichte, 113, 2749 (1980), and more specifically, H, Lexy et al., page 2752, lines 26 to 35.

For example, those compounds can be synthesized from metal compounds and ligands or dissociated ligands in the presence or absence of a solvent (e.g., a halogen-containing solvent, an alcohol solvent, an ether solvent, an ester solvent, a ketone solvent, a nitrile solvent, an amide solvent, a sulfone solvent, a sulfoxide solvent, water), in the presence or absence of a base (including inorganic and organic bases, such as sodium methoxide, potassium t-butoxide, triethylamine and potassium carbonate) under room temperature or application of heat (in the usual way or by means of a microwave device).

The iridium complexes, though favorably used as light-emitting materials, may be used as materials other than light-emitting ones.

Each of the iridium complexes is generally incorporated into a light-emitting layer in an amount of 0.1 to 50 mass% based on all the compounds forming the light-emitting layer. From the viewpoints of durability and external quantum efficiency, the iridium complex content in the light-emitting layer is preferably from 1 to 50 mass%, more preferably from 2 to 40 mass%.

The luminescent dopant is usually contained in the light emitting layer in an amount of from 0.1 to 50 mass% based on the mass of all the compounds constituting the light emitting layer. From the standpoints of durability and external quantum efficiency, it is contained in an amount of preferably from 1 to 50 mass%, more preferably from 2 to 40 mass%.

Although the thickness of the light emitting layer is not particularly limited, a thickness of from 2 nm to 500 nm is usually preferred. From the standpoint of external quantum efficiency, the thickness is more preferably from 3 nm to 200 nm, still more preferably from 5 nm to 100 nm.

### <Host material>

As the host material to be used in the invention, hole transporting host materials having an excellent hole transporting property (which may be called "hole transporting hosts") and electron transporting host compounds having an excellent electron transporting property (which may be called "electron transporting hosts") can be used. The compounds of the invention represented by the formula (I) are preferably used as the hole transporting hosts.

### <Hole transporting host>

As the hole transporting hosts to be used in the invention, the following materials can be given as specific examples.

Specific examples include pyrrole, indole, carbazole, azaindole, azacarbazole, triazole, oxazole, oxadiazole, pyrazole, imidazole, thiophene, polyarylalkanes, pyrazoline, pyrazolone, phenylenediamine, arylamines, amino-substituted chalcones, styrylanthracene, fluorenone, hydrazone, stilbene, silazane, aromatic tertiary amine compounds, styrylamine compounds, aromatic dimethylidine compounds, porphyrin compounds, polysilane compounds, poly(N-vinylcarbazole), aniline copolymers, electroconductive high-molecular oligomers such as thiophene oligomers and polythiophene, organic silanes, and carbon films, and derivatives thereof.

Of these, indole derivatives, carbazole derivatives, aromatic tertiary amine compounds, and thiophene derivatives are preferred, with those having, in the molecule thereof, a carbazole group being more preferred. Compounds having a t-butyl-substituted carbazole group are especially preferred.

### <Electron transporting host>

The electron transporting host in the light emitting layer to be used in the invention has an electron affinity Ea of preferably 2.5 eV or greater and not greater than 3.5 eV, more preferably 2.6 eV or greater and not greater than 3.4 eV, still more preferably 2.8 eV or greater and not greater than 3.3 eV in order to improve durability and avoid reduction in driving voltage. Furthermore, it has an ionization potential Ip of preferably 5.7 eV or greater and not greater than 7.5 eV, more preferably 5.8 eV or greater and not greater than 7.0 eV, still more preferably 5.9 eV or greater and not greater than to 6.5 eV in order to improve durability and avoid reduction in driving voltage.

As such electron transporting hosts, the following materials can be given as specific examples.

Specific examples include pyridine, pyrimidine, triazine, imidazole, pyrazole, triazole, oxazole, oxadiazole, fluorenone, anthraquinonedimethane, anthrone, diphenylquinone, thiopyrandioxide, carbodiimide, fluorenylidenemethane, distyrylpyradine, fluorine-substituted aromatic compounds, heterocyclic tetracarboxylic anhydrides such as naphthalene perylene, and phthalocyanine, derivatives thereof (which may form a fused ring with another ring), and various metal complexes typified by metal complexes of 8-quinolynol derivatives, metallophthalocyanines, and metal complexes having benzoxazole or benzothiazole as the ligand.

The electron transporting hosts are preferably metal complexes, azole derivatives (such as benzimidazole derivatives and imidazopyridine derivatives), and azine derivatives (such as pyridine derivatives, pyrimidine derivatives, and triazine derivatives). Of these, metal complex compounds are preferred in view of durability. The metal complex compounds (A) are more preferably metal complexes having a ligand having at least one nitrogen atom, oxygen atom, or sulfur atom to be coordinated with the metal.

Although a metal ion in the metal complex is not particularly limited, preferred examples include a beryllium ion, a magnesium ion, an aluminum ion, a gallium ion, a zinc ion, an indium ion, a tin ion, a platinum ion, and a palladium ion. Of these, a beryllium ion, an aluminum ion, a gallium ion, a zinc ion, a platinum ion, and a palladium ion being are more preferred, with an aluminum ion, a zinc ion, and a palladium ion being still more preferred.

Although there are various known ligands to be contained in the above-described metal complexes, examples include ligands described in Photochemistry and Photophysics of Coordination Compounds written by H. Yersin, published by Springer-Verlag in 1987; and Organometallic Chemistry - Principles and Applications, written by Akio Yamamoto, published by Shokabo Publishing in 1982.

The ligands are preferably nitrogen-containing heterocyclic ligands (preferably, C₁₋₃₀, more preferably C₂₋₂₀, especially preferably C₃₋₁₅ ligands which may be either monodentate ligands or multidentate ligands, with ligands from bidentate ones to hexadentate ones being preferred. Mixtures of a monodentate ligand with a multidentate ligand from a bidentate to hexadentate ligand are also preferred).

Examples of the ligands include azine ligands (such as pyridine ligands, bipyridyl ligands, and terpyridine ligands); hydroxyphenylazole ligands (such as hydroxyphenylbenzimidazole ligands, hydroxyphenylbenzoxazole ligands, hydroxyphenylimidazole ligands, and hydroxyphenylimidazopyridine ligands); alkoxy ligands (preferably, C₁₋₃₀, more preferably C₁₋₂₀, especially preferably C₁₋₁₀ ligands such as methoxy, ethoxy, butoxy, and 2-ethylhexyloxy); aryloxy ligands (preferably, C₆₋₃₀, more preferably C₆₋₂₀, especially preferably C₆₋₁₂ ligands such as phenyloxy, 1-naphthyloxy, 2-naphthyloxy, 2,4,6-trimethylphenyloxy, and 4-biphenyloxy); heteroaryloxy ligands (preferably, C₁₋₃₀, more preferably C₁₋₂₀, especially preferably C₁₋₁₂ ligands such as pyridyloxy, pyrazyloxy, pyrimidyloxy, and quinolyloxy); alkylthio ligands (preferably, C₁₋₃₀, more preferably C₁₋₂₀, especially preferably C₁₋₁₂ ligands such as methylthio and ethylthio); arylthio ligands (preferably, C₆₋₃₀, more preferably C₆₋₂₀, especially preferably C₆₋₁₂ ligands such as phenylthio); heteroarylthio ligands (preferably C₁₋₃₀, more preferably C₁₋₂₀, especially preferably C₁₋₁₂ ligands such as pyridylthio, 2-benzimidazolylthio, 2-benzoxazolylthio, and 2-benzothiazolylthio); siloxy ligands (preferably C₁₋₃₀, more preferably C₃₋₂₅, especially preferably C₆₋₂₀ ligands such as triphenylsiloxy group, a triethoxysiloxy group, and a triisopropylsiloxy group); aromatic hydrocarbon anion ligands (preferably C₆₋₃₀, more preferably C₆₋₂₅, especially preferably C₆₋₂₀ ligands such as a phenyl anion, a naphthyl anion, and an anthranyl anion); aromatic heterocyclic anion ligands (preferably, C₁₋₃₀, more preferably C₂₋₂₅, especially preferably C₂₋₂₀ ligands such as a pyrrole anion, a pyrazole anion, a triazole anion, an oxazole anion, a benzoxazole anion, a thiazole anion, a benzothiazole anion, a thiophene anion, and a benzothiophene anion); and indolenine anion ligands. Of these, nitrogen-containing heterocyclic ligands, aryloxy ligands, heteroaryloxy groups, and siloxy ligands are preferred, with nitrogen-containing heterocyclic ligands, aryloxy ligands, siloxy ligands, aromatic hydrocarbon anion ligands, and aromatic heterocyclic anion ligands being more preferred.

Examples of the metal complex electron transporting hosts include compounds described in JP-A-2002-235076, JP-A-2004-214179, JP-A-2004-221062, JP-A-2004-221065, JP-A-2004-221068, and JP-A-2004-327313.

In the light emitting layer of the invention, it is preferred that the host material (including the compound represented by the formula (I)) has a lowest triplet excited state (T1) higher than the T1 of the phosphorescent material from the viewpoint of color purity, luminous efficiency, and running durability.

Although a content of the host compounds is not particularly limited in the invention, it is preferably 15 mass% or greater and not greater than 99.9% mass% relative to the mass of all the compounds constituting the light emitting layer in view of luminous efficiency and driving voltage. When the compound represented by the formula (I) is used as the host material, a host compound other than the compound of the invention is used in an amount of 50 mass% or less, preferbly 25 mass% or less, especially preferably 15 mass% or less relative to the compound of the invention.

### (Hole Injection layer, hole transport layer)

A hole injection layer and a hole transport layer each has a function of receiving holes from the anode or anode side and transporting them to the cathode side. Hole injection materials and hole transporting materials to be used for these layers may be either low molecular compounds or high molecular compounds.

Specifically, they are preferably layers containing a pyrrole derivative, a carbazole derivative, a triazole derivative, an oxazole derivative, an oxadiazole derivative, an imidazole derivative, a polyarylalkane derivative, a pyrazoline derivative, a pyrazolon derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidine compound, a phthalocyanine compound, a porphyrine compound, a thiophene derivative, an organic silane derivative, or a carbon.

The hole injection layer or the hole transport layer of the organic EL device of the invention may contain an electron accepting dopant. As the electron accepting dopant to be introduced into the hole injection layer or the hole transport layer, any of inorganic compounds and organic compounds can be used insofar as it can accept electrons and oxidize an organic compound.

Specific examples of the inorganic compound include metal halides such as ferric chloride, aluminum chloride, gallium chloride, indium chloride, and antimony pentachloride, and metal oxides such as vanadium pentaoxide and molybdenum trioxide.

As the organic compound, compounds having, as a substituent, a nitro group, a halogen atom, a cyano group, or a trifluoromethyl group; quinone compounds, acid anhydride compounds, and fullerenes are preferred.

In addition, those described in JP-A-6-212153, JP-A-11-111463, JP-A-11-251067, JP-A-2000-196140, JP-A-2000-286054, JP-A-2000-315580, JP-A-2001-102175, JP-A-2001-160493, JP-A-2002-252085, JP-A-2002-56985, JP-A-2003-157981, JP-A-2003-217862, JP-A-2003-229278, JP-A-2004-342614, JP-A-2005-72012, JP-A-2005-166637, and JP-A-2005-209643 are preferred..

Of these, particularly preferred are hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, 1,2,4,5-tetracyanobenzene, 1,4-dicyanotetrafluorobenzene, 2,3-dichloro-5,6-dicyanobenzoquinone, p-dinitrobenzene, m-dinitrobenzene, o-dinitrobenzene, 1,4-naphthoquinone, 2,3-dichloronaphthoquinone, 1,3-dinitronaphthalene, 1,5-dinitronaphthalene, 9,10-anthraquinone, 1,3,6,8-tetranitrocarbazole, 2,4,7-trinitro-9-fluorenone, 2,3,5,6-tetracyanopyridine, and fullerene C60. Of these, hexacyanobutadiene, hexacyanobenzene, tetracyanoethylene, tetracyanoquinodimethane, tetrafluorotetracyanoquinodimethane, p-fluoranil, p-chloranil, p-bromanil, 2,6-dichlorobenzoquinone, 2,5-dichlorobenzoquinone, 2,3-dichloronaphthoquinone, 1,2,4,5-tetracyanobenzene, 2,3-dichloro-5,6-dicyanobenzoquinone and 2,3,5,6-tetracyanopyridine are more preferred, with tetrafluorotetracyanoquinodimethane being especially preferred.

These electron-accepting dopants may be used either singly or in combination. The amount of the electron-accepting dopants differs, depends on the kind of the materials, but the amount is preferably from 0.01 to 50 mass%, more preferably from 0.05 to 20 mass%, especially preferably from 0.1 to 10 mass%, each relative to the materials of the hole transport layer.

The thickness of each of the hole injection layer and the hole transport layer is preferably 500 nm or less in order to reduce the driving voltage.

The thickness of the hole transport layer is preferably from 1 to 500 nm, more preferably from 5 nm to 200 nm, still more preferably from 10 nm to 100 nm. The thickness of the hole injection layer is preferably from 0.1 nm to 200 nm, more preferably from 0.5 to 100 nm, still more preferably from 1 to 100 nm.

The transport injection layer and the hole transport layer may each be a single layer composed of one or more of the above-described materials or a multilayer composed of a plurality of layers having the same composition or different compositions.

### (Electron injection layer, electron transport layer)

The electron injection layer and the electron transport layer are layers having a function of receiving electrons from the cathode or the cathode side and transporting them to the anode side. The electron injection materials and electron transport materials to be used for these layers may be either a low molecular compound or a high molecular compound.

Specifically, they are preferably layers containing a pyridine derivative, a quinoline derivative, a pyrimidine derivative, a pyrazine derivative, a phthalazine derivative, a phenanthroline derivative, a triazine derivative, a triazole derivative, an oxazole derivative, an oxadiazole derivative, an imidazole derivative, a fluorenone derivative, an anthraquinodimethane derivative, an anthrone derivative, a diphenylquinone deriative, a thiopyran dioxide derivative, a carbodiimide derivative, a fluorenylidenemethane derivative, a distyrylpyrazine derivative, an aromatic cyclic tetracarboxylic anhydride such as naphthalene and perylene, various complexes typified by a metal complex of a 8-quinolinol derivative , metalphthalocyanines, and metal complexes having benzoxazole or benzothiazole as a ligand, and organic silane derivatives typified by silole.

The electron injection layer or the electron transport layer of the organic EL device of the invention can contain an electron donating dopant. The electron donating dopant to be introduced into the electron injection layer or the electron transport layer may be any material insofar as it has an electron donating property and therefore capable of reducing an organic compound. Alkali metals such as Li, alkaline earth metals such as Mg, transition metals containing a rare earth metal, and reductive organic compounds are preferred. As the metal, those having a work function not greater than 4.2 eV are especially preferred. Specific examples of it include Li, Na, K, Be, Mg, Ca, Sr, Ba, Y, Cs, La, Sm, Gd, and Yb. The reductive organic compounds are, for example, nitrogen-containing compounds, sulfur-containing compounds, and phosphorus-containing compounds.

In addition, materials described in Japanese Patent Application Laid-Open Nos. 212153/1994, 196140/2000, 68468/2003, 229278/2003, and 342614/2004 can be used.

These electron donating dopant may be used either singly or in combination. The amount of the electron donating dopant varies, depending on the kind of the material, but it is preferably from 0.1 to 99 mass%, more preferably from 1.0 to 80 mass%, especially preferably from 2.0 to 70 mass% relative to the material of the electron transport layer.

The thickness of each of the electron injection layer and the electron transport layer is preferably 500 nm or less in order to reduce the driving voltage.

The thickness of the electron transport layer is preferably from 1 to 500 nm, more preferably from 5 nm to 200 nm, still more preferably from 10 nm to 100 nm. The thickness of the electron injection layer is preferably from 0.1 to 200 nm, more preferably from 0.2 to 100 nm, still more preferably from 0.5 to 50 nm.

Each of the electron injection layer and the electron transport layer may be a single layer composed of one or more of the above-described materials or a multilayer composed of a plurality of layers having the same composition or having different compositions.

### (Hole blocking layer)

The hole blocking layer is a layer having a function of preventing passage of holes, which have been transported to the light emitting layer from the anode side, to the cathode side. In the invention, the hole blocking layer can be formed as an organic layer adjacent to the light emitting layer on the cathode side.

Examples of compounds constituting the hole blocking layer include aluminum complexes such as BAlq, triazole derivatives, and phenanthroline derivatives such as BCP. The thickness of the hole blocking layer is preferably from 1 to 500 nm, more preferably from 5 to 200 nm, still more preferably from 10 to 100 nm.

The hole blocking layer may be a single layer composed of one or more of the above-described materials or a multilayer composed of a plurality of layers having the same composition or different compositions.

### (Electron blocking layer)

The electron blocking layer is a layer having a function of preventing passage of electrons, which have been transported to the light emitting layer from the cathode side, to the anode side. In the invention, the electron blocking layer can be formed as an organic layer adjacent to the light emitting layer on the anode side.

Examples of the compound constituting the electron blocking layer are similar to those given above as the hole transporting material.

The thickness of the electron blocking layer is preferably from 1 to 500 nm, more preferably from 5 to 200 nm, still more preferably from 10 to 100 nm.

The hole blocking layer may be a single layer composed of one or more of the above-described materials, or a multilayer composed of a plurality of layers having the same composition or different compositions.

### (Protective layer)

In the invention, the whole organic EL device may be protected by a protective layer.

Any material may be incorporated in the protective layer insofar as it has a function of preventing intrusion of substances, which promote deterioration of the device such as water or oxygen, into the device.

Specific examples of the material include metals such as In, Sn, Pb, Au, Cu, Ag, Al, Ti and Ni; metal oxides such as MgO, SiO, SiO₂, Al₂O₃, GeO, NiO, CaO, BaO, Fe₂O₃ Y₂O₃, and TiO₂; metal nitrides such as SiNₓ and SiNₓO_{y}; metal fluorides such as MgF₂, LiF, AlF₃ and CaF₂; polyethylene, polypropylene, poly(methyl methacrylate), polyimide, polyurea, polytetrafluoroethylene, polychlorotrifluoroethylene, polydichlorodifluoroethylene, chlorotrifluoroethylene/dichlorodifluoroethylene copolymer, copolymers obtainable by copolymerizing a monomer mixture containing tetrafluoroethylene and at least one comonomer, fluorine-containing copolymers having, on the copolymer backbone thereof, a ring structure, water absorptive materials having a water absorption of 1% or greater, and moisture-proof materials having a water absorption of 0.1 % or less.

A process for forming the protective layer is not particularly limited. Examples of the process applicable to the formation include a vacuum deposition process, a sputtering process, a reactive sputtering process, a MBE (molecular beam epitaxy) process, a cluster ion beam process, an ion plating process, a plasma polymerization process (high-frequency excited ion plating process), a plasma CVD process, a laser CVD process, a thermal CVD process, a gas source CVD process, a coating process, a printing process, and a transfer process.

### (Sealing)

Furthermore, the entire organic electroluminescence device of the invention may be sealed using a sealing container.

Also, a space between the sealing container and the device may be filled with a moisture absorbent or an inert liquid. The moisture absorbent is not particularly limited. Examples of it include barium oxide, sodium oxide, potassium oxide, calcium oxide, sodium sulfate, calcium sulfate, magnesium sulfate, phosphorus pentaoxide, calcium chloride, magnesium chloride, copper chloride, cesium fluoride, niobium fluoride, calcium bromide, vanadium bromide, a molecular sieve, zeolite, and magnesium oxide. The inert liquid is not particularly limited and examples of it include paraffins, liquid paraffins, fluorine-based solvents such as perfluoroalkanes, perfluoroamines and perfluoroethers, chlorine-based solvents, and silicone oils.

Alternatively, the organic EL device of the invention may be preferably sealed with the following resin sealing layer.

### (Resin sealing layer)

It is preferred to use a resin sealing layer to suppress deterioration of the performance of the functional device of the invention which will otherwise occur by the contact with oxygen or moisture in the atmosphere.

### (Material)

The resin material for the resin sealing layer is not particularly limited and acrylic resins, epoxy resins, fluorine-based resins, silicon-based resins, rubber-based resins, and ester resins can be used. Of these, epoxy resins are preferred because of their moisture preventive function. Of the epoxy resins, thermosetting epoxy resins and photocurable epoxy resins are preferred.

### (Preparation process)

No particular limitation is imposed on the preparation process of the resin sealing layer. Examples include a process of applying a resin solution, a process of press bonding or hot press bonding a resin sheet, and a process of dry polymerization by vapor deposition or sputtering.

### (Film Thickness)

The thickness of the resin sealing layer is 1 µm or greater and not greater than 1 mm, more preferably 5 µm or greater and not greater than 100 µm, most preferably 10 µm or greater and not greater than 50 µm. When the resin sealing layer has a thickness below the above-described range, the inorganic film may be damaged at the time of mounting the second substrate. The resin sealing layer having a thickness exceeding the above-described range, on the other hand, increases the thickness of the electroluminescence device itself and impairs the characteristic of the organic electroluminescence device, that is, a thin film property.

### (Sealing Adhesive)

The sealing adhesive used in the invention has a function of preventing intrusion of moisture or oxygen from the edge.

### <Material>

For the sealing adhesive, materials similar to those used for the resin sealing layer can be used. Of these, the epoxy adhesives are preferred from the viewpoint of preventing penetration of water, with light curing adhesives and thermosetting adhesives are especially preferred.

Further, addition of a filler to the above-described materials is also preferred.

The filler added to the sealant is preferably an inorganic material such as SiO₂, SiO (silicon oxide), SiON (silicon oxynitride), or SiN (silicon nitride). The addition of the filler increases the viscosity of the sealant to improve the processing suitability and improve the humidity resistance.

### <Drying Agent>

The sealing adhesive may contain a drying agent. The drying agent is preferably barium oxide, calcium oxide, or strontium oxide.

The amount of the drying agent is preferably 0.01 mass% or greater and not greater than 20 mass%, more preferably 0.05 mass% or greater and not greater than 15 mass% relative to the sealing adhesive. When the amount is below the range, the drying agent cannot bring about sufficient effect. Amounts exceeding the range, on the other hand, make it difficult to uniformly disperse the drying agent in the sealing adhesive. Amounts outside the above range are therefore not preferred.

### <Formulation of Sealing Adhesive>

### Polymer Composition, Concentration

The sealing adhesive is not particularly limited and those described above can be used. Examples of the light curing epoxy adhesive include "XNR5516", product of Nagase Chemtech. The sealing adhesive may be prepared by adding the drying agent directly to the adhesive and then, dispersing the resulting mixture.

### Thickness

The sealing adhesive is preferably applied to give a thickness of 1 µm or greater and not greater than 1 mm. When the thickness is below the range, the sealing adhesive cannot be applied uniformly. When the thickness exceeds the range, on the other hand, water intrusion paths become wide. Thicknesses outside the above-described range are therefore not preferred.

### <Sealing Method>

In the invention, the functional device can be obtained by applying an optional amount of the sealing adhesive containing the drying agent by using a disperser, stacking the second substrate over the film, and then curing the stack.

### (Driving)

By applying a direct current (which may contain an alternating current component if necessary) voltage (usually from 2 to 15V) or a direct current between the anode and the cathode of the organic electroluminescence device of the invention, light emission can be obtained.

Examples of a method for driving the organic electroluminescence device of the invention include those described in Japanese Patent Laid-Open Nos. 148687/1990, 301355/1994, 29080/1993, 134558/1995, 234685/1996, and 241047/1996, Japanese Patent No. 2784615, and U.S. Pat. Nos. 5,828,429 and 6,023,308.

The light extraction efficiency of the luminescence device of the invention can be raised by various known methods. For example, it is possible to improve a light extraction efficiency and improve an external quantum efficiency by processing a surface shape of the substrate (for example, forming a pattern with minute irregularities), controlling the refractive index of the substrate, the ITO layer and/or the organic layer, or controlling the film thickness of the substrate, the ITO layer and/or the organic layer.

The luminescence device of the invention may be a so-called top emission type device in which light is emitted from the anode side.

The organic EL element of the invention can have a charge generation layer between two or more light emitting layers in order to improve luminous efficiency.

The charge generation layer has a function of generating charges (holes and electrons) when a voltage is applied and at the same time has a function of injecting the charges thus generated into a layer adjacent to the charge generation layer.

The material for forming the charge generation layer may be any material insofar as it has the-above mentioned functions. The charge generation layer may be made of a single compound or a plurality of compounds.

Specifically, the material may be either conductive or semi-conductive such as a doped organic layer. It may also be an insulating material. Examples include materials described in Japanese Patent Application Laid-Open Nos. 329748/1999, 2003-272860 and 2004-39617.

More specifically, examples may include transparent conductive materials such as ITO and IZO (indium zinc oxide), fullerenes such as C60, conductive organic materials such as oligothiophenes, conductive organic materials such as metallophthalocyanines, metal-free phthalocyanines, metalloporphyrins and metal-free porphyrins, metal materials such as Ca, Ag, Al, Mg:Ag alloys, Al:Li alloys and Mg:Li alloys, hole conductive materials, and electron conductive materials, and mixtures thereof.

Examples of the hole conductive materials include materials obtained by doping a hole transporting organic material such as 2-TNATA or NPD with an electron attractive oxidizing agent such as F4-TCNQ, TCNQ or FeCl₃, P-type conductive polymers and P-type semiconductors. Examples of the electron conductive materials include materials obtained by doping an electron transporting organic material with a metal or metal compound having a work function less than 4.0 eV, N-type conductive polymers and N-type semiconductors. Examples of the N-type semiconductors include N-type Si, N-type CdS and N-type ZnS. Examples of the P-type semiconductors include P-type Si, P-type CdTe and P-type CuO.

Further, insulating materials such as V₂O₅ can be used for the charge generation layer.

The charge generation layer may be a single layer or a stack of a plurality of layers. Examples of the latter one include a layer having a structure in which a transparent conductive material, a conductive material such as a metal material, and the hole conductive material or the electron conductive material are stacked one after another and a layer having a structure in which the hole conductive material and the electron conductive material are stacked one after another.

It is usually preferred to select the film thickness or the material of the charge generation layer to give light transmittance of 50% or greater. The thickness is not particularly limited, but preferably from 0.5 to 200 nm, more preferably from 1 to 100 nm, still more preferably from 3 to 50 nm, especially preferably from 5 to 30 nm.

The formation process of the charge generation layer is not particularly limited, and the above-described formation process of the organic layer can be employed.

The charge generation layer is inserted between the two or more light-emitting layers. The charge generation layer may contain, on the anode side and the cathode side thereof, a material having a function of injecting charges into an adjacent layer. In order to improve the electron injection property to the adjacent layer on the anode side, an electron injecting compound such as BaO, SrO, Li₂O, LiCl, LiF, MgF₂, MgO or CaF₂ may be stacked on the anode side of the charge generation layer.

Alternatively, the material of the charge generation layer can be selected based on the descriptions of Japanese Patent Application Laid-Open No. 2003-45676 and U.S. Pat. Nos. 6,337,492, 6,107,734, and 6,872,472.

The organic EL device of the invention may have a resonator structure. For example, such a device has, on a transparent substrate, a multilayer film mirror composed of a stack of plural films different in refractive index, a transparent or semi-transparent electrode, a light emitting layer, and a metal electrode which have been stacked one after another. Light produced at the light emitting layer repeats reflection and resonates between the multilayer film mirror and the metal electrode while causing them to serve a reflector plate.

In another preferred embodiment, a transparent or semi-transparent electrode and a metal electrode function as a reflector plate on a transparent substrate and light produced at a light emitting layer repeats reflection and resonates therebetween.

A resonator structure is formed by adjusting the effective refractive index of each of two reflector plates and the optical path length determined from the refractive index and thickness of each layer between the reflectors to be optimum for obtaining a desired resonant wavelength. The calculation formula for the first embodiment is described in Japanese Patent Application Laid-Open No. 180883/1997, while that for the second embodiment is described in Japanese Patent Application Laid-Open No. 2004-127795.

### (Applications of the invention)

The organic electroluminescence device of the invention can be suitably used for display devices, displays, backlights, electrophotography, light sources for illumination, light sources for recording, light sources for exposure, light sources for reading, signs, sign boards, interiors, and optical communications.

The organic EL display can be made a full color type by a known method as described in Monthly Display, September issue, 33-37(2000), for example, the three color light emitting method wherein three organic EL devices which respectively emit lights corresponding to the three primary colors (blue (B), green (G), red (R)) are placed on a substrate; the white light method wherein a white light from an organic EL device for white light emission is divided into the three primary colors via color filters; and the color conversion method wherein a blue light emitted from an organic EL device for blue light emission is converted into red (R) and green (G) via a fluorescent pigment layer.

A flat type light source emitting lights of desired colors can be provided by using a plurality of the organic EL devices different in emission color and obtainable by any of the above-described methods. Such a light source is, for example, a white light emitting light source using a blue luminescence device and a yellow luminescence device in combination, and a white light emitting light source using a blue luminescence device, a green luminescence device, and a red luminescence device in combination.

### [Examples]

The invention will hereinafter be described in further detail by Examples. It should however be borne in mind that the invention is limited to or by them.

### <Synthesis of Exemplified Compound 1-14>

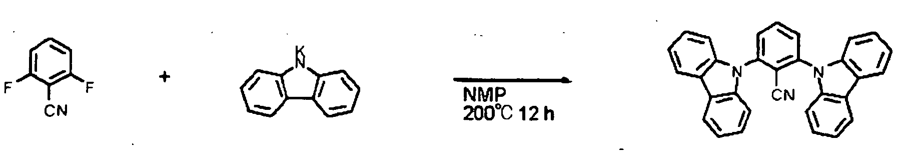

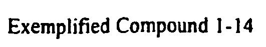

A mixture of 2,6-difluorobenzonitrile (3.4 g, 24 mmol), carbazole potassium (10 g, 49 mmol), and 1-methyl-2-pyrrolidone (100 mL) is heated at 150°C for 10 hours and then heated at 200°C for 12 hours. After the reaction mixture is cooled to room temperature, water is added thereto. A solid thus precipitated is filtered, dried, and dissolved in toluene. The resulting solution is treated with activated earth and is filtered. A solid obtained by concentrating the resulting toluene solution is washed with heated ethanol and then dried to yield 4.3 g (10 mmol) of a crude product. The crude product is purified by sublimation and provided for evaluation.

### <Synthesis of Exemplified Compound 1-15>

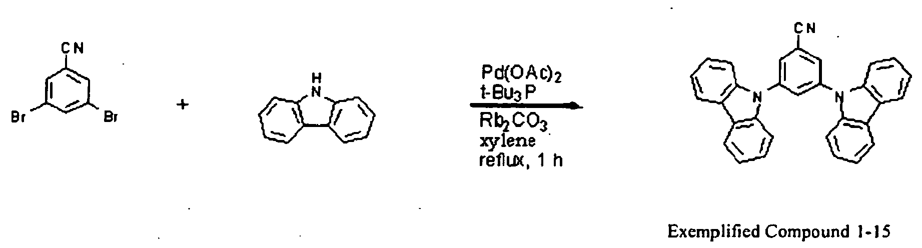

A mixture of 3,5-dibromobenzonitrile (5.4 g, 21 mmol), carbazole potassium (7 g, 42 mmol), palladium acetate (0.45 g, 2 mmol), tri(tert-butyl)phosphine (1.9 mL, 8 mmol), rubidium carbonate (23 g, 100 mmol), and xylene (100 mL) is heated at 150°C for 4 hours. After cooling to room temperature, the reaction mixture is diluted with toluene and then filtered using silica gel. The filtrate is concentrated. The solid thus obtained is washed with heated ethyl acetate, followed by recrystallization from toluene to yield 3.7 g (8.5 mmol) of a crude product. The resulting crude product is purified by sublimation and provided for evaluation.

In the above-described preparation process, when the substituent specified changes under conditions of a certain synthesis process or is not suited for enforcing the process, the intended compound can be prepared easily by protecting or deprotecting a functional group by means as described (for example, Protective Groups in Organic Synthesis, written by T. W. Greene, published by John Wiley & Sons, Inc. in 1981). If necessary, the order of the reaction steps such as introduction of a substituent can be changed as needed.

### <Fabrication and Evaluation of Organic Electroluminescence Device>

### (1) Fabrication of an organic electroluminescence device of Comparative Example 1

A glass substrate (product of Geomatec having a surface resistivity of 10 Ω/sq) which is 0.5 mm thick and 2.5 cm square and has an ITO film thereon is placed in a cleaning container, ultrasonically cleaned in 2-propanol, and treated with UV ozone for 30 minutes. On the resulting transparent anode (ITO film), following organic layers are vapor-deposited successively by vacuum deposition.

A deposition rate in Examples of the invention is 0.2 nm/sec unless otherwise particularly specified. The deposition rate is measured using a quartz crystal deposition controller "CRTM-9000", product of ULVAC. The film thicknesses listed below are worked out with a calibration curve prepared on the basis of numerical values obtained using CRTM-9000 and film thicknesses measured using a DEKTAK type stylus film thickness measurer.
<Organic layer 1> Compound A: film thickness of 80 nm
<Organic layer 2> Compound B: film thickness of 10 nm
<Organic layer 3> Co-evaporation of Comparative compound 1 + Light emitting material A (10 mass%); film thickness of 60 nm
<Organic layer 4> Compound C: film thickness: 10 nm
<Organic layer 5> Compound D: film thickness: 30 nm

Finally, lithium fluoride and metallic aluminum are successively deposited to thicknesses of 0.1 nm and 100 nm, respectively, to form a cathode. The resulting product is then put in a glove box replaced with an argon gas without being brought into contact with the atmosphere, and is sealed in a sealing can made of stainless with a UV-curing adhesive ("XNR5516HV", product of Nagase Ciba) to obtain the organic electroluminescence device of Comparative Example 1.

### (2) Fabrication of organic electroluminescence devices of Comparative Examples 2 to 12

Organic electroluminescence devices of Comparative Examples 1 to 12 are fabricated in a similar manner to that employed in Comparative Example 1 except that Light emitting materials B to L having the following structures, respectively, are used instead of Light emitting material A of Comparative Example 1 in accordance with the following table.

Compounds A to D have the following chemical structures, respectively.

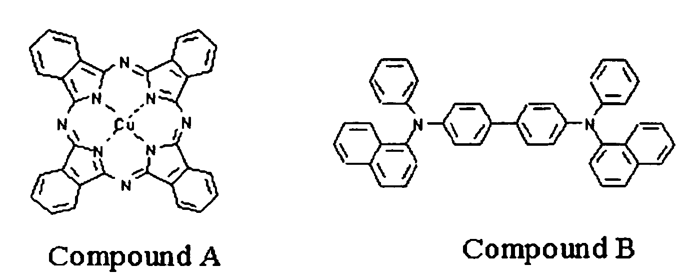

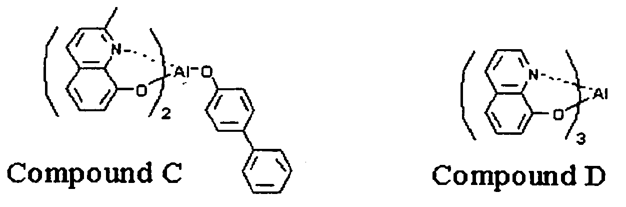

Light emitting materials A to L have the following chemical structures, respectively.

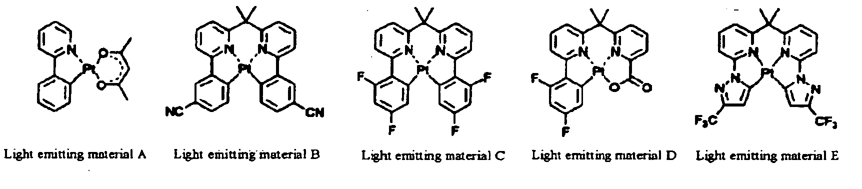

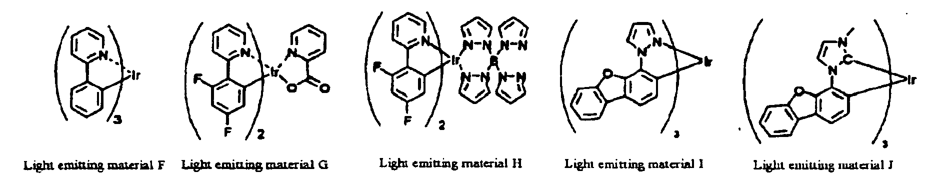

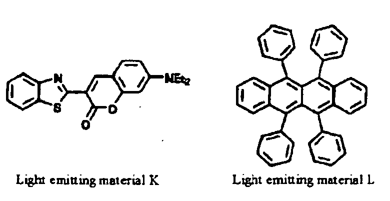

Comparative compound 1 has the following chemical structure.

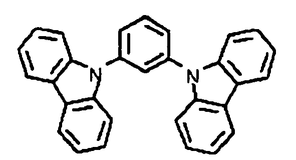

### Comparative compound 1

### (3) Fabrication of organic electroluminescence devices of Examples 1 to 12

Organic electroluminescence devices of Examples 1 to 12 are fabricated in a similar manner to that employed in Comparative Examples 1 to 12 except that Exemplified Compound 1-15 is used instead of Comparative Compound 1 in accordance with the following table.

### (4) Fabrication of an organic electroluminescence device of Example 13

An organic electroluminescence device of Example 13 of the invention is fabricated in a similar manner to that employed in Comparative Example 5 except that a layer composed of Exemplified Compound 1-15 of the invention and having a thickness of 5 nm is inserted between Organic layers 3 and 4 of the organic electroluminescence device of Comparative Example 5.

### (5) Fabrication of an organic electroluminescence device of Example 14

An organic electroluminescence device of Example 14 of the invention is fabricated in a similar manner to that employed in Example 13 except that Exemplified Compound 1-15 of the invention is used instead of Comparative Compound 1.

### (6) Fabrication of an organic electroluminescence device of Example 15

An organic electroluminescence device of Example 15 of the invention is fabricated in a similar manner to that employed in Example 13 except that Exemplified Compound 1-14 of the invention is used instead of Exemplified Compound 1-15.

The organic electroluminescence devices thus fabricated are evaluated in the following manner.

### (1) Evaluation of EL external quantum efficiency

A DC constant voltage is applied to each of the organic electroluminescence devices thus obtained by using "Source Measure Unit 2400" manufactured by Toyo Corporation to cause light emission. The EL external quantum efficiency of them is calculated from front luminance at 100 cd/m².

The evaluation results of the organic electroluminescence devices of Comparative Examples 1 to 12 and Examples 1 to 12 are shown in the following table. The emission wavelength shown in this table is a wavelength at which the maximum intensity of the emission spectrum becomes the maximum. By grouping together Comparative Example and Example using the same light emitting material, the driving voltage and EL external quantum efficiency of each of Examples using Exemplified Compound 1-15 are indicated by a relative value with the results of Comparative Examples using Comparative Compound 1 as 100.

**[Table 1]**

| | Emission wavelength | Light emitting material | Driving voltage (relative value) | EL external quantum efficiency (relative value) |
|---|---|---|---|---|
| Comparative Example 1 | 486 nm | Light emitting material A | 100 | 100 |
| Example 1 | 490 nm | Light emitting material A | 70 | 135 |
| Comparative Example 2 | 498 nm | Light emitting material B | 100 | 100 |
| Example 2 | 499 nm | Light emitting material B | 65 | 132 |
| Comparative Example 3 | 492 nm | Light emitting material C | 100 | 100 |
| Example 3 | 491 nm | Light emitting material C | 68 | 140 |
| Comparative Example 4 | 482 nm | Light emitting material D | 100 | 100 |
| Example 4 | 482 nm | Light emitting material D | 65 | 140 |
| Comparative Example 5 | 460 nm | Light emitting material E | 100 | 100 |
| Example 5 | 458 nm | Light emitting material E | 60 | 150 |
| Comparative Example 6 | 516 nm | Light emitting material F | 100 | 100 |
| Example 6 | 520 nm | Light emitting material F | 77 | 125 |
| Comparative Example 7 | 468 nm | Light emitting material G | 100 | 100 |
| Example 7 | 465 nm | Light emitting material G | 80 | 127 |
| Comparative Example 8 | 460 nm | Light emitting material H | 100 | 100 |
| Example 8 | 458 nm | Light emitting material H | 77 | 120 |
| Comparative Example 9 | 456 nm | Light emitting material I | 100 | 100 |
| Example 9 | 458 nm | Light emitting material I | 75 | 130 |
| Comparative Example 10 | 444 nm | Light emitting material J | 100 | 100 |
| Example 10 | 455 nm | Light emitting material J | 72 | 130 |
| Comparative Example 11 | 497 nm | Light emitting material K | 100 | 100 |
| Example 11 | 499 nm | Light emitting material K | 85 | 117 |
| Comparative Example 12 | 560 nm | Light emitting material L | 100 | 100 |
| Example 12 | 560 nm | Light emitting material L | 85 | 115 |

The organic electroluminescence devices of Examples 13 to 15 of the invention are evaluated. The results are as shown in the following table. The driving voltage and EL external quantum efficiency of Examples 13 to 15 of the invention are shown as a relative value to those of Comparative Example 5 using the same light emitting material set as 100.

**[Table 2]**

| | Light emitting material | Host material | Material of additional layer | Driving voltage (relative value) | EL external quantum efficiency (relative value) |
|---|---|---|---|---|---|
| Comparative Example 5 | Light emitting material E | Comparative compound 1 | - | 100 | 100 |
| Example 13 | Light emitting material E | Comparative compound 1 | Exemplified Compound 1-15 | 65 | 135 |
| Example 14 | Light emitting material E | Exemplified Compound 1-15 | Exemplified Compound 1-15 | 55 | 165 |
| Example 15 | Light emitting material E | Comparative compound 1 | Exemplified Compound 1-14 | 65 | 145 |

### (7) Fabrication and Evaluation of Organic Electroluminescent Devices of Examples 16 to 32 and Comparative Examples 16 to 32

Electroluminescent devices of Examples 16 to 32 and Comparative Examples 16 to 32 are fabricated in a similar manner to that employed in Comparative Example 1 except that, as shown in the following Table 3, Comparative Compounds 2 to 6 and Exemplified Compounds 2 to 6 are used instead of Comparative Compound 1 of Comparative Example 1 and Light emitting materials M to Z are used instead of the light emitting material A, and they are evaluated by the method similar to the above.

The chemical structures of Comparative Compounds 2 to 6 and Exemplified Compounds 2 to 6 are as follows.

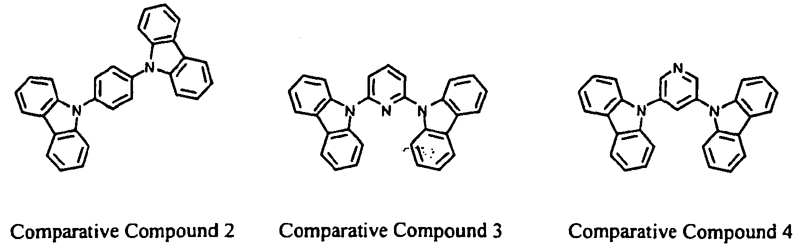

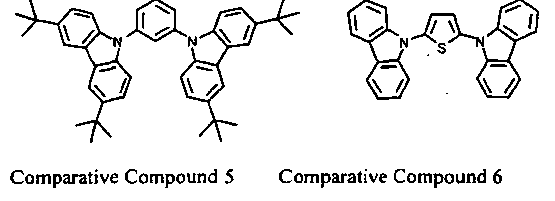

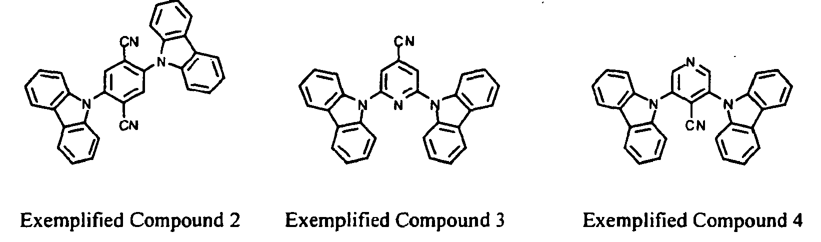

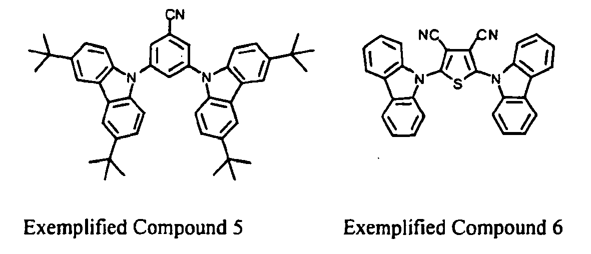

The chemical structures of Light emitting materials M to Z are shown below.

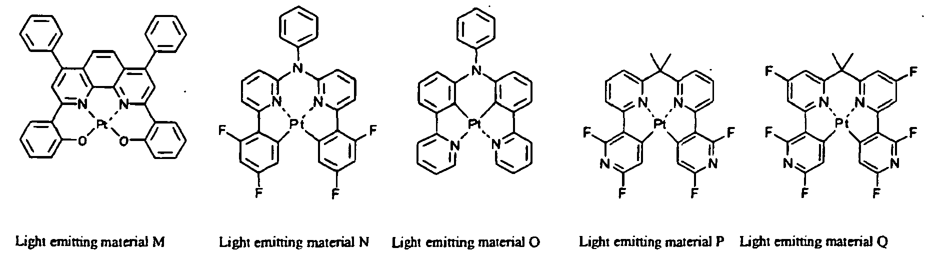

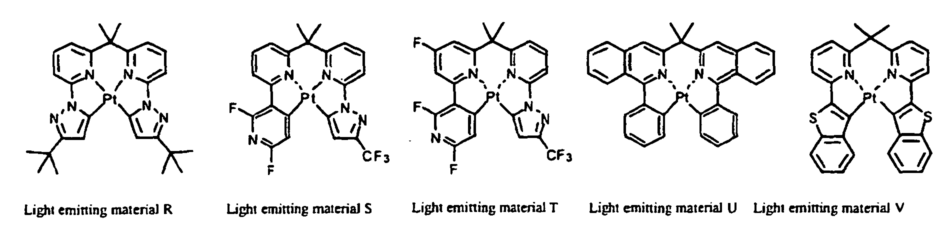

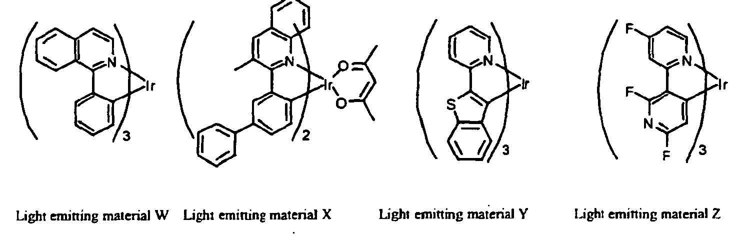

**Table 3**

| | | Light emitting material | Driving voltage (relative value) | EL external quantum efficiency (relative value) |
|---|---|---|---|---|
| Comparative Example 16 | Comparative Compound 2 | Light emitting material M | 100 | 100 |
| Example 16 | Exemplified Compound 2 | Light emitting material M | 70 | 120 |
| Comparative Example 17 | Comparative Compound 3 | Light emitting material N | 100 | 100 |
| Example 17 | Exemplified Compound 3 | Light emitting material N | 71 | 125 |
| Comparative Example 18 | Comparative Compound 2 | Light emitting material O | 100 | 100 |
| Example 18 | Exemplified Compound 2 | Light emitting material O | 60 | 135 |
| Comparative Example 19 | Comparative Compound 5 | Light emitting material O | 100 | 100 |
| Example 19 | Exemplified Compound 5 | Light emitting material O | 70 | 145 |
| Comparative Example 20 | Comparative Compound 4 | Light emitting material P | 100 | 100 |
| Example 20 | Exemplified Compound 4 | Light emitting material P | 64 | 140 |
| Comparative Example 21 | Comparative Compound 4 | Light emitting material Q | 100 | 100 |
| Example 21 | Exemplified Compound 4 | Light emitting material Q | 67 | 138 |
| Comparative Example 22 | Comparative Compound 3 | Light emitting material R | 100 | 100 |
| Example 22 | Exemplified Compound 3 | Light emitting material R | 69 | 133 |
| Comparative Example 23 | Comparative Compound 3 | Light emitting material S | 100 | 100 |
| Example 23 | Exemplified Compound 3 | Light emitting material S | 61 | 135 |
| Comparative Example 24 | Comparative Compound 5 | Light emitting material S | 100 | 100 |
| Example 24 | Exemplified Compound 5 | Light emitting material S | 68 | 140 |
| Comparative Example 25 | Comparative Compound 3 | Light emitting material T | 100 | 100 |
| Example 25 | Exemplified Compound 3 | Light emitting material T | 60 | 139 |
| Comparative Example 26 | Comparative Compound 2 | Light emitting material U | 100 | 100 |
| Example 26 | Exemplified Compound 2 | Light emitting material U | 62 | 133 |
| Comparative Example 27 | Comparative Compound 2 | Light emitting material V | 100 | 100 |
| Example 27 | Exemplified Compound 2 | Light emitting material V | 62 | 135 |
| Comparative Example 28 | Comparative Compound 2 | Light emitting material W | 100 | 100 |
| Example 28 | Exemplified Compound 2 | Light emitting material W | 69 | 120 |
| Comparative Example 29 | Comparative Compound 3 | Light emitting material X | 100 | 100 |
| Example 29 | Exemplified Compound 3 | Light emitting material X | 71 | 122 |
| Comparative Example 30 | Comparative Compound 6 | Light emitting material X | 100 | 100 |
| Example 30 | Exemplified Compound 6 | Light emitting material X | 67 | 132 |
| Comparative Example 31 | Comparative Compound 3 | Light emitting material Y | 100 | 100 |
| Example 31 | Exemplified Compound 3 | Light emitting material Y | 75 | 125 |
| Comparative Example 32 | Comparative Compound 2 | Light emitting material Z | 100 | 100 |
| Example 32 | Exemplified Compound 2 | Light emitting material Z | 77 | 130 |

An organic electroluminescence device featuring low voltage operation and excellent EL external quantum efficiency can be provided by the invention.

## Claims

1. An organic electroluminescent device comprising:
a pair of electrodes; and
an organic layer between the pair of electrodes, which comprises a light-emitting layer and contains a compound represented by the following formula (1): 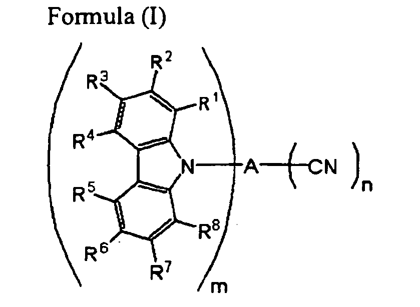 wherein
each of R¹ to R⁸ independently represents a hydrogen atom or a substituent, A represents an aromatic ring which may have a substituent,
m represents an integer of 2 or greater, and
n represents an integer of 1 or greater.

2. The organic electroluminescence device according to Claim 1, wherein
each of R¹ to R⁸ independently represents a hydrogen atom, an alkyl group, an aryl group, a heteroaryl group, a silyl group, or a halogen atom.

3. The organic electroluminescence device according to Claim 1, wherein
A represents an aromatic ring,
m represents an integer of 2 to 5,
n represents an integer of 1 to 4, and
each of R¹ to R⁸ independently represents a hydrogen atom, an alkyl group, an aryl group, a heteroaryl group, a silyl group, or a halogen atom.

4. The organic electroluminescence device according to Claim 1, wherein
the compound represented by the formula (I) is represented by the following formula (Ia) 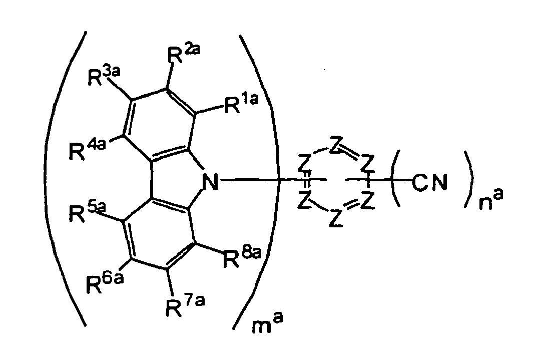 wherein
each of R^{1a} to R^{8a} independently represents a hydrogen atom, an alkyl group, an aryl group, a heteroaryl group, a silyl group, or a halogen atom
m^{a} represents an integer of 2 to 5,
n^{a} represents an integer of 1 to 4, and
Z represents a carbon atom or a nitrogen atom, provided that when Z is unsubstituted, Z represents C-H or N.

5. The organic electroluminescence device according to Claim 1, wherein
A represents a benzene ring,
m represents an integer of 2 to 5,
n represents an integer of 1 to 4, and
m+n represents an integer of 3 to 6.

6. The organic electroluminescence device according to Claim 1, wherein
the compound represented by the formula (I) is contained in the light emitting layer.

7. The organic electroluminescence device according to Claim 1, wherein
the compound represented by the formula (I) is contained in a layer adjacent to the light emitting layer.

8. The organic electroluminescence device according to Claim 1, wherein
the light emitting layer contains at least one of a platinum complex phosphorescent material and an iridium complex phosphorescent material.

9. The organic electroluminescence device according to Claim 1, wherein
the light emitting layer contains a platinum complex phosphorescent material having a tetradentate ligand.

## Patentansprüche

1. Organische Elektrolumineszenzvorrichtung, umfassend:
ein Paar Elektroden; und
eine organische Schicht zwischen dem Paar Elektroden, die eine lichtemittierende Schicht umfasst und eine durch die folgende Formel (1) dargestellte Verbindung enthält: 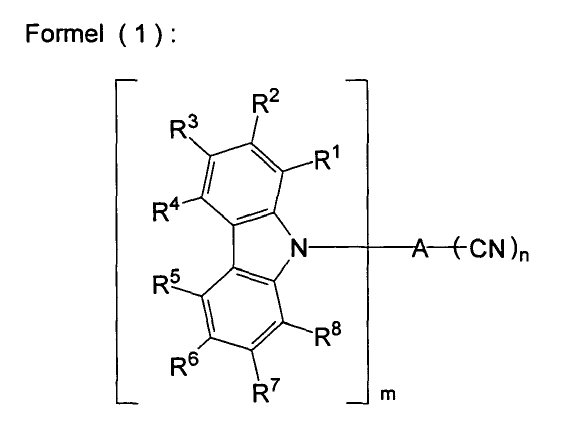 worin
jedes von R¹ bis R⁸ unabhängig voneinander ein Wasserstoffatom oder einen Substituenten darstellt,
A einen aromatischen Ring darstellt, der einen Substituenten aufweisen kann,
m eine ganze Zahl von 2 oder grösser darstellt, und
n eine ganze Zahl von 1 oder grösser darstellt.

2. Organische Elektrolumineszenzvorrichtung gemäss Anspruch 1, worin
jedes von R¹ bis R⁸ unabhängig voneinander ein Wasserstoffatom, eine Alkylgruppe, eine Arylgruppe, eine Heteroarylgruppe, eine Silylgruppe oder ein Halogenatom darstellt.

3. Organische Elektrolumineszenzvorrichtung gemäss Anspruch 1, worin
A einen aromatischen Ring darstellt,
m eine ganze Zahl von 2 bis 5 darstellt,
n eine ganze Zahl von 1 bis 4 darstellt, und
jedes von R¹ bis R⁸ unabhängig voneinander ein Wasserstoffatom, eine Alkylgruppe, eine Arylgruppe, eine Heteroarylgruppe, eine Silylgruppe oder ein Halogenatom darstellt.

4. Organische Elektrolumineszenzvorrichtung gemäss Anspruch 1, worin
die durch die Formel (1) dargestellte Verbindung durch die folgende Formel (1a) dargestellt wird: 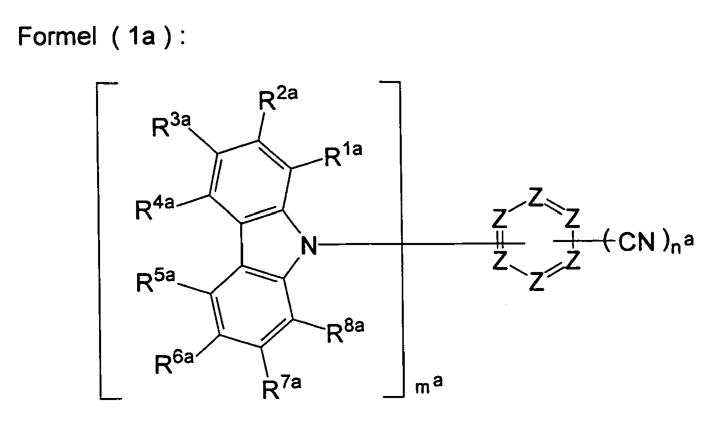 worin
jedes von R^{1a} bis R^{8a} unabhängig voneinander ein Wasserstoffatom, eine Alkylgruppe, eine Arylgruppe, eine Heteroarylgruppe, eine Silylgruppe oder ein Halogenatom darstellt,
m^{a} eine ganze Zahl von 2 bis 5 darstellt,
n^{a} eine ganze Zahl von 1 bis 4 darstellt, und
Z ein Kohlenstoffatom oder ein Stickstoffatom darstellt, vorausgesetzt, dass, wenn Z nicht substituiert ist, Z C-H oder N darstellt.

5. Organische Elektrolumineszenzvorrichtung gemäss Anspruch 1, worin
A einen Benzolring darstellt,
m eine ganze Zahl von 2 bis 5 darstellt,
n eine ganze Zahl von 1 bis 4 darstellt, und
m + n eine ganze Zahl von 3 bis 6 darstellt.

6. Organische Elektrolumineszenzvorrichtung gemäss Anspruch 1, worin die durch die Formel (1) dargestellte Verbindung in der lichtemittierenden Schicht enthalten ist.

7. Organische Elektrolumineszenzvorrichtung gemäss Anspruch 1, worin die durch die Formel (1) dargestellte Verbindung in einer Schicht enthalten ist, die an die lichtemittierende Schicht angrenzt.

8. Organische Elektrolumineszenzvorrichtung gemäss Anspruch 1, worin die lichtemittierende Schicht mindestens eines von einem phosphoreszierenden Platinkomplexmaterial und einem phosphoreszierenden Iridiumkomplexmaterial enthält.

9. Organische Elektrolumineszenzvorrichtung gemäss Anspruch 1, worin die lichtemittierende Schicht ein phosphoreszierendes Platinkomplexmaterial enthält, das einen vierzähnigen Liganden aufweist.

## Revendications

1. Dispositif électroluminescent organique comprenant :
une paire d'électrodes ; et
une couche organique entre la paire d'électrodes, laquelle comprend une couche émettant de la lumière et contient un composé représenté par la formule (I) suivante : 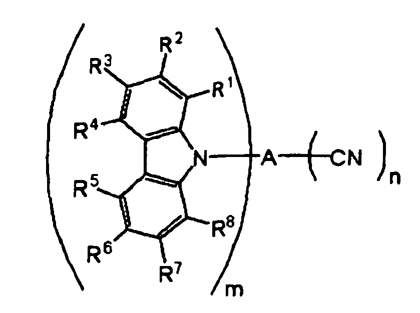 dans laquelle
chacun de R¹ à R⁸ représente indépendamment un atome d'hydrogène ou un substituant,
A représente un noyau aromatique qui peut présenter un substituant,
m représente un nombre entier égal à 2 ou supérieur, et
n représente un nombre entier égal à 1 ou supérieur.

2. Dispositif électroluminescent organique selon la revendication 1, dans lequel
chacun de R¹ à R⁸ représente indépendamment un atome d'hydrogène, un groupe alkyle, un groupe aryle, un groupe hétéroaryle, un groupe silyle ou un atome d'halogène.

3. Dispositif électroluminescent organique selon la revendication 1, dans lequel
A représente un noyau aromatique,
m représente un nombre entier de 2 à 5,
n représente un nombre entier de 1 à 4, et
chacun de R¹ à R⁸ représente indépendamment un atome d'hydrogène, un groupe alkyle, un groupe aryle, un groupe hétéroaryle, un groupe silyle ou un atome d'halogène.

4. Dispositif électroluminescent organique selon la revendication 1, dans lequel
le composé représenté par la formule (I) est représenté par la formule (Ia) suivante : 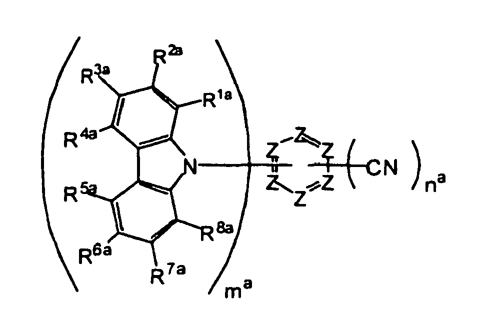 dans laquelle
chacun de R^{1a} à R^{8a} représente indépendamment un atome d'hydrogène, un groupe alkyle, un groupe aryle, un groupe hétéroaryle, un groupe silyle ou un atome d'halogène
m^{a} représente un nombre entier de 2 à 5,
n^{a} représente un nombre entier de 1 à 4, et
Z représente un atome de carbone ou un atome d'azote, à condition que lorsque Z est non substitué, Z représente C-H ou N.

5. Dispositif électroluminescent organique selon la revendication 1, dans lequel
A représente un noyau benzène,
m représente un nombre entier de 2 à 5,
n représente un nombre entier de 1 à 4, et
m+n représente un nombre entier de 3 à 6.

6. Dispositif électroluminescent organique selon la revendication 1, dans lequel
le composé représenté par la formule (I) est contenu dans la couche émettant de la lumière.

7. Dispositif électroluminescent organique selon la revendication 1, dans lequel
le composé représenté par la formule (I) est contenu dans une couche adjacente à la couche émettant de la lumière.

8. Dispositif électroluminescent organique selon la revendication 1, dans lequel
la couche émettant de la lumière contient au moins un parmi un matériau phosphorescent de complexe du platine et un matériau phosphorescent de complexe d'iridium.

9. Dispositif électroluminescent organique selon la revendication 1, dans lequel
la couche émettant de la lumière contient un matériau phosphorescent de complexe du platine présentant un ligand tétradenté.
